(19)

**Europäisches Patentamt**
**European Patent Office**
**Office européen des brevets**

(11) **EP 4 395 182 A1**

(12) **EUROPEAN PATENT APPLICATION**
published in accordance with Art. 153(4) EPC

(43) Date of publication:
**03.07.2024 Bulletin 2024/27**

(21) Application number: **22874563.4**

(22) Date of filing: **02.09.2022**

(51) International Patent Classification (IPC):
**H03M 13/13** $^{(2006.01)}$

(52) Cooperative Patent Classification (CPC):
**H03M 13/13; H04L 1/00**

(86) International application number:
**PCT/CN2022/116922**

(87) International publication number:
**WO 2023/051172 (06.04.2023 Gazette 2023/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2021  CN 202111173210**

(71) Applicant: **Huawei Technologies Co., Ltd.**
**Shenzhen, Guangdong 518129 (CN)**

(72) Inventors:
• **QIN, Kangjian**
  **Shenzhen, Guangdong 518129 (CN)**

• **LI, Rong**
  **Shenzhen, Guangdong 518129 (CN)**
• **ZHANG, Huazi**
  **Shenzhen, Guangdong 518129 (CN)**
• **WANG, Xianbin**
  **Shenzhen, Guangdong 518129 (CN)**
• **WANG, Jun**
  **Shenzhen, Guangdong 518129 (CN)**

(74) Representative: **Gill Jennings & Every LLP**
**The Broadgate Tower**
**20 Primrose Street**
**London EC2A 2ES (GB)**

(54) **ENCODING METHOD AND APPARATUS, AND DECODING METHOD AND APPARATUS**

(57) This application discloses an encoding method, a decoding method, and an apparatus. The encoding method includes: obtaining a first bit sequence and a target code length M; then performing first channel encoding on the first bit sequence, to obtain a second bit sequence; performing second channel encoding based on the second bit sequence, to obtain a third bit sequence; and outputting the third bit sequence. The first bit sequence includes K information bits, the second bit sequence includes N bits, and the third bit sequence includes the N bits and E check bits, where M>N, and E=M-N. M, K, N, and E are all integers greater than or equal to 1. According to the encoding method, a code length can be flexibly extended based on different M, to improve flexibility of code length extension.

A transmit end obtains a first bit sequence and a target code length M, where the first bit sequence includes K information bits, K is an integer greater than or equal to 1, and M is an integer greater than or equal to 1 — 401

The transmit end performs first channel encoding on the first bit sequence, to obtain a second bit sequence, where the second bit sequence includes N bits, and N is an integer greater than or equal to 1 — 402

The transmit end performs second channel encoding based on the second bit sequence, to obtain a third bit sequence, where the third bit sequence includes the N bits and E check bits, E is an integer greater than or equal to 1, M>N, and E=M–N — 403

The transmit end outputs the third bit sequence — 404

FIG. 4a

## Description

This application claims priority to Chinese Patent Application No. 202111173210.7, filed with the China National Intellectual Property Administration on September 30, 2021 and entitled "ENCODING METHOD, DECODING METHOD, AND APPARATUS", which is incorporated herein by reference in its entirety.

## TECHNICAL FIELD

This application relates to the field of communication technologies, and in particular, to an encoding method, a decoding method, and an apparatus.

## BACKGROUND

As a channel encoding scheme that can prove that a Shannon channel capacity can be "achieved", a polar code has features of an algebraic encoding structure and probability decoding. Generally, the polar code may be used to control channel encoding. However, a low-density parity check (low-density parity check, LDPC) code is used for data channel encoding. Because flexible extension of a code length of the polar code cannot be easily implemented, application of the polar code on a data channel is limited.

Therefore, how to apply a polar code encoding scheme to the data channel needs to be urgently resolved.

## SUMMARY

This application provides an encoding method, a decoding method, and an apparatus, so that a code length can be flexibly extended based on different M, to improve flexibility of code length extension.

According to a first aspect, an embodiment of this application provides an encoding method. The method includes:

obtaining a first bit sequence and a target code length M, where the first bit sequence includes K information bits, K is an integer greater than or equal to 1, and M is an integer greater than or equal to 1; performing first channel encoding on the first bit sequence, to obtain a second bit sequence, where the second bit sequence includes N bits, and N is an integer greater than or equal to 1; performing second channel encoding based on the second bit sequence, to obtain a third bit sequence, where the third bit sequence includes the N bits and E check bits, E is an integer greater than or equal to 1, M>N, and E=M-N; and outputting the third bit sequence.

A transmit end determines a quantity E of check bits based on given sending code lengths M and N, to perform second channel encoding, so as to obtain the E check bits. According to the method provided in this embodiment of this application, a code length can be flexibly extended based on different M. For example, the E check bits can be obtained through extension. This improves flexibility of code length extension. In particular, for polar code encoding, in the method provided in this embodiment of this application, not only advantages of the polar code encoding can be combined, but also the code length can be flexibly extended, so that the polar code encoding can be more flexibly applied to a data channel.

In a possible implementation, the performing second channel encoding based on the second bit sequence includes: performing second channel encoding based on the second bit sequence and an extension matrix, where the extension matrix includes N rows and E columns, the extension matrix is obtained based on a lifted base matrix, the lifted base matrix includes $N_0$ rows and $E_0$ columns, and both $E_0$ and $N_0$ are integers greater than or equal to 1.

In a possible implementation, a lifting size Z of the lifted base matrix is a prime number; or $Z=2^n$, Z is a lifting size of the lifted base matrix, and n is an integer greater than or equal to 0.

In a possible implementation, $Z=N/N_0$, and Z is the lifting size of the lifted base matrix.

In a possible implementation, Z=16.

In a possible implementation, the E columns of the extension matrix are first E columns of a first matrix, and the first matrix is a matrix obtained by lifting the lifted base matrix based on the lifting size; or the E columns of the extension matrix are adjacent E columns in a first matrix, the adjacent E columns in the first matrix are determined based on a code rate of the first channel encoding, and the first matrix is a matrix obtained by lifting the lifted base matrix based on the lifting size.

In a possible implementation, a column weight of a specific column in the extension matrix is related to N, K, and E.

In a possible implementation, the column weight of the specific column in the extension matrix meets any one or more of the following relationships: The column weight is negatively correlated with E, the column weight is positively correlated with K, the column weight is negatively correlated with N, and the column weight is positively correlated with K/N.

In a possible implementation, a column weight of a first column in the extension matrix meets any one or more of the following relationships: The column weight is negatively correlated with E, the column weight is positively correlated with K, the column weight is negatively correlated with N, and the column weight is positively correlated with K/N.

In a possible implementation, column weights of at least two columns in the extension matrix meet any one or more of the following relationships: The column weights are negatively correlated with E, the column weights are positively correlated with K, the column weights are negatively correlated with N, and the column weights are positively correlated with K/N.

In a possible implementation, a column weight of each column in the extension matrix meets any one or more of the following relationships: The column weight is negatively correlated with E, the column weight is positively correlated with K, the column weight is negatively correlated with N, and the column weight is positively correlated with K/N.

In a possible implementation, locations of the K information bits are determined based on a first reliability sequence, a length of the first reliability sequence is N, the first reliability sequence is a subsequence of a second reliability sequence, a length of the second reliability sequence is $N_{max}$, and $N_{max}$ is greater than or equal to N.

In a possible implementation, the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |

| $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ |
|---|---|---|---|---|---|---|---|---|---|---|---|---|---|---|---|
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |

| $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ |
|---|---|---|---|---|---|---|---|---|---|---|---|---|---|---|---|
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N\max}$ is a reliability sequence, an element in the reliability sequence is a sequence number of a subchannel, $W(Q_i^{N\max})$ represents reliability corresponding to the reliability sequence, and i is an integer greater than or equal to 1 and less than or equal to $N_{\max}$.

In a possible implementation, the performing first channel encoding on the first bit sequence includes: determining reliability of each of N locations based on a channel state and the extension matrix, where reliability of a location is positively correlated with a quantity of participated check bits; determining the first reliability sequence in ascending order of reliability of the N locations; and performing first channel encoding on the first bit sequence based on the first reliability sequence.

In a possible implementation, the performing first channel encoding on the first bit sequence includes: performing first channel encoding on the first bit sequence based on an inner interleaver sequence, where the inner interleaver sequence is determined based on the extension matrix, and a size of a block of the inner interleaver sequence is equal to the lifting size of the extension matrix.

According to a second aspect, an embodiment of this application provides a decoding method. The method includes:

obtaining a second to-be-decoded sequence, where the second to-be-decoded sequence includes information about N bits and information about E check bits, N is an integer greater than or equal to 1, and E is an integer greater than or equal to 1; performing second channel decoding on the second to-be-decoded sequence based on an extension matrix, to obtain a first to-be-decoded sequence, where the extension matrix includes N rows and E columns, the extension matrix is obtained based on a lifted base matrix, the lifted base matrix includes $N_0$ rows and $E_0$ columns, the first to-be-decoded sequence includes information about the N bits, and both $E_0$ and $N_0$ are integers greater than or equal to 1; and performing first channel decoding on the first to-be-decoded sequence based on a first reliability sequence, to obtain a first bit sequence, where a length of the first reliability sequence is N, the first reliability sequence is a subsequence of a second reliability sequence, a length of the second reliability sequence is $N_{\max}$, $N_{\max}$ is greater than or equal to N, and the first bit sequence includes K information bits.

For example, the information about the E check bits may be understood as a soft information sequence obtained after the E check bits pass through a channel, or the information about the N bits may be understood as a soft information sequence obtained after the N bits pass through a channel. It may be understood that the information about the N bits included in the first to-be-decoded sequence may be the same as or different from the information about the N bits included in the second to-be-decoded sequence.

It may be understood that in the foregoing method, the first reliability sequence is a subsequence of the second reliability sequence. However, in this embodiment of this application, the first reliability sequence may alternatively be obtained based on an extension matrix. For example, a receive end may obtain the first reliability sequence by using an online construction method.

In a possible implementation, a lifting size Z of the lifted base matrix is a prime number; or $Z=2^n$, Z is a lifting size of the lifted base matrix, and n is an integer greater than or equal to 0.

In a possible implementation, $Z=N/N_0$, and Z is the lifting size of the lifted base matrix.

In a possible implementation, Z=16.

In a possible implementation, the E columns of the extension matrix are first E columns of a first matrix, and the first matrix is a matrix obtained by lifting the lifted base matrix based on the lifting size; or the E columns of the extension matrix are adjacent E columns in a first matrix, the adjacent E columns in the first matrix are determined based on a code rate of the first channel encoding, and the first matrix is a matrix obtained by lifting the lifted base matrix based on the lifting size.

In a possible implementation, a column weight of a specific column in the extension matrix is related to N, K, and E.

In a possible implementation, the column weight of the specific column in the extension matrix meets any one or more of the following relationships: The column weight is negatively correlated with E, the column weight is positively correlated with K, the column weight is negatively correlated with N, and the column weight is positively correlated with K/N.

In a possible implementation, a column weight of a first column in the extension matrix meets any one or more of the following relationships: The column weight is negatively correlated with E, the column weight is positively correlated with K, the column weight is negatively correlated with N, and the column weight is positively correlated with K/N.

In a possible implementation, column weights of at least two columns in the extension matrix meet any one or more of the following relationships: The column weights are negatively correlated with E, the column weights are positively correlated with K, the column weights are negatively correlated with N, and the column weights are positively correlated with K/N.

In a possible implementation, a column weight of each column in the extension matrix meets any one or more of the following relationships: The column weight is negatively correlated with E, the column weight is positively correlated with K, the column weight is negatively correlated with N, and the column weight is positively correlated with K/N.

In a possible implementation, the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |

| $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ |
|---|---|---|---|---|---|---|---|---|---|---|---|---|---|---|---|
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N\max}$ is a reliability sequence, an element in the reliability sequence is a sequence number of a subchannel, $W(Q_i^{N\max})$ represents reliability corresponding to the reliability sequence, and i is an integer greater than or equal to 1 and less than or equal to $N_{max}$.

In a possible implementation, the performing first channel decoding on the first to-be-decoded sequence based on a first reliability sequence includes: performing first channel decoding on the first to-be-decoded sequence based on the first reliability sequence and an inner interleaver sequence, where the inner interleaver sequence is determined based on the extension matrix, and a size of a block of the inner interleaver sequence is equal to the lifting size of the extension matrix.

According to a third aspect, an embodiment of this application provides a communication apparatus, configured to implement the method in any one of the first aspect or the possible implementations of the first aspect. The communication apparatus includes units that perform the method in any one of the first aspect or the possible implementations of the first aspect.

For example, the communication apparatus may be a transmit end, a chip in a transmit end, or the like.

According to a fourth aspect, an embodiment of this application provides a communication apparatus, configured to perform the method in any one of the second aspect or the possible implementations of the second aspect. The communication apparatus includes corresponding methods configured to perform the method in any one of the second aspect or the possible implementations of the second aspect.

For example, the communication apparatus may be a receive end, a chip in a receive end, or the like.

In the third aspect or the fourth aspect, the communication apparatus may include an input/output unit and a processing unit. For specific descriptions of the input/output unit and the processing unit, refer to the following apparatus embodiments.

According to a fifth aspect, an embodiment of this application provides a communication apparatus. The communication apparatus includes a processor, configured to perform the method in any one of the first aspect or the possible implementations of the first aspect. Alternatively, the processor is configured to execute a program stored in a memory. When the program is executed, the method in any one of the first aspect or the possible implementations of the first aspect is performed.

In a process of performing the foregoing method, a process of sending information or outputting information (for example, a third bit sequence) or obtaining information (for example, obtaining the first bit sequence) in the foregoing method may be understood as a process of outputting the information by the processor or a process of receiving the input information by the processor. When outputting the information, the processor outputs the information to a transceiver, so that the transceiver transmits the information. After the information is output by the processor, other processing may further need to be performed on the information before the information arrives at the transceiver. Similarly, when the processor receives the input information, the transceiver receives the information, and inputs the information into the processor. Further, after the transceiver receives the information, other processing may need to be performed on the information before the information is input into the processor.

Based on the foregoing principle, for example, the obtaining the first bit sequence mentioned in the foregoing method may be understood as receiving the input first bit sequence by the processor. The outputting the third bit sequence mentioned in the foregoing method may be understood as outputting the third bit sequence by the processor, or the like.

Unless otherwise specified, or if operations such as transmitting, sending, and receiving related to the processor do not contradict an actual function or internal logic of the operations in related descriptions, all the operations may be more generally understood as operations such as outputting, receiving, and inputting of the processor, instead of operations such as transmitting, sending, and receiving directly performed by a radio frequency circuit and an antenna.

In an implementation process, the processor may be a processor specially configured to perform these methods, or a processor, for example, a general-purpose processor, that executes computer instructions in a memory to perform these methods. The memory may be a non-transitory (non-transitory) memory, for example, a read-only memory (read-only memory, ROM). The memory and the processor may be integrated on a same chip, or may be separately disposed on different chips. A type of the memory and a manner of disposing the memory and the processor are not limited in this embodiment of this application. It may be understood that descriptions of the processor and the memory are also applicable to the sixth aspect shown below. For brevity, descriptions of the processor and the memory are not described in detail in the sixth aspect.

In a possible implementation, the memory is located outside the communication apparatus.

In a possible implementation, the memory is located inside the communication apparatus.

In this embodiment of this application, the processor and the memory may alternatively be integrated into one device. In other words, the processor and the memory may alternatively be integrated together.

For example, the memory may be configured to store one or more of a second reliability sequence or a lifted base matrix, and the like

In a possible implementation, the communication apparatus further includes a transceiver, and the transceiver is configured to receive a signal or send a signal. For example, the transceiver may be further configured to send a sequence obtained based on the third bit sequence, and the like.

In this embodiment of this application, the communication apparatus may be a transmit end, a chip in a transmit end, or the like.

According to a sixth aspect, an embodiment of this application provides a communication apparatus. The communication apparatus includes a processor, configured to perform the method in any one of the second aspect or the possible implementations of the second aspect. Alternatively, the processor is configured to execute a program stored in a memory. When the program is executed, the method in any one of the second aspect or the possible implementations of the second aspect is performed.

In a possible implementation, the memory is located outside the communication apparatus.

In a possible implementation, the memory is located inside the communication apparatus.

In this embodiment of this application, the processor and the memory may alternatively be integrated into one device. In other words, the processor and the memory may alternatively be integrated together.

For example, the memory may be configured to store one or more of a second reliability sequence or a lifted base matrix, and the like.

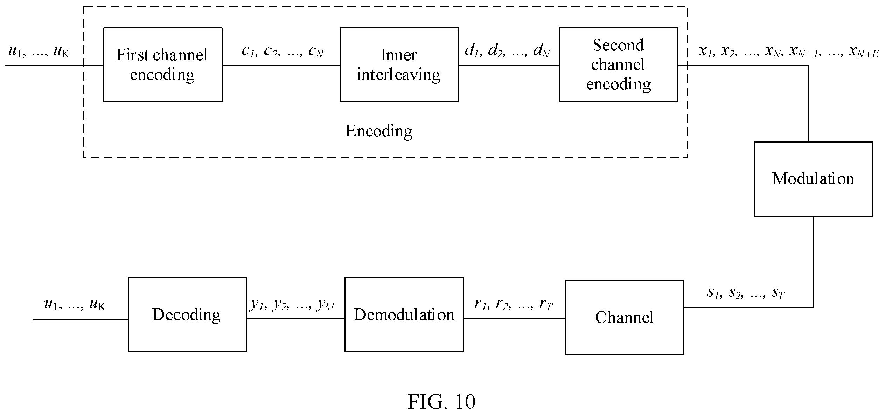

In a possible implementation, the communication apparatus further includes a transceiver, and the transceiver is configured to receive a signal or send a signal. For example, the transceiver may be configured to receive a sequence (a received sequence shown in FIG. 10), and the like.

In this embodiment of this application, the communication apparatus may be a receive end, a chip in a receive end, or the like.

According to a seventh aspect, an embodiment of this application provides a communication apparatus. The communication apparatus includes a logic circuit and an interface, and the logic circuit is coupled to the interface. The logic circuit is configured to obtain a first bit sequence; the logic circuit is further configured to perform first channel encoding on the first bit sequence to obtain a second bit sequence, and perform second channel encoding based on the second bit sequence to obtain a third bit sequence; and the interface is further configured to output the third bit sequence. The first bit sequence includes K information bits, and K is an integer greater than or equal to 1. The second bit sequence includes N bits, and N is an integer greater than or equal to 1. The third bit sequence includes the N bits and E check bits, E is an integer greater than or equal to 1, $M>N$, and $E=M-N$. M is a target code length, and M is an integer greater than or equal to 1.

It may be understood that, that the logic circuit is configured to obtain the first bit sequence shown above may be further understood as follows: The logic circuit is configured to: input to-be-processed data through the interface, and process the to-be-processed data to obtain the first bit sequence. The first bit sequence may be input from another apparatus or component to the logic circuit through the interface, or may be obtained by processing, by the logic circuit, other data input through the interface. This is not limited in this embodiment of this application.

In a possible implementation, the logic circuit is specifically configured to perform second channel encoding based on the second bit sequence and an extension matrix, where the extension matrix includes N rows and E columns, the extension matrix is obtained based on a lifted base matrix, the lifted base matrix includes $N_0$ rows and $E_0$ columns, and both $E_0$ and $N_0$ are integers greater than or equal to 1.

In a possible implementation, the logic circuit is specifically configured to perform first channel encoding on the first bit sequence based on an inner interleaver sequence, where the inner interleaver sequence is determined based on the extension matrix, and a size of a block of the inner interleaver sequence is equal to the lifting size of the extension matrix.

It may be understood that, for descriptions of the first bit sequence, the second bit sequence, the third bit sequence, the first channel encoding, the second channel encoding, the extension matrix, the lifted base matrix, the first reliability sequence, the second reliability sequence, and the like, refer to the descriptions in the first aspect, or refer to the following method embodiments. Details are not described herein again.

According to an eighth aspect, an embodiment of this application provides a communication apparatus. The communication apparatus includes a logic circuit and an interface, and the logic circuit is coupled to the interface. The logic circuit is configured to: obtain a second to-be-decoded sequence; perform second channel decoding on the second to-be-decoded sequence based on an extension matrix, to obtain a first to-be-decoded sequence; and perform first channel decoding on the first to-be-decoded sequence based on a first reliability sequence, to obtain a first bit sequence. The second to-be-decoded sequence includes information about N bits and information about E check bits, N is an integer greater than or equal to 1, and E is an integer greater than or equal to 1. The extension matrix includes N rows and E columns, the extension matrix is obtained based on a lifted base matrix, the lifted base matrix includes $N_0$ rows and $E_0$ columns, the first to-be-decoded sequence includes information about the N bits, and both $E_0$ and $N_0$ are integers greater than or equal to 1. A length of the first reliability sequence is N, the first reliability sequence is a subsequence of a second reliability sequence, a length of the second reliability sequence is $N_{max}$, $N_{max}$ is greater than or equal to N, and the first bit sequence includes K information bits.

It may be understood that, that the logic circuit is configured to obtain a third bit sequence shown above may be further understood as follows: The interface is configured to input to-be-processed data (for example, a received sequence obtained through a channel), and the logic circuit processes the to-be-processed data input by the interface, to obtain the second to-be-decoded sequence; the logic circuit inputs the second to-be-decoded sequence through the interface; or the like

In a possible implementation, the logic circuit is specifically configured to perform first channel decoding on the first to-be-decoded sequence based on the first reliability sequence and an inner interleaver sequence, where the inner interleaver sequence is determined based on the extension matrix, and a size of a block of the inner interleaver sequence is equal to the lifting size of the extension matrix.

It may be understood that, for descriptions of the first bit sequence, the first to-be-decoded sequence, the second to-be-decoded sequence, first channel encoding, second channel encoding, the extension matrix, a lifted base matrix, the first reliability sequence, the second reliability sequence, and the like, refer to the descriptions in the second aspect, or refer to the following method embodiments. Details are not described herein again.

According to a ninth aspect, an embodiment of this application provides a computer-readable storage medium. The computer-readable storage medium is configured to store a computer program, and when the computer program is run on a computer, the method shown in any one of the first aspect or the possible implementations of the first aspect is performed, or the method shown in any one of the second aspect or the possible implementations of the second aspect is performed.

According to a tenth aspect, an embodiment of this application provides a computer program product. The computer program product includes a computer program or computer code, and when the computer program product runs on a computer, the method shown in any one of the first aspect or the possible implementations of the first aspect is performed, or the method shown in any one of the second aspect or the possible implementations of the second aspect is performed.

According to an eleventh aspect, an embodiment of this application provides a computer program. When the computer program is run on a computer, the method shown in any one of the first aspect or the possible implementations of the first aspect is performed, or the method shown in any one of the second aspect or the possible implementations of the second aspect is performed.

According to a twelfth aspect, an embodiment of this application provides a wireless communication system. The wireless communication system includes a transmit end and a receive end. The transmit end is configured to perform the method shown in any one of the first aspect or the possible implementations of the first aspect, and the receive end is configured to perform the method shown in any one of the second aspect or the possible implementations of the second aspect.

## BRIEF DESCRIPTION OF DRAWINGS

FIG. 1 is a schematic diagram of an architecture of a communication system according to an embodiment of this application;

FIG. 2 is a schematic diagram of polar code encoding according to an embodiment of this application;

FIG. 3 is a schematic diagram of a tree structure of successive cancellation list (successive cancellation list, SCL) decoding according to an embodiment of this application;

FIG. 4a is a schematic flowchart of an encoding method according to an embodiment of this application;

FIG. 4b is a schematic diagram of second channel encoding according to an embodiment of this application;

FIG. 5a is a schematic diagram of a lifted base matrix according to an embodiment of this application;

FIG. 5b is a schematic diagram of another lifted base matrix according to an embodiment of this application;

FIG. 5c is a schematic flowchart of a method for generating a lifted base matrix according to an embodiment of this application;

FIG. 5d is a schematic flowchart of another method for generating a lifted base matrix according to an embodiment of this application;

FIG. 6a is a schematic diagram of decoding performance corresponding to different construction sequences according to an embodiment of this application;

FIG. 6b is a schematic diagram of a reliability difference between and a block-wise feature of bit channels according to an embodiment of this application;

FIG. 6c is a schematic diagram of a check relationship between a check node and a variable node according to an embodiment of this application;

FIG. 6d is a schematic diagram of a relationship between an extension matrix and a first reliability sequence according to an embodiment of this application;

FIG. 7a is a schematic diagram of decoding performance comparison between an encoding method provided in this application and a polar code encoding method according to an embodiment of this application;

FIG. 7b is a schematic diagram of decoding performance comparison between repetition encoding in an encoding method provided in this application and repetition encoding in a polar code encoding method according to an embodiment of this application;

FIG. 8 is a schematic flowchart of a decoding method according to an embodiment of this application;

FIG. 9a is a schematic flowchart of large iterative decoding according to an embodiment of this application;

FIG. 9b is a schematic diagram of a decoding method according to an embodiment of this application;

FIG. 9c is a schematic diagram of comparison between maximum decoding complexity and average decoding complexity according to an embodiment of this application;

FIG. 9d to FIG. 9g are schematic diagrams of performance comparison between an encoding method, a repetition encoding method, and a long code encoding method according to an embodiment of this application;

FIG. 10 is a schematic diagram of an encoding method and a decoding method according to an embodiment of this application; and

FIG. 11 to FIG. 13 are schematic diagrams of a structure of a communication apparatus according to an embodiment of this application.

## DESCRIPTION OF EMBODIMENTS

To make the objectives, technical solutions, and advantages of this application clearer, this application is further described with reference to the accompanying drawings.

Terms "first", "second", and the like in the specification, claims, and accompanying drawings of this application are merely used to distinguish between different objects, and are not used to describe a specific sequence. In addition, terms such as "include" and "have" and any other variants thereof are intended to cover a non-exclusive inclusion. For example, processes, methods, systems, products, or devices that include a series of steps or units are not limited to listed steps or units, but instead, optionally further include steps or units that are not listed, or optionally further include other steps or units inherent to these processes, methods, products, or devices.

An "embodiment" mentioned in this specification means that a particular feature, structure, or characteristic described with reference to the embodiment may be included in at least one embodiment of this application. The phrase shown in various locations in the specification may not necessarily refer to a same embodiment, and is not an independent or optional embodiment exclusive from another embodiment. It may be understood explicitly and implicitly by a person skilled in the art that the embodiments described in this specification may be combined with other embodiments.

In this application, "at least one piece (item)" means one or more, "a plurality of" means two or more, "at least two pieces (items)" means two or three or more, and "and/or" is used to describe an association relationship between associated objects, and indicates that three relationships may exist. For example, "A and/or B" may indicate: Only A exists, only B exists, and both A and B exist, where A and B may be singular or plural. The character "/" generally represents an "or" relationship between the associated objects. "At least one of the following items (pieces)" or a similar expression thereof means any combination of these items. For example, at least one of a, b, or c may represent: a, b, c, "a and b", "a and c", "b and c", or "a and b and c".

The method provided in this application may be applied to various communication systems, for example, may be applied to an Internet of things (Internet of things, IoT) system, a narrow band Internet of things (narrow band Internet of things, NB-IoT) system, a long term evolution (long term evolution, LTE) system, a 5th generation (5th generation, 5G) communication system (for example, including enhanced mobile broadband (enhanced mobile broadband, eMBB), ultra-reliable and low-latency communication (ultra-reliable and low-latency communication, URLLC), and enhanced machine type communication (enhanced machine type communication, eMTC)), and a new communication system (for example, 6G) emerging in future communication development. In addition, the method provided in this application may be further applied to a wireless local area network (wireless local area network, WLAN) system, for example, wireless fidelity (wireless fidelity, Wi-Fi) and the like.

The technical solutions provided in this application may be further applied to machine type communication (machine type communication, MTC), a long term evolution-machine (Long Term Evolution-machine, LTE-M) technology, and a device-to-device (device-to-device, D2D) network, a machine to machine (machine to machine, M2M) network, an Internet of Things (Internet of things, IoT) network, or another network. The IoT network may include, for example, the Internet of vehicles. Communication manners in an Internet of vehicles system are collectively referred to as a vehicle to X (vehicle to X, V2X, where X can stand for anything) device. For example, the V2X may include: vehicle to vehicle (vehicle to vehicle, V2V) communication, vehicle to infrastructure (vehicle to infrastructure, V2I) communication, vehicle to pedestrian communication (vehicle to vehicle, V2P), vehicle to network (vehicle to network, V2N) communication, or the like.

Terms in this application are described below in detail.

1. Terminal device

The terminal device in this application is an apparatus having a wireless transceiver function. The terminal device may communicate with an access network device (or may be referred to as an access device) in a radio access network (radio access network, RAN).

The terminal device may also be referred to as user equipment (user equipment, UE), an access terminal, a terminal (terminal), a subscriber unit (subscriber unit), a subscriber station, a mobile station, a remote station, a remote terminal, a mobile device, a user terminal, a user agent, a user apparatus, or the like. In a possible implementation, the terminal device may be deployed on land, including being deployed indoor or outdoor, or being handheld or vehicle-mounted, or may be deployed on water (for example, on a ship). In a possible implementation, the terminal device may be a handheld device, a vehicle-mounted device, a wearable device, a sensor, a terminal in the Internet of things, a terminal in the Internet of vehicles, an uncrewed aerial vehicle, a 5th generation (5th generation, 5G) network, a terminal device in any form in a future network, or the like that has a wireless communication function. This is not limited in this application.

It may be understood that the terminal device shown in this application may not only include a vehicle (for example, an automobile) in the Internet of vehicles, but also include a vehicle-mounted device, a vehicle-mounted terminal, or the like in the Internet of vehicles. A specific form of the terminal device applied to the Internet of vehicles is not limited in this application. It may be understood that terminal devices shown in this application may further communicate with each other by using technologies such as D2D, V2X, or M2M. A method for communication between the terminal devices is not limited in this application.

2. Network device

The network device in this application may be an apparatus that is deployed in a radio access network and that provides a wireless communication service for a terminal device. The network device may also be referred to as an access network device, an access device, a RAN device, or the like.

For example, the network device may be a next generation NodeB (next generation NodeB, gNB), a next generation evolved NodeB (next generation evolved NodeB, ng-eNB), a network device in future 6G communication, or the like. The network device may be any device having a wireless transceiver function, and includes but is not limited to a base station (including a base station deployed on a satellite). The network device may alternatively be an apparatus having a base station function in a 6th generation communication system. Optionally, the network device may be an access node, a wireless relay node, a wireless backhaul node, or the like in a wireless local area network (wireless fidelity, Wi-Fi) system. Optionally, the network device may be a radio controller in a cloud radio access network (cloud radio access network, CRAN) scenario. Optionally, the network device may be a wearable device, a vehicle-mounted device, or the like. Optionally, the network device may be a small cell, a transmission reception point (transmission reception point, TRP) (or may be referred to as a transmission point), or the like. It may be understood that the network device may alternatively be a base station, a satellite, or the like in a future evolved public land mobile network (public land mobile network, PLMN). The network device may alternatively be a device carrying a base station function in a non-terrestrial communication system, D2D, V2X, or M2M, or the like. A specific type of the network device is not limited in this application. In systems of different radio access technologies, a device having a network device function may be named differently.

Optionally, in some deployments of the network device, the network device may include a central unit (central unit, CU), a distributed unit (distributed unit, DU), and the like. In some other deployments of the network device, the CU may be further divided into a CU-control plane (control plane, CP), a CU-user plane (user plane, UP), and the like. In some other deployments of the network device, the network device may alternatively be in an open radio access network (open radio access network, ORAN) architecture or the like. A specific deployment manner of the network device is not limited in this application.

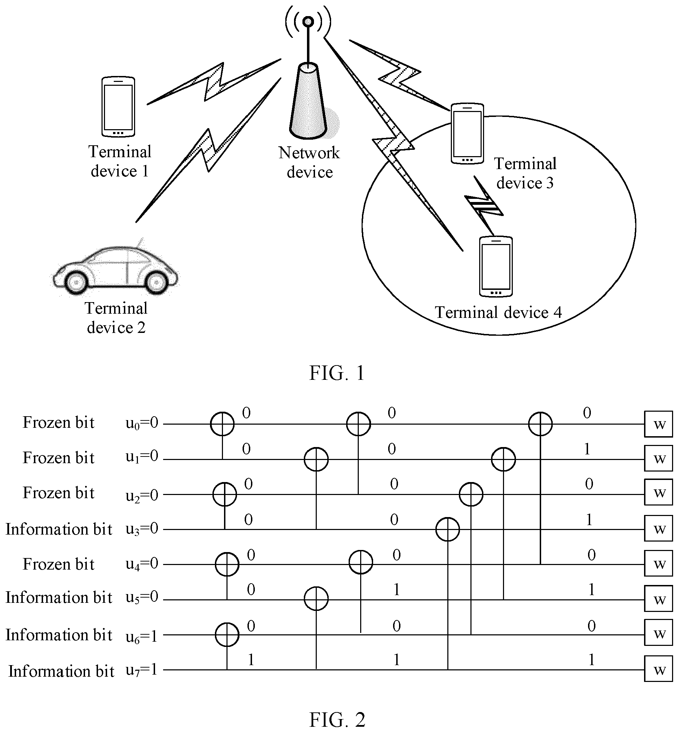

Based on the terminal device and the network device described above, an embodiment of this application provides a communication system. FIG. 1 is a schematic diagram of an architecture of the communication system according to an embodiment of this application. As shown in FIG. 1, the communication system may include at least one network device and at least one terminal device, for example, a terminal device 1 to a terminal device 4 in FIG. 1.

For example, a terminal device 3 and the terminal device 4 shown in FIG. 1 may directly communicate with each other. For example, direct communication between the terminal devices may be implemented by using a D2D technology. For another example, the terminal device 1 to the terminal device 4 may separately communicate with the network device. It may be understood that the terminal device 3 and the terminal device 4 may directly communicate with the network device, or may indirectly communicate with the network device, for example, communicate with the network device through another terminal device (not shown in FIG. 1). It should be understood that FIG. 1 shows an example in which there is one network device, a plurality of terminal devices, and a communication link between communication devices. Optionally, the communication system may include a plurality of network devices, and a coverage area of each network device may include another quantity of terminal devices, for example, more or fewer terminal devices. This is not limited in this application.

A network architecture and a service scenario described in embodiments of this application are intended to describe the technical solutions in embodiments of this application more clearly, and do not constitute a limitation on the technical solutions provided in embodiments of this application. A person of ordinary skill in the art may know that, with evolution of the network architecture and emergence of a new service scenario, the technical solutions provided in embodiments of this application are also applicable to similar technical problems.

3. Quasi-cyclic (quasi-cyclic, QC) matrix

The QC matrix may also be referred to as a quasi-cyclic shift, a QC form, a quasi-cyclic shift matrix, or the like.

For example, a matrix $\begin{bmatrix} 3 & 0 & 0 \\ 0 & 5 & 0 \\ 1 & 0 & 2 \end{bmatrix}$ is a QC matrix whose lifting size (lifting size) is equal to 5, and a non-zero element in the QC matrix is referred to as a shifting value (shifting value). In this case, a matrix obtained when the matrix corresponds to a binary field may be obtained in the following manner:

Each element in the QC matrix is converted into a unit matrix I whose size is equal to the lifting size.

For example, if a value of the non-zero element in the QC matrix is referred to as a shifting value (shifting value), a unit matrix at a location of the non-zero element may be circularly shifted rightwards by z columns.

For example, a matrix corresponding to a non-zero element 3 in the QC matrix may be obtained by cyclically shifting I rightwards by three columns, that is, $\begin{bmatrix} 0 & 0 & 0 & 1 & 0 \\ 0 & 0 & 0 & 0 & 1 \\ 1 & 0 & 0 & 0 & 0 \\ 0 & 1 & 0 & 0 & 0 \\ 0 & 0 & 1 & 0 & 0 \end{bmatrix}$ . For another example, because a non-zero element 5 in the QC matrix is equal to the lifting size, it is equivalent that no column is shifted rightwards. For another example, a matrix corresponding to a non-zero element 1 in the QC matrix may be obtained by cyclically shifting I

$$\begin{bmatrix} 0 & 1 & 0 & 0 & 0 \\ 0 & 0 & 1 & 0 & 0 \\ 0 & 0 & 0 & 1 & 0 \\ 0 & 0 & 0 & 0 & 1 \\ 1 & 0 & 0 & 0 & 0 \end{bmatrix}$$

rightwards by one column, that is, . For another example, a matrix corresponding to a non-zero element 2 in the QC matrix may be obtained by cyclically shifting I rightwards by two columns, that is,

$$\begin{bmatrix} 0 & 0 & 1 & 0 & 0 \\ 0 & 0 & 0 & 1 & 0 \\ 0 & 0 & 0 & 0 & 1 \\ 1 & 0 & 0 & 0 & 0 \\ 0 & 1 & 0 & 0 & 0 \end{bmatrix}$$
.

Based on the lifting size 5, a binary-field matrix corresponding to the QC matrix may be shown as follows:

$$\begin{bmatrix} 0 & 0 & 0 & 1 & 0 & 0 & 0 & 0 & 0 & 0 & 0 & 0 & 0 & 0 & 0 \\ 0 & 0 & 0 & 0 & 1 & 0 & 0 & 0 & 0 & 0 & 0 & 0 & 0 & 0 & 0 \\ 1 & 0 & 0 & 0 & 0 & 0 & 0 & 0 & 0 & 0 & 0 & 0 & 0 & 0 & 0 \\ 0 & 1 & 0 & 0 & 0 & 0 & 0 & 0 & 0 & 0 & 0 & 0 & 0 & 0 & 0 \\ 0 & 0 & 1 & 0 & 0 & 0 & 0 & 0 & 0 & 0 & 0 & 0 & 0 & 0 & 0 \\ 0 & 0 & 0 & 0 & 0 & 1 & 0 & 0 & 0 & 0 & 0 & 0 & 0 & 0 & 0 \\ 0 & 0 & 0 & 0 & 0 & 0 & 1 & 0 & 0 & 0 & 0 & 0 & 0 & 0 & 0 \\ 0 & 0 & 0 & 0 & 0 & 0 & 0 & 1 & 0 & 0 & 0 & 0 & 0 & 0 & 0 \\ 0 & 0 & 0 & 0 & 0 & 0 & 0 & 0 & 1 & 0 & 0 & 0 & 0 & 0 & 0 \\ 0 & 0 & 0 & 0 & 0 & 0 & 0 & 0 & 0 & 1 & 0 & 0 & 0 & 0 & 0 \\ 0 & 1 & 0 & 0 & 0 & 0 & 0 & 0 & 0 & 0 & 0 & 0 & 1 & 0 & 0 \\ 0 & 0 & 1 & 0 & 0 & 0 & 0 & 0 & 0 & 0 & 0 & 0 & 0 & 1 & 0 \\ 0 & 0 & 0 & 1 & 0 & 0 & 0 & 0 & 0 & 0 & 0 & 0 & 0 & 0 & 1 \\ 0 & 0 & 0 & 0 & 1 & 0 & 0 & 0 & 0 & 0 & 1 & 0 & 0 & 0 & 0 \\ 1 & 0 & 0 & 0 & 0 & 0 & 0 & 0 & 0 & 0 & 0 & 1 & 0 & 0 & 0 \end{bmatrix}$$

In other words, after the 3-row and 3-column QC matrix is converted into a binary-field matrix based on the lifting size, a binary-field 15-row and 15-column matrix may be obtained.

Generally, when the shifting value is equal to the lifting size, it is equivalent to that the unit matrix is not circularly shifted rightwards. If the shifting value is greater than the lifting size, it is equivalent to that the unit matrix is circularly shifted rightwards by mod(shifting value, lifting size) columns. It may be understood that the lifting size 5 shown above is merely an example, and a value of the lifting size is not limited in this application. For example, the lifting size may alternatively be equal to 3, 7, or the like. In addition, another name of the lifting size is not limited in this application.

For example, a column weight of a corresponding column (which may also be referred to as a specific column) in the matrix shown in this application may be represented by a quantity of non-zero elements of the corresponding column (which may also be referred to as the specific column) in the matrix. For example, if a first column of the QC matrix includes two non-zero elements, a column weight of the first column of the QC matrix may be represented by 2. For another example, if both a second column and a third column of the QC matrix include one non-zero element, column weights of both the second column and the third column of the QC matrix may be represented by 1. In addition, after the QC matrix is converted into the binary-field matrix, a column weight of a corresponding column of the QC matrix is equal to a column weight of a corresponding column of the binary-field matrix of the QC matrix. For example, the column weight of the first column of the QC matrix is 2. It may be obtained, based on the lifting size, that the first column of the QC matrix corresponds to a first column to a fifth column of the binary-field matrix of the QC matrix. Therefore, column weights of the first column to the fifth column in the binary-field matrix of the QC matrix are all 2. Similarly, if the column weight of the second column of the QC matrix is 1, column weights of a sixth column to a tenth column in the binary-field matrix of the QC matrix are all 1. It may be understood that the column weight of the first column is greater than the column weight of the sixth column. In other words, a larger quantity of non-zero elements in a corresponding column in the matrix indicates a heavier column weight (which may also be referred to as a larger column weight) of the corresponding column in the matrix. Similarly, a smaller quantity of non-zero elements of a corresponding column in the matrix indicates a lighter column weight (which may also be referred to as a smaller column weight) of the corresponding column in the matrix.

4. Polar (polar) code encoding

An encoding matrix G of a polar code may be obtained by performing a Kronecker product n times based on a standard polar kernel $F=\begin{bmatrix} 1 & 0 \\ 1 & 1 \end{bmatrix}$ . For example, when n=2, a polar code encoding matrix

$$G=F^{\otimes n}=\begin{bmatrix} 1 & 0 & 0 & 0 \\ 1 & 1 & 0 & 0 \\ 1 & 0 & 1 & 0 \\ 1 & 1 & 1 & 1 \end{bmatrix}$$ whose code length is N=4 may be obtained.

FIG. 2 is a schematic diagram of polar code encoding according to an embodiment of this application. For example, when n=3, a polar code encoding matrix G whose code length is N=8 is shown as follows:

$$\begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

As shown in FIG. 2, to-be-encoded bits may be classified into two types based on reliability: a frozen (frozen) bit (which may also be referred to as a fixed bit) and an information bit (data). Generally, a bit with higher reliability is set as an information bit (data), and a bit with lower reliability is set as a frozen (frozen) bit. A value of the frozen (frozen) bit is usually set to 0, which is known to both a transmit end and a receive end in actual transmission. As shown in FIG. 2, $u_7$, $u_6$, $u_5$, and $u_3$ are four bits whose reliability is ranked top, and are set as information bits (data); and $u_4$, $u_2$, $u_1$, and $u_0$ are four bits whose reliability is ranked low, and are set as frozen (frozen) bits.

5. Reliability sequence

The reliability sequence is a sequence in which location numbers are sorted in ascending order of reliability. For example, in a reliability sequence A=[$a_1$, $a_2$, ..., $a_N$] whose length is N, a first bit $a_1$ is a location number with lowest reliability, and a last bit $a_N$ is a location number with highest reliability. Certainly, the location numbers may alternatively be sorted in descending order of the reliability. Because essence is the same, this application is still described by using an example in which the location numbers are sorted in ascending order of the reliability. Alternatively, the location number with the lowest reliability may start from 0, or the like. This is not limited in this application. For example, if one K-length information bit and one N-length reliability sequence A=[$a_1$, $a_2$, ..., $a_N$] are given, the K information bits may be placed at most reliable K locations in A, for example, [$a_{N-K+1}$, ..., $a_N$] (merely an example), and frozen bits (for example, 0) may be placed at remaining N-K locations [$a_1$, ..., $a_{N-K}$] in A. In this way, an information carried sequence [$b_1$, $b_2$, ..., $b_N$] is obtained.

6. Successive cancellation (successive cancellation, SC) decoding and successive cancellation list (successive cancellation list, SCL) decoding of a polar code

The SC decoding is a manner of polar code sequential decoding, and SC decoding may be performed on polar channels $W_N^{(i)}$ of the polar code one by one, starting from i=1 to i=N. For example, $U_1$ may be first determined by using a channel received signal $Y^N$ (if $U_1$ is a frozen bit, determining is directly performed). Then, an obtained $U_1$ and the channel received signal $Y^N$ are considered as a second polar channel $W_N^{(2)}$, and decoding is performed on the second polar channel to obtain $U_2$. This process is repeated until an $N^{th}$ bit $U_N$ is obtained through decoding, and decoding ends.

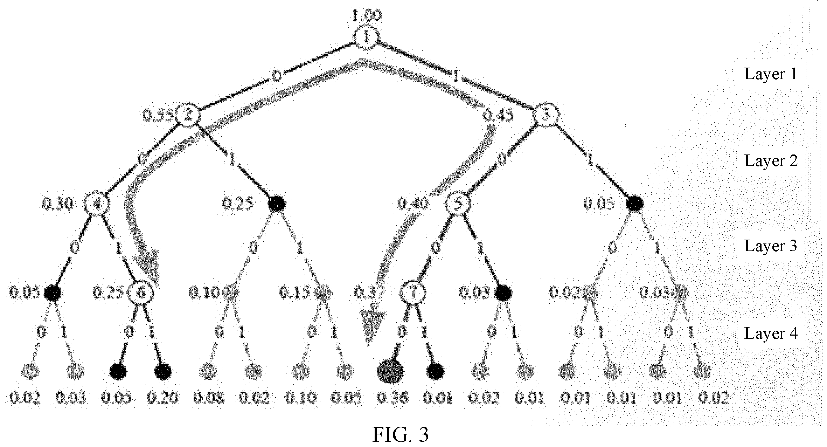

The SCL decoding is based on SC, but determining is not performed on $U_i$ immediately when each $W_N^{(i)}$ is decoded, and two possibilities are maintained: $U_i$=0 and $U_i$=1. Generally, a size of a candidate sequence in a decoding pool increases exponentially. Therefore, to control decoding complexity, a size of a list (list) of an SCL decoder is limited to an extent. To be specific, only L candidate paths with largest probability values are reserved each time. When $U^N$ is finally output, a path with a largest probability value is selected from the L candidate paths as a decoding result. FIG. 3 is a schematic diagram of a tree structure of SCL decoding according to an embodiment of this application. For example, N=4, L=4, and each bit $U_i$ is represented by an $i^{th}$ layer, where $1 \leq 1 \leq 4$. For $U_i$ at each layer, the SCL decoder separately performs probability calculation on $U_i$=0 and $U_i$=1 based on a previously decided bit $U_1^{i-1}$. Therefore, as i increases, a quantity of obtained layers also increases continuously, and the tree structure in FIG. 3 is formed. As shown in FIG. 3, each path has a corresponding weight, and a value of the weight is determined by a probability of a corresponding U value on the path. Therefore, a path with a largest weight is selected from the L paths that are finally output, as a final output of the SCL decoder. As shown in FIG. 3, an output of the SCL decoder is 1000.

It may be understood that descriptions of the SC decoding and the SCL decoding in embodiments of this application are merely examples, and specific manners of the SC decoding and the SCL decoding are not limited in embodiments of this application.

This application provides an encoding method, a decoding method, and an apparatus. The methods not only have advantages of flexible code length extension and easy generation of a soft value of an LDPC code, but also maintain features of a strong structure and high decoding efficiency of a polar code, and effectively combine advantages of the LDPC code and the polar code.

Optionally, the methods provided in this application may be applied to the terminal device or the network device shown above. For example, the terminal device may serve as a transmit end, for example, encode K information bits, and then send, to the network device, encoded bits obtained based on the K information bits. The network device serves as a receive end, and decodes an encoded sequence received from the terminal device, to obtain the K information bits. For another example, the network device may be used as a transmit end, and the terminal device may be used as a receive end. This is not limited in this application. Optionally, the methods provided in this application may be further applied to an application-specific integrated circuit (application-specific integrated circuit, ASIC) (which may also be referred to as an application-specific integrated chip), a field programmable gate array (field programmable gate array, FPGA), a programmable chip, or the like. Optionally, the methods provided in this application may alternatively be implemented by using software (for example, by using program code stored in a memory), and the like. This is not limited in this application.

The following describes in detail the encoding method and the decoding method shown in this application.

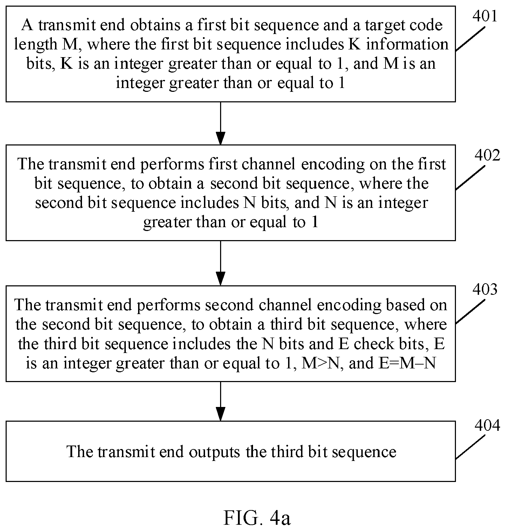

FIG. 4a is a schematic flowchart of the encoding method according to an embodiment of this application. As shown in FIG. 4a, the method includes the following steps.

401: A transmit end obtains a first bit sequence and a target code length M, where the first bit sequence includes K information bits, K is an integer greater than or equal to 1, and M is an integer greater than or equal to 1.

The first bit sequence may be understood as a to-be-sent bit sequence obtained by the transmit end. For example, the first bit sequence may be understood as a bit sequence that includes an information amount, a bit sequence that needs to be transmitted, or the like. Optionally, the first bit sequence may be understood as being constituted by the K information bits.

In a possible implementation, the K information bits may include a cyclic redundancy check (cyclic redundancy check, CRC) bit and/or a parity check (parity check, PC) bit. For example, for uplink transmission, K may be greater than or equal to 18, and 6 CRC bits, 11 CRC bits, or the like may be included. For another example, for downlink transmission, K may be greater than or equal to 36, and 16 CRC bits, 24 CRC bits, or the like may be included.

In another possible implementation, alternatively, the K information bits may not include a CRC bit, or may not include a PC bit, or the like. In an example, when the K information bits do not include the CRC bit, the transmit end may add the CRC bit to the obtained K information bits, or the transmit end may add the CRC bit to N bits after obtaining a second bit sequence (step 402 shown below). In another example, when the K information bits do not include the PC bit, the transmit end may add the PC bit to the obtained K information bits, or the transmit end may add the PC bit to N bits after obtaining a second bit sequence. In another example, the K information bits neither include the CRC bit nor include the PC bit. The transmit end may add the CRC bit and the PC bit based on the obtained K information bits, or the transmit end may add the CRC bit and the PC bit to N initially transmitted bits after obtaining the first bit sequence. A location at which the transmit end adds the CRC bit or the PC bit is not limited in this embodiment of this application. It may be understood that the CRC bit and the PC bit shown above each are a check method, and another check method is not limited in this embodiment of this application.

The target code length may be understood as a given sending code length, or the target code length may be understood as a code length that can be flexibly extended, a code length of an extension flexible-polar (extension flexible-polar, EF-polar) code, or the like. A name of the target code length is not limited in this embodiment of this application. For example, the target code length may be determined based on a channel transmission resource and a modulation order. For example, the target code length may be set by a network device, or the target code length may be specified in a protocol or a standard. A method for setting the target code length is not limited in this embodiment of this application.

For example, that the transmit end obtains the first bit sequence may include: The transmit end generates the first bit sequence, or an encoding apparatus in the transmit end obtains the first bit sequence from another apparatus in the transmit end. How the transmit end obtains the first bit sequence is not limited in this embodiment of this application.

402: The transmit end performs first channel encoding on the first bit sequence, to obtain the second bit sequence, where the second bit sequence includes the N bits, and N is an integer greater than or equal to 1.

The first channel encoding includes any one or more of polar code encoding, Bose-Chaudhuri-Hocquenghem (Bose-Chaudhuri-Hocquenghem, BCH) code encoding, Reed-Solomon (Reed-Solomon, RS) code encoding, LDPC encoding, a convolutional code, or the like. The first channel encoding may use probability encoding (for example, the LDPC encoding), or may use algebraic encoding (for example, the BCH encoding). This is not limited in this embodiment of this application.

N may be a mother code length, or may be a code length on which rate matching is performed. For example, if N is the mother code length, the transmit end may perform polar code encoding on information bits, for example, $U = u_1, u_2, ... u_K$, to obtain the second bit sequence. For example, the second bit sequence is $C = c_1, c_2, ... c_N$. For another example, if the mother code length is greater than N, the transmit end may obtain the bits whose length is N through rate matching. To be specific, when the mother code length is greater than N, the transmit end may adapt to a length of an available resource by using a rate matching method, to obtain the second bit sequence. The rate matching method may include repetition (repetition), puncturing (puncturing), shortening (shortening), and the like. This is not limited in this embodiment of this application.

403: The transmit end performs second channel encoding based on the second bit sequence, to obtain a third bit sequence, where the third bit sequence includes the N bits and E check bits, E is an integer greater than or equal to 1, M>N, and E=M-N.

The second channel encoding may also be referred to as redundant encoding, redundant extension encoding, redundant channel encoding, or the like. A name of the second channel encoding is not limited in this embodiment of this application.

The performing second channel encoding based on the second bit sequence includes: performing second channel encoding based on the second bit sequence and an extension matrix, where the extension matrix includes N rows and E columns, the extension matrix is obtained based on a lifted base matrix, the lifted base matrix includes $N_0$ rows and $E_0$ columns, and both $E_0$ and $N_0$ are integers greater than or equal to 1.

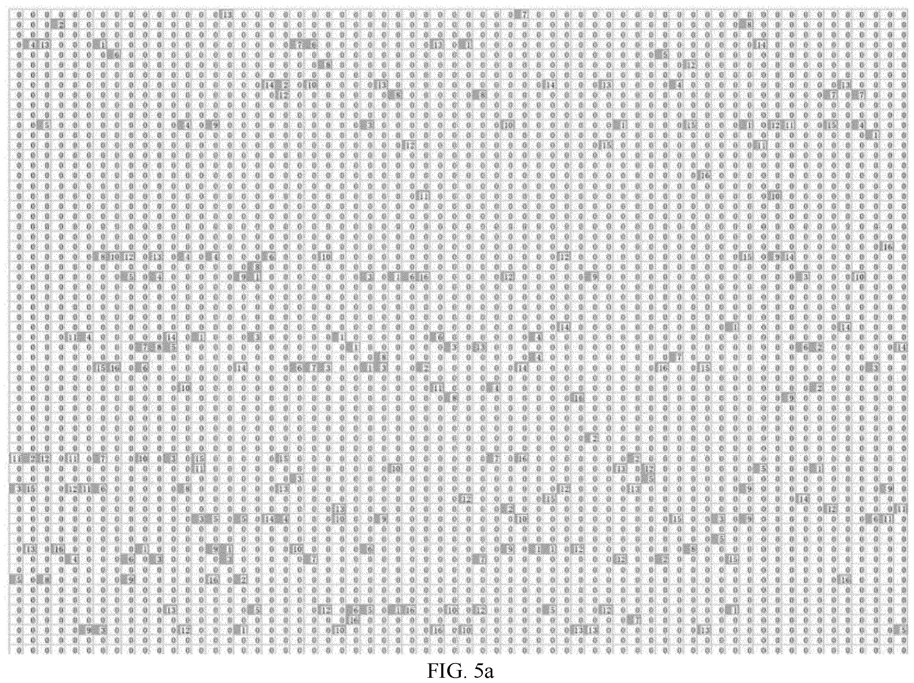

In other words, the transmit end may perform second channel encoding on the second bit sequence based on the extension matrix, to obtain the third bit sequence. The extension matrix is obtained based on the lifted base matrix. To be specific, the lifted base matrix may adapt to different N and/or different E, to obtain an extension matrix that matches N and E. The lifted base matrix may also be referred to as a base matrix (base matrix), a base graph (base graph), a protograph (protograph), or the like. The extension matrix may also be referred to as a check matrix, a redundant extension matrix, a redundant encoding matrix, or the like. Names of the lifted base matrix and the extension matrix are not limited in this embodiment of this application. It may be understood that the extension matrix and the lifted base matrix each have a QC structure. For specific descriptions of the lifted base matrix, refer to related descriptions of FIG. 5a to FIG. 5d. Details are not described herein.

For example, the extension matrix is represented by H, the E check bits are represented by P, and the second bit sequence is represented by C. In this case, a relationship between H and P may be shown as follows:

$$P = C \cdot H = c_1, c_2, ..., c_N \times \begin{bmatrix} h_{1,1} & \cdots & h_{1,E} \\ \vdots & \ddots & \vdots \\ h_{N,1} & \cdots & h_{N,E} \end{bmatrix}$$

$c_1, c_2, ..., c_N$ represents the N bits of the second bit sequence, and $P = p_1, p_2, ..., p_E$ represents the E check bits.

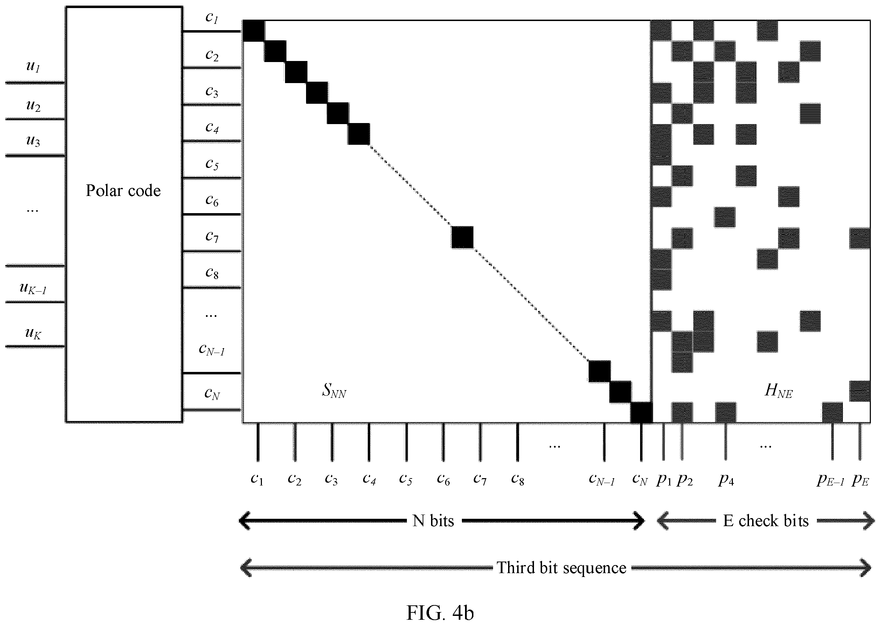

FIG. 4b is a schematic diagram of the second channel encoding according to an embodiment of this application. As shown in FIG. 4b, polar code encoding is performed on the K information bits, for example, $u_1, u_2, ... , u_K$, to obtain the second bit sequence, for example, $c_1, c_2, ..., c_N$. For example, the second bit sequence passes through an N-row and N-column unit matrix, and may be sequentially output as first N bits of the third bit sequence; and after the second bit sequence passes through the extension matrix H, the E check bits may be obtained as last E bits of the third bit sequence. In this way, a code length is extended. It may be understood that forms of the unit matrix (for example, an $S_{NN}$) and the extension matrix H shown in FIG. 4b are merely examples. This is not limited in this embodiment of this application. It may be understood that $G_{check}=[S_{NN}, H_{NE}]$ shown in this embodiment of this application may also be understood as a form of the extension matrix shown in this embodiment of this application.

It may be understood that the foregoing matrix operation may be on a binary field or a non-binary field. For example, the extension matrix may alternatively be in a non-binary-field form. When the extension matrix shown in FIG. 4b is a non-binary-field matrix, each black square may be a matrix whose dimension is Z*Z and that is shifted rightwards based on a shifting value. It may be understood that, when the extension matrix shown in FIG. 4b is a non-binary-field matrix, a row quantity and a column quantity of the extension matrix shown in FIG. 4b may not be N and E respectively, but a row quantity and a column quantity obtained when the N-row and E-column binary-field matrix is converted into a non-binary-field matrix. In other words, the second channel encoding shown in FIG. 4b is merely an example, and should not be construed as a limitation on embodiments of this application.

For ease of description, the following describes the method provided in this application by using an example in which the extension matrix H is a binary-field matrix.

It may be understood that when M=N, the encoding method shown in this embodiment of this application may be degraded to: The transmit end obtains the first bit sequence and the target code length M; performs first channel encoding on the first bit sequence, to obtain the second bit sequence; and outputs the second bit sequence.

404: The transmit end outputs the third bit sequence.

It may be understood that, if the transmit end performs rate matching in step 402, after outputting the third bit sequence, the transmit end may not perform rate matching again. Certainly, if the transmit end does not perform rate matching in step 402, the transmit end may perform rate matching after step 404.

Optionally, after step 404, the transmit end may further perform modulation and the like, and may send a modulated sequence to a receive end through a channel. This is not limited in this embodiment of this application.

The transmit end determines a quantity E of check bits based on given sending code lengths M and N, to perform second channel encoding, so as to obtain the E check bits. According to the method provided in this embodiment of this application, a code length can be flexibly extended based on different M. For example, the E check bits can be obtained through extension. This improves flexibility of code length extension. In particular, for the polar code encoding, in the method provided in this embodiment of this application, not only advantages such as a strong structure and high decoding efficiency of the polar code can be combined, but also the code length can be flexibly extended, so that the polar code encoding can be more flexibly applied to a data channel.

The following describes in detail the lifted base matrix and the extension matrix that are shown in this embodiment of this application.

When performing second channel encoding, the transmit end needs to determine a size of the extension matrix H. For example, the size of the extension matrix H may be determined based on the length N of the second bit sequence and the target code length M. For another example, the size of the extension matrix H may be determined based on the lifted base matrix and the lifting size (lifting size) of the lifted base matrix. The extension matrix shown in this embodiment of this application may have a double nesting property, for example, may flexibly adapt to different N and E. Details are as follows:

1. Adapt to different N

To adapt to different N, it needs to be ensured that a quantity of rows of the extension matrix H can be flexibly scaled. In other words, different N may be adapted by changing the lifting size Z and/or according to the rate matching method.

In an example, different N may be adapted based on the quantity $N_0$ of rows of the lifted base matrix and the lifting size Z. For example, $N_0=16$, and when performing first channel encoding, the transmit end needs to obtain a second bit sequence whose length is 1024 bits. In this case, $Z=N/N_0=64$. In other words, the lifted base matrix may be converted into a binary-field matrix by using the lifting size Z=64, to obtain the extension matrix. For another example, $N_0=16$, and when performing first channel encoding, the transmit end needs to obtain a second bit sequence whose length is 512 bits. In this case, $Z=N/N_0=32$. In other words, the lifted base matrix may be converted into a binary-field matrix by using the lifting size Z=32, to obtain the extension matrix. It may be understood that the quantity $N_0=16$ of rows of the lifted base matrix shown in this embodiment of this application is merely an example. For example, the quantity of rows of the lifted base matrix may be $N_0=32$, $N_0=64$, or the like. This is not limited in this embodiment of this application. For example, $N_0=64$, and when performing first channel encoding, the transmit end needs to obtain a second bit sequence whose length is 1024 bits. In this case, $Z=N/N_0=16$. In other words, the lifted base matrix may be converted into a binary-field matrix by using the lifting size Z=16, to obtain the extension matrix. It may be understood that, in this embodiment of this application, $Z=2^n$, and n is an integer greater than or equal to 0 (that is, n may be a natural number).

For example, n=0, 1, 2, 3, 4, 5, 6, or the like.

In another example, different N may be adapted based on the quantity $N_0$ of rows of the lifted base matrix, the lifting size Z, and the rate matching method. For example, $N_0=16$, and when performing first channel encoding, the transmit end needs to obtain a second bit sequence whose length is 1000 bits. In this case, Z may be determined based on $\lceil N/N_0 \rceil$ (that is, $N/N_0$ is rounded up) and $Z=2^n$, that is, Z=64. In other words, the lifted base matrix may be converted into a binary-field matrix (namely, a matrix including 1024 rows) by using the lifting size Z=64, and then an extension matrix with 1000 rows is obtained through puncturing (puncturing) or shortening (shortening). For example, $N_0=64$, and when performing first channel encoding, the transmit end needs to obtain a second bit sequence whose length is 2000 bits. Based on $\lceil N/N_0 \rceil = 32$, because 32 is a power of 2, Z=32. In other words, the lifted base matrix is converted into a binary-field matrix (namely, a matrix including 2048 rows) by using Z=32, and then a 2000-row extension matrix is obtained through puncturing (puncturing) or shortening (shortening).

It may be understood that the foregoing is shown by using examples in which $N_0$ and Z adapt to different N. However, in this embodiment of this application, the length N of the second bit sequence may be further determined based on $N_0$ and Z. In other words, Z may alternatively be a fixed value. For example, the transmit end may first determine N based on $N_0$ and Z, then perform first channel encoding on the first bit sequence to obtain the second bit sequence, and perform second channel encoding based on the second bit sequence and the extension matrix. It may be understood that when N is determined by using the foregoing method, if N is greater than M, N may be shortened or punctured to a value less than M according to the rate matching method. This embodiment of this application imposes no limitation on the value that is less than M and to which N is shortened or punctured according to the rate matching method.

For example, $N=N_0*Z$. For example, if $N_0=16$ and Z=64, N=1024. In other words, the length of the second bit sequence obtained by the transmit end is 1024. For another example, if $N_0=16$ and Z=32, N=512. In other words, the length of the second bit sequence obtained by the transmit end is 521. In this embodiment of this application, $Z=2^n$, and n is an integer greater than or equal to 0 (that is, n may be a natural number). For example, n=0, 1, 2, 3, 4, 5, 6, or the like.

2. Adapt to different code rates R

The extension matrix $H_{NE}$ further has flexibility of adapting to different code rates. For example, the extension matrix $H_{NE}$ may meet a submatrix nesting property. The submatrix nesting property may be understood as follows: An extension matrix with a low code rate is a submatrix of an extension matrix with a high code rate. In other words, the extension matrix shown in this embodiment of this application is compatible with different code rates. It may be understood that the code rate shown in this embodiment of this application may be understood as a code rate of the first channel encoding.

3. Adapt to different E

Based on N and the code rate R, the extension matrix has flexibility of adapting to different quantities E of check bits. In other words, the $H_{NE}$ can meet a column nesting property. For example, the column nesting property may be understood as follows: An extension matrix $H_{N, e1}$ corresponding to $e_1$ check bits is a submatrix of an extension matrix $H_{N, e1+e2}$ corresponding to $e1+e2$ check bits. In other words, it is required that the submatrix $H_{N, e1}$ obtained by intercepting first $e_1$ columns of the extension matrix $H_{N, e1+e2}$ whose quantity of check bits is $e1+e2$ can also obtain good performance when a quantity of check bits is $e_1$. In other words, the extension matrix shown in this embodiment of this application is compatible with different E.

In an example, the E columns of the extension matrix are first E columns of a first matrix, and the first matrix is a matrix obtained by lifting the lifted base matrix based on the lifting size. For example, when the code rate of the first channel encoding is equal to a maximum supported code rate, the E columns of the extension matrix are the first E columns of the first matrix. For example, after the lifted base matrix is lifted based on the lifting size, the first matrix may be obtained, and then the first E columns of the first matrix are determined as the E columns of the extension matrix based on M-N. It may be understood that for descriptions of the lifting size, refer to the foregoing descriptions about adaptation to different N. Details are not described herein again. It may be understood that the maximum supported code rate shown in this embodiment of this application may also be referred to as a maximum design code rate or the like. A name of the maximum supported code rate is not limited in this embodiment of this application. For example, a specific value of the maximum supported code rate may be set by the network device, or may be defined by a standard or a protocol. This is not limited in this embodiment of this application.

In another example, the E columns of the extension matrix are adjacent E columns in a first matrix, the adjacent E columns in the first matrix are determined based on the code rate of the first channel encoding (which may also be referred to as being related to the code rate of the first channel encoding), and the first matrix is a matrix obtained by lifting the lifted base matrix based on the lifting size. For example, when a code rate obtained based on K/N is less than a maximum supported code rate, the E columns of the extension matrix may be adjacent E columns in the first matrix. In other words, it may be determined, based on an operation result between the code rate obtained based on K/N and the maximum supported code rate, that the E columns of the extension matrix are adjacent E columns in the first matrix. In this case, the E columns of the extension matrix are not first E columns in the first matrix. For example, a first column of the extension matrix is obtained based on an operation result j between the code rate obtained based on K/N and the maximum supported code rate. In other words, j is related to K/N, the maximum supported code rate, and N. For example, j may meet any one of the following relationships:

$$j = \lceil \frac{N \times (R_h - R)}{R} + \Delta \rceil;$$

$$j = \lceil \frac{N \times (R_h - R)}{R} \rceil + \Delta;$$

$$j = \lfloor \frac{N \times (R_h - R)}{R} + \Delta \rfloor;$$

or

$$j = \lfloor \frac{N \times (R_h - R)}{R} \rfloor + \Delta$$

R=K/N, $R_h$ represents the maximum supported code rate, N represents the length of the second bit sequence, and $\Delta$ represents an offset value and may be a real number (for example, a positive integer, 0, or a negative integer). $\lceil \rceil$ indicates rounding up, and $\lfloor \rfloor$ indicates rounding down. For example, $\Delta$ may be equal to 0. Alternatively, $\Delta$ may be equal to -1, -2, -3, -4, -5, or the like, and examples are not provided herein one by one. Alternatively, $\Delta$ may be equal to 1, 2, 3, 4, 5, or the like, and examples are not provided herein one by one.

For example, R=K/N=0.5, the maximum supported code rate $R_h$=0.75, and N=1024. In this case, based on the foregoing relationship, j=1024*0.25/0.5=512. If the quantity E of check bits is equal to 200, 512 columns of the first matrix may be selected rightwards, to obtain the first column of the extension matrix. For example, when $\Delta$= 0, 200 columns may be intercepted from a 513th column of the first matrix to obtain the extension matrix, where the first column of the extension matrix is the 513th column of the first matrix, and a 200th column of the extension matrix is a 712th column of the first matrix.

The extension matrix shown in this embodiment of this application can flexibly adapt to different E. In other words, performance of the second channel encoding can be ensured when different values of E are used. For example, when E=180, a submatrix $H_{sub}$ obtained by intercepting first 180 columns of the extension matrix whose E=200 can also obtain good performance.

In this embodiment of this application, a column weight of a specific column in the extension matrix meets any one or more of the following relationships: The column weight is negatively correlated with E, the column weight is positively correlated with K, the column weight is negatively correlated with N, and the column weight is positively correlated with K/N (namely, the code rate of the first channel encoding). For example, a larger code rate of the first channel encoding indicates a heavier column weight of the specific column. For example, a column weight of the first column in the extension matrix may meet the foregoing relationship. For another example, a column weight of each of at least two columns in the extension matrix meets the foregoing relationship. For another example, a column weight of each column in the extension matrix meets the foregoing relationship. For ease of description, the following uses the column weight of each column as an example to describe a relationship between the column weight and the foregoing parameters.

For example, a smaller value of E indicates a heavier column weight (namely, a larger column weight); or a larger value of K indicates a heavier column weight; or a smaller value of N indicates a heavier column weight; or a larger value of K/N indicates a heavier column weight. Similarly, a larger value of E indicates a lighter column weight (namely, a smaller column weight); or a smaller value of K indicates a lighter column weight; or a larger value of N indicates a lighter column weight; or a smaller value of K/N indicates a lighter column weight.

In this embodiment of this application, the column weight may be a function of N, K, and E. For example, when K/N is fixed, a smaller value of E indicates a heavier column weight. Similarly, when K/N is fixed, a larger value of E indicates a lighter column weight. For example, when E is fixed, a larger value of K/N indicates a heavier column weight. Similarly, when E is fixed, a smaller value of K/N indicates a lighter column weight. For example, a larger value of K/N and a smaller value of E indicate a heavier column weight. Similarly, a smaller value of K/N and a larger value of E indicate a lighter column weight. It may be understood that the foregoing descriptions of the extension matrix are also applicable to the lifted base matrix. In addition, the descriptions of the lifted base matrix are also applicable to the extension matrix.

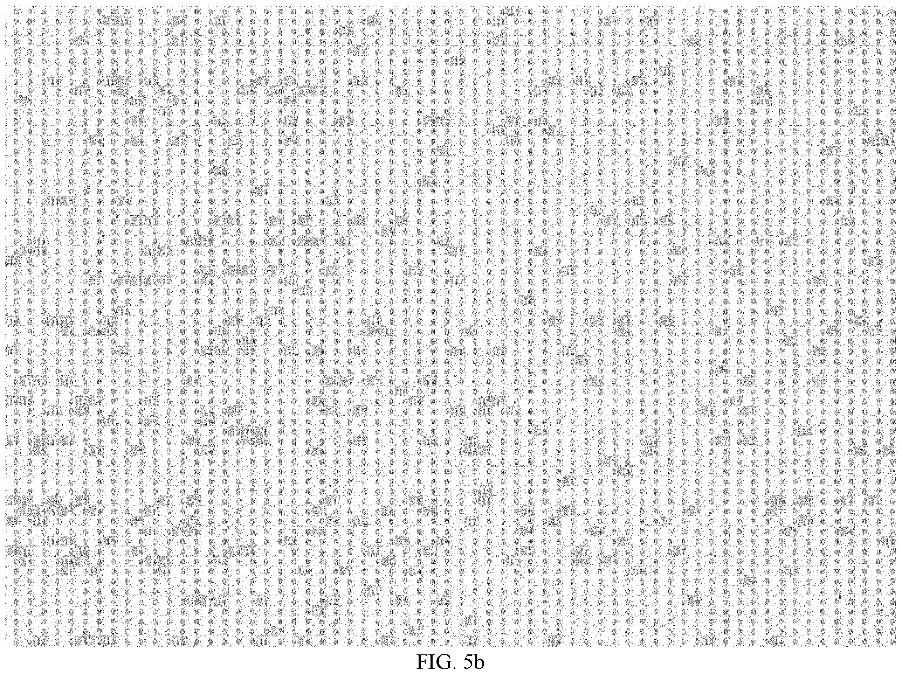

With reference to the extension matrix, this embodiment of this application provides two extension base matrices as an example. FIG. 5a and FIG. 5b are schematic diagrams of a lifted base matrix according to an embodiment of this application. It may be understood that FIG. 5a and FIG. 5b are shown in a form of QC, but should not be construed as a limitation on embodiments of this application. For example, FIG. 5a shows a lifted base matrix shown when E=1024, Z=16, N=1024, and K=512. FIG. 5b shows a lifted base matrix shown when E=1024, Z=16, N=1024, and K=768. Because E shown in FIG. 5a is the same as E shown in FIG. 5b, and 512/1024 is less than 768/1024, a largest column weight (for example, a column weight of a specific column) of the lifted base matrix shown in FIG. 5a is less than a largest column weight (for example, a column weight of a specific column) of the lifted base matrix shown in FIG. 5b. In the lifted base matrix shown in FIG. 5a, a smallest column weight is 1, and the largest column weight is 5. In the lifted base matrix shown in FIG. 5b, a smallest column weight is 1, and the largest column weight is 8. For example, a column weight of a first column of the lifted base matrix shown in FIG. 5a is 3, and a column weight of a first column of the lifted base matrix shown in FIG. 5b is 8.

It may be understood that, in FIG. 5a and FIG. 5b, an N-row and E-column lifted base matrix is shown as an example. However, the lifted base matrix shown in this embodiment of this application may further include a 1024-row and 1024-column unit matrix (based on Z=16, when the unit matrix is converted into a QC form, the unit matrix may be represented as a 64-row and 64-column matrix) (which may be shown in FIG. 4b). In this embodiment of this application, a reason why the lifted base matrix is represented by using the unit matrix and the matrix shown in FIG. 5a or FIG. 5b is as follows: The receive end needs to convert the extension matrix into a Tanner graph during decoding. A unit matrix $S_{NN}$ is included, so that the Tanner graph can be better drawn, so as to assist in belief propagation (belief propagation, BP) algorithm decoding. Certainly, if the extension matrix is represented by $H_{NE}$, the receive end may alternatively autonomously add the unit matrix $S_{NN}$ during decoding.

With reference to the foregoing descriptions of the extension matrix, an embodiment of this application further provides a method for generating a lifted base matrix. For example, a double nesting property of the lifted base matrix shown in this embodiment of this application may be implemented based on a QC matrix by using a tree search algorithm. It may be understood that the method for generating a lifted base matrix shown in this embodiment of this application may be implemented by a transmit end, a receive end, or the like. This is not limited in this embodiment of this application. For example, if the lifted base matrix is implemented by the transmit end, the transmit end may send information about the lifted base matrix to the receive end. For another example, if the lifted base matrix is implemented by the receive end, the receive end may send information about the lifted base matrix to the transmit end. It may be understood that the lifted base matrix shown in this embodiment of this application may alternatively be predefined by a protocol or a standard, or the like. This is not limited in this embodiment of this application.

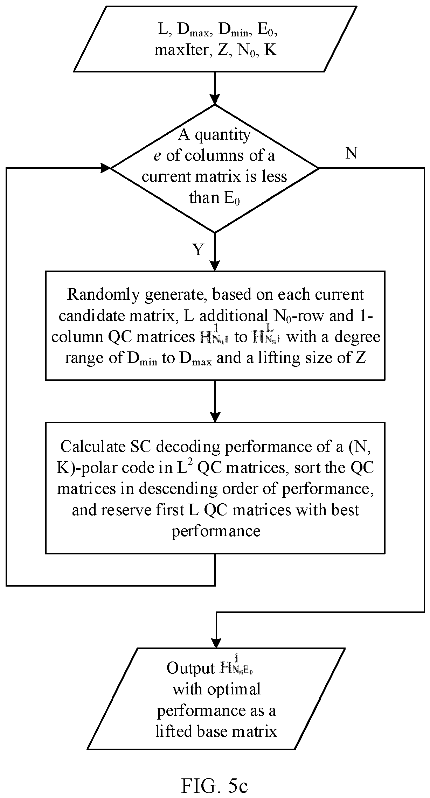

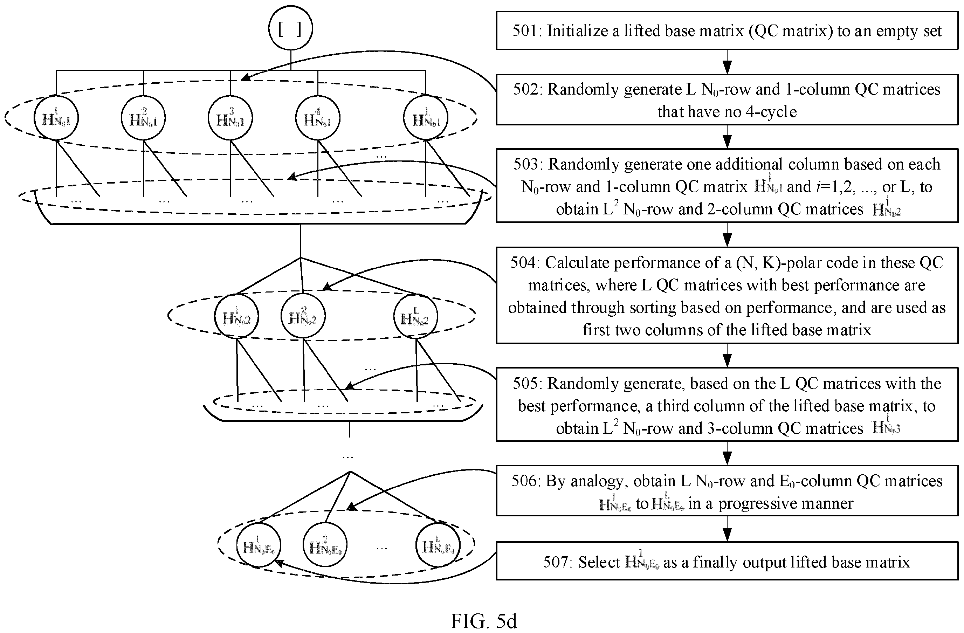

FIG. 5c and FIG. 5d are schematic flowcharts of a method for generating a lifted base matrix according to an embodiment of this application. In FIG. 5c and FIG. 5d, L represents a search width. For example, the search width may be understood as a quantity of initialized random matrices. $D_{max}$ and $D_{min}$ respectively represent a largest column weight and a smallest column weight of the lifted base matrix; $E_0$ represents a maximum quantity of columns of the lifted base matrix; maxIter represents a maximum quantity of iterations that are used for protograph-based extrinsic information transfer (protograph-based extrinsic information transfer, PEXIT) when performance of the lifted base matrix is calculated; Z represents a lifting size (lifting size) of a QC matrix corresponding to the lifted base matrix; $N_0$ represents a maximum quantity of rows of the lifted base matrix; K represents a length of a first bit sequence (which may also be understood as a length of information bits or the like), and e represents a quantity of columns of a currently generated lifted base matrix. In FIG. 5c and FIG. 5d, a progressive tree search process is shown. Optionally, in the tree search process shown in FIG. 5c and FIG. 5d, to reduce search complexity, the lifting size Z in FIG. 5c and FIG. 5d may alternatively be a prime number.

For example, as shown in FIG. 5c, the method for generating a lifted base matrix includes: generating L QC matrices based on input parameters L, $D_{max}$, $D_{min}$, $E_0$, maxIter, Z, $N_0$, and K, where the L QC matrices may be understood as a first column of an initialized lifted base matrix. When the quantity e of columns of the current matrix is less than $E_0$, L QC matrices with $N_0$ rows and one column may be randomly generated based on the L QC matrices, the largest column weight, the smallest column weight, and the lifting size. For example, another matrix is randomly generated based on each of the L QC matrices, that is, L*L QC matrices are obtained. Then, the L*L QC matrices are sorted based on SC decoding performance (which is merely an example), and first L QC matrices with best performance are retained.

Circulation is performed based on this, and when the quantity of columns e of the current matrix is equal to $E_0$, a lifted base matrix with $N_0$ rows and $E_0$ columns and with optimal performance is output.

For example, as shown in FIG. 5d, the method for generating a lifted base matrix includes the following steps.

501: Initialize the lifted base matrix to an empty set.

502: Randomly generate L $N_0$-row and 1-column QC matrices that have no 4-cycle.

For example, the L QC matrices that have no 4-cycle may be randomly generated based on a shifting value (shifting value). For example, if the shifting value is a positive integer less than or equal to 16, that is, the shifting value=1 to 16, it indicates that a value range of a non-zero element of the generated L $N_0$-row and 1-column QC matrices is greater than or equal to 1 and less than or equal to 16. For example, the L QC matrices without 4-cycles may be randomly generated based on a column weight. For example, if a column weight range is 1 to 9, it indicates that a range of column weights of the randomly generated L $N_0$-row and 1-column QC matrices is greater than or equal to 1 and less than or equal to 9.

For example, whether the generated QC matrix has no 4-cycle may be determined based on the lifting size (lifting size) and the shifting value. For specific descriptions of no 4-cycle, details are not described in this embodiment of this application.

For example, after the L $N_0$-row and 1-column QC matrices that have no 4-cycle are randomly generated, the L QC matrices may be further sorted based on performance (for example, based on SC decoding performance). As shown in FIG. 5d, QC matrices obtained by sorting performance in descending order are $H_{N_0 1}^1$, $H_{N_0 1}^2$, $H_{N_0 1}^3$, ... , and $H_{N_0 1}^L$ (for the method shown in FIG. 5d, an example in which performance is sorted in descending order is used). It may be understood that a form (a form in the descriptions of the accompanying drawing) of a matrix with best performance in the L QC matrices shown in FIG. 5d is different from $H_{N_0 1}^1$ , and should not be construed as a limitation on this embodiment of this application.

503: Randomly generate one additional column based on each $N_0$-row and 1-column QC matrix $H_{N_0 1}^i$ and 1 = 1, 2, ..., L, to obtain $L^2$ $N_0$-row and 2-column QC matrices $H_{N_0 2}^i$ .

504: Calculate performance of a (N, K)-polar code in the $L^2$ $N_0$-row and 2-column QC matrices $H_{N_0 2}^i$ , where L $N_0$-row and 2-column QC matrices with best performance are obtained through sorting based on performance, and are used as first two columns of the lifted base matrix.

505: Randomly generate, based on the L $N_0$-row and 2-column QC matrices with the best performance, a third column of the lifted base matrix, to obtain $L^2$ $N_0$-row and 3-column QC matrices $H_{N_0 3}^i$ .

506: By analogy (according to the method shown in step 503 and step 504), obtain L $N_0$-row and $E_0$-column QC matrices $H_{N_0 E_0}^1$ to $H_{N_0 E_0}^L$ in a progressive manner.

507: Select $H_{N_0 E_0}^1$ as a finally output lifted base matrix.

It may be understood that a reason why $H_{N_0 E_0}^1$ is used as the lifted base matrix is as follows: The L $N_0$-row and $E_0$-column QC matrices are all sorted based on performance. In other words, $H_{N_0 E_0}^1$ is a QC matrix with best performance. Certainly, alternatively, sorting may not be performed, and a QC matrix with best performance is directly output as the lifted base matrix. This is not limited in this embodiment of this application.

It may be understood that the foregoing method for generating a lifted base matrix is also applicable to an extension matrix. Details are not described herein again.

With reference to the methods shown in FIG. 5c and FIG. 5d, the following describes the method for generating a lifted base matrix by using examples.

For example, N=1024, K=512, M=2024, E=1000, the lifting size=16, the shifting value=1 to 16, a column weight range is 1 to 9, and L=50. In this embodiment of this application, the extension matrix is a binary-field 1024-row and 1000-column matrix, and the lifted base matrix may be a $\left\lceil \frac{1024}{16} \right\rceil$-row and $\times \left\lceil \frac{1000}{16} \right\rceil$-column matrix, namely, a 64-row $\times$ 63-column matrix. Therefore, a search tree (as shown in FIG. 5d) shown in this embodiment of this application needs to generate 63 columns in a progressive manner. In a corresponding tree search process, the search tree needs to grow 63 layers downward in a progressive manner, and L=50 candidate matrices with optimal performance need to be reserved for each layer.

First, L=50 empty matrices at a layer 0 are generated, and e=0 is set. Because e<63, L=50 64-row and 1-column QC matrices are randomly generated as candidate matrices of a layer 1, and $e=e+1=1$. Then, one additional column is randomly generated based on each 64-row and 1-column QC matrix, to obtain 2500 64-row and 2-column random QC matrices. In addition, column weights of these random QC matrices meet that a maximum value is 9 and a minimum value is 1. A signal-to-noise ratio (signal-to-noise ratio, SNR) required for a polar code of (N=1024, K=512) to reach a BLER=0.01 in the 2500 64-row and 2-column random QC matrices is calculated by using a PEXIT algorithm and a Gaussian approximation (Gaussian approximation, GA) algorithm. In the 2500 random QC matrices, L=50 matrices with smallest SNRs are selected as candidate matrices of a layer 2, and $e=e+1=2$. In this way, the search tree completes growth of the layer 2. Because e is still less than 63, the search tree continues to grow downwards: L=50 64-row and 1-column QC matrices with column weights ranging from 1 to 9 are randomly generated based on each matrix at the layer 2, to obtain 2500 64-row and 3-column random QC matrices at a layer 3. An SNR required for the polar code of (N=1024, K=512) to reach a BLER=0.01 in the 2500 random QC check matrices is calculated by using the PEXIT algorithm and the GA algorithm, and L=50 matrices with smallest SNRs are selected from the 2500 64-row and 3-column random QC check matrices as candidate matrices of the layer 3, and $e=e+1=3$. In this way, the search tree completes growth of the layer 3. By analogy, until the search tree grows to a layer 63 ($e=63$), L=50 64-row and 63-column candidate matrices may be obtained, and a first candidate matrix with best performance is output as the lifted base matrix.

It may be understood that the methods for generating a lifted base matrix shown in FIG. 5c and FIG. 5d are merely examples. This is not limited in this embodiment of this application.

It may be understood that the extension matrix shown in this application is shown by using an example in which N rows and E columns are used. A transposition matrix of the extension matrix, for example, an E-row and N-column matrix, or a shifted matrix (for example, a right-shifted matrix or a left-shifted matrix) of the extension matrix, or a deformation like rotation of the extension matrix falls within the protection scope of this application. Similarly, a variation of the lifted base matrix also falls within the protection scope of this application. For example, as shown above, the column weight of each column in the extension matrix meets any one or more of the following relationships: The column weight is negatively correlated with E, the column weight is positively correlated with K, the column weight is negatively correlated with N, and the column weight is positively correlated with K/N (namely, the code rate of the first channel encoding). In this case, after the extension matrix is transposed, an obtained relationship may be that a row weight of each row in the extension matrix meets any one or more of the following relationships: The row weight is negatively correlated with E, the row weight is positively correlated with K, the row weight is negatively correlated with N, and the row weight is positively correlated with K/N (namely, the code rate of the first channel encoding).

It may be understood that, in the foregoing method for obtaining the E check bits by using the extension matrix, the E check bits may alternatively be obtained by using a check matrix of a Luby transform-LDPC (Luby transform-LDPC, LT-LDPC) code or an LT code, or the E check bits may be obtained by using a generation matrix of an LT-LDPC code.

In the method shown in FIG. 4a, the transmit end needs to perform first channel encoding on the first bit sequence. For example, the transmit end may perform first channel encoding on the first bit sequence based on a first reliability sequence. Locations of the K information bits shown in FIG. 4a are determined based on the first reliability sequence. A length of the first reliability sequence is N, the first reliability sequence is a subsequence of a second reliability sequence, a length of the second reliability sequence is $N_{max}$, and $N_{max}$ is greater than or equal to N.

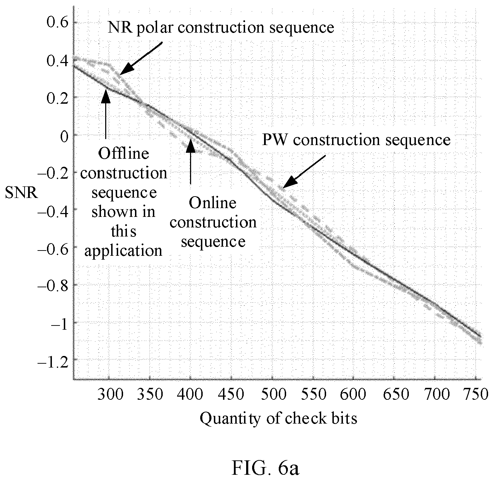

Because the first reliability sequence needs to be flexibly changed based on different code lengths, there may be a plurality of sequences having this type of feature, as shown in FIG. 6a. FIG. 6a is a schematic diagram of decoding performance corresponding to different construction sequences according to an embodiment of this application. FIG. 6a shows decoding performance comparison between an online construction sequence, an offline construction sequence shown in this application, an NR polar construction sequence, and a polarization weight (polarization weight, PW) construction sequence. It can be learned from FIG. 6a that performance of the second reliability sequence provided in this embodiment of this application is optimal, and the performance of the second reliability sequence can be further close to a sequence obtained in an online construction manner. The second reliability sequence in this embodiment of this application may support a maximum code length $N_{max}$ and/or a maximum quantity $E_{max}$ of check bits. Optionally, the second reliability sequence may further support different expansion factors. For example, the second reliability sequence may support a maximum expansion factor $Z_{max}$.

For example, the transmit end may perform first channel encoding on the first bit sequence based on a same set of first reliability sequences. For example, the first reliability sequence may be represented as $Q^N = \left\{ Q_1^N, Q_2^N, Q_3^N, ..., Q_N^N \right\}$ . An element $Q_i^N$ in $Q^N$ represents a sequence number of a subchannel, a value of the element does not exceed N, and subchannels are sorted in ascending order of reliability $W\left(Q_1^N\right) < W\left(Q_2^N\right) < W\left(Q_3^N\right) < ... < W\left(Q_N^N\right)$ , where i=1, ..., or N. For another example, the second reliability sequence may be represented as $Q^{Nmax}$ , where $Q^N$ is a subsequence of $Q^{Nmax}$ , a value of an element $Q_i^{N_{max}}$ in $Q^{Nmax}$ does not exceed N$_{max}$, sorting is performed in ascending order of reliability $W\left(Q_1^{N_{max}}\right) < W\left(Q_2^{N_{max}}\right) < W\left(Q_3^{N_{max}}\right) < ... < W\left(Q_{N_{max}}^{N_{max}}\right)$ , and $i =1,...,N_{max}$.

For example, the second reliability sequence $Q^{N_{max}} = \left\{ Q_1^{N_{max}}, Q_2^{N_{max}}, ..., Q_{N_{max}}^{N_{max}} \right\}$ may be shown in Table 1, where $Q_i^{N_{max}}$ $\left(1 \le Q_i^{N_{max}} \le N_{max}\right)$ is a number of a bit before the first channel encoding is performed. The second reliability sequence $Q^{Nmax}$ is a sequence obtained through sorting in ascending order of reliability $W\left(Q_1^{N_{max}}\right) < W\left(Q_2^{N_{max}}\right) < ... < W\left(Q_{N_{max}}^{N_{max}}\right)$ , where $W\left(Q_i^{N_{max}}\right)$ is reliability corresponding to the bit number $Q_i^{N_{max}}$ .

**Table 1**

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |

| | | | | | | | | | | | | | | | |
|---|---|---|---|---|---|---|---|---|---|---|---|---|---|---|---|
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |

| 52 | 29 | 180 | 531 | 308 | 96 | 436 | 557 | 564 | 348 | 692 | 902 | 820 | 624 | 948 | 940 |
|---|---|---|---|---|---|---|---|---|---|---|---|---|---|---|---|
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |

| | | | | | | | | | | | | | | | |
|---|---|---|---|---|---|---|---|---|---|---|---|---|---|---|---|
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |

| 120 | 78 | 248 | 168 | 376 | 418 | 504 | 611 | 632 | 693 | 760 | 493 | 888 | 848 | 1016 | 1016 |
|-----|-----|-----|-----|-----|-----|-----|-----|-----|-----|-----|-----|-----|-----|------|------|
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

For example, the first reliability sequence may alternatively be represented as $Q^N = \left\{ Q_0^N, Q_1^N, Q_2^N, ..., Q_{N-1}^N \right\}$.

An element $Q_i^N$ in $Q^{N-1}$ represents a sequence number of a subchannel, a value of the element does not exceed N-1, and subchannels are sorted in ascending order of reliability $W\left(Q_0^N\right) < W\left(Q_1^N\right) < W\left(Q_2^N\right) < ... < W\left(Q_{N-1}^N\right)$, where i=0, ..., or N-1. For another example, the second reliability sequence may be represented as $Q^{Nmax}$, where $Q^N$ is a subsequence of $Q^{Nmax}$, a value of an element $Q_i^{N_{max}}$ in $Q^{Nmax}$ does not exceed $N_{max}$-1, sorting is performed in ascending order of reliability $W\left(Q_0^N\right) < W\left(Q_1^N\right) < W\left(Q_2^N\right) < ... < W\left(Q_{N_{max}-1}^{N_{max}}\right)$, and $i = 0,1,...,N_{max}$ -1.

For example, the second reliability sequence $Q^{N_{max}} = \left\{ Q_0^{N_{max}}, Q_1^{N_{max}}, ..., Q_{N_{max}-1}^{N_{max}} \right\}$ may be shown in Table 2, where $Q_i^{N\max}\left(0 \le Q_i^{N_{max}} \le N_{max}-1\right)$ is a number of a bit before the first encoding is performed. The second reliability sequence $Q^{Nmax}$ is a sequence obtained through sorting in ascending order of reliability $W\left(Q_0^{N_{max}}\right) < W\left(Q_1^{N_{max}}\right) < ... < W\left(Q_{N_{max}-1}^{N_{max}}\right)$, where $W\left(Q_i^{N_{max}}\right)$ is reliability corresponding to the bit number $Q_i^{N_{max}}$.

## Table 2

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 0 | 0 | 128 | 58 | 256 | 325 | 384 | 213 | 512 | 315 | 640 | 373 | 768 | 694 | 896 | 861 |
| 1 | 1 | 129 | 85 | 257 | 580 | 385 | 308 | 513 | 788 | 641 | 721 | 769 | 791 | 897 | 862 |
| 2 | 2 | 130 | 135 | 258 | 110 | 386 | 187 | 514 | 127 | 642 | 793 | 770 | 504 | 898 | 863 |
| 3 | 3 | 131 | 544 | 259 | 352 | 387 | 448 | 515 | 422 | 643 | 716 | 771 | 697 | 899 | 867 |
| 4 | 4 | 132 | 276 | 260 | 533 | 388 | 216 | 516 | 412 | 644 | 414 | 772 | 415 | 900 | 869 |
| 5 | 5 | 133 | 86 | 261 | 271 | 389 | 407 | 517 | 235 | 645 | 374 | 773 | 717 | 901 | 870 |
| 6 | 6 | 134 | 139 | 262 | 641 | 390 | 608 | 518 | 451 | 646 | 722 | 774 | 698 | 902 | 871 |

| | | | | | | | | | | | | | | | |
|---|---|---|---|---|---|---|---|---|---|---|---|---|---|---|---|
| 7 | 7 | 135 | 515 | 263 | 171 | 391 | 595 | 519 | 802 | 647 | 794 | 775 | 718 | 903 | 873 |
| 8 | 8 | 136 | 196 | 264 | 305 | 392 | 550 | 520 | 598 | 648 | 805 | 776 | 375 | 904 | 874 |
| 9 | 9 | 137 | 60 | 265 | 560 | 393 | 649 | 521 | 372 | 649 | 377 | 777 | 700 | 905 | 875 |
| 10 | 10 | 138 | 384 | 266 | 117 | 394 | 228 | 522 | 720 | 650 | 737 | 778 | 723 | 906 | 876 |
| 11 | 11 | 139 | 289 | 267 | 158 | 395 | 158 | 523 | 611 | 651 | 724 | 779 | 795 | 907 | 877 |
| 12 | 12 | 140 | 99 | 268 | 225 | 396 | 419 | 524 | 792 | 652 | 796 | 780 | 379 | 908 | 878 |
| 13 | 16 | 141 | 89 | 269 | 326 | 397 | 309 | 525 | 425 | 653 | 427 | 781 | 725 | 909 | 879 |
| 14 | 17 | 142 | 141 | 270 | 300 | 398 | 540 | 526 | 653 | 654 | 806 | 782 | 726 | 910 | 881 |
| 15 | 18 | 143 | 517 | 271 | 212 | 399 | 772 | 527 | 601 | 655 | 378 | 783 | 797 | 911 | 882 |
| 16 | 20 | 144 | 176 | 272 | 534 | 400 | 609 | 528 | 317 | 656 | 655 | 784 | 798 | 912 | 883 |
| 17 | 24 | 145 | 290 | 273 | 400 | 401 | 656 | 529 | 833 | 657 | 603 | 785 | 807 | 913 | 884 |
| 18 | 32 | 146 | 101 | 274 | 547 | 402 | 332 | 530 | 804 | 658 | 738 | 786 | 255 | 914 | 885 |
| 19 | 33 | 147 | 90 | 275 | 329 | 403 | 118 | 531 | 376 | 659 | 319 | 787 | 381 | 915 | 886 |
| 20 | 34 | 148 | 147 | 276 | 642 | 404 | 599 | 532 | 736 | 660 | 728 | 788 | 382 | 916 | 887 |
| 21 | 36 | 149 | 142 | 277 | 584 | 405 | 338 | 533 | 426 | 661 | 835 | 789 | 383 | 917 | 888 |
| 22 | 40 | 150 | 518 | 278 | 306 | 406 | 217 | 534 | 237 | 662 | 809 | 790 | 431 | 918 | 889 |
| 23 | 48 | 151 | 280 | 279 | 279 | 407 | 367 | 535 | 343 | 663 | 380 | 791 | 439 | 919 | 890 |
| 24 | 64 | 152 | 200 | 280 | 173 | 408 | 651 | 536 | 453 | 664 | 740 | 792 | 443 | 920 | 891 |
| 25 | 65 | 153 | 102 | 281 | 118 | 409 | 229 | 537 | 654 | 665 | 429 | 793 | 445 | 921 | 892 |
| 26 | 66 | 154 | 521 | 282 | 537 | 410 | 390 | 538 | 602 | 666 | 239 | 794 | 446 | 922 | 893 |
| 27 | 68 | 155 | 149 | 283 | 199 | 411 | 312 | 539 | 659 | 667 | 810 | 795 | 447 | 923 | 894 |
| 28 | 72 | 156 | 292 | 284 | 63 | 412 | 449 | 540 | 318 | 668 | 455 | 796 | 463 | 924 | 895 |
| 29 | 80 | 157 | 105 | 285 | 387 | 413 | 541 | 541 | 613 | 669 | 605 | 797 | 471 | 925 | 903 |
| 30 | 96 | 158 | 92 | 286 | 226 | 414 | 333 | 542 | 834 | 670 | 615 | 798 | 475 | 926 | 907 |
| 31 | 128 | 159 | 522 | 287 | 121 | 415 | 232 | 543 | 808 | 671 | 744 | 799 | 477 | 927 | 909 |
| 32 | 129 | 160 | 150 | 288 | 179 | 416 | 554 | 544 | 433 | 672 | 837 | 800 | 478 | 928 | 910 |
| 33 | 130 | 161 | 576 | 289 | 549 | 417 | 773 | 545 | 428 | 673 | 430 | 801 | 479 | 929 | 911 |
| 34 | 132 | 162 | 31 | 290 | 330 | 418 | 174 | 546 | 238 | 674 | 817 | 802 | 487 | 930 | 915 |
| 35 | 136 | 163 | 163 | 291 | 216 | 419 | 122 | 547 | 243 | 675 | 812 | 803 | 491 | 931 | 917 |
| 36 | 256 | 164 | 263 | 292 | 174 | 420 | 657 | 548 | 454 | 676 | 435 | 804 | 493 | 932 | 918 |
| 37 | 512 | 165 | 106 | 293 | 538 | 421 | 611 | 549 | 559 | 677 | 606 | 805 | 494 | 933 | 919 |
| 38 | 144 | 166 | 153 | 294 | 644 | 422 | 340 | 550 | 604 | 678 | 752 | 806 | 495 | 934 | 921 |
| 39 | 13 | 167 | 321 | 295 | 283 | 423 | 776 | 551 | 897 | 679 | 838 | 807 | 499 | 935 | 922 |
| 40 | 14 | 168 | 529 | 296 | 308 | 424 | 219 | 552 | 614 | 680 | 818 | 808 | 501 | 936 | 923 |

| 41 | 19 | 169 | 47 | 297 | 389 | 425 | 313 | 553 | 836 | 681 | 899 | 809 | 502 | 937 | 924 |
|---|---|---|---|---|---|---|---|---|---|---|---|---|---|---|---|
| 42 | 21 | 170 | 165 | 298 | 203 | 426 | 423 | 554 | 816 | 682 | 841 | 810 | 503 | 938 | 925 |
| 43 | 22 | 171 | 524 | 299 | 416 | 427 | 394 | 555 | 434 | 683 | 820 | 811 | 505 | 939 | 926 |
| 44 | 25 | 172 | 267 | 300 | 122 | 428 | 672 | 556 | 457 | 684 | 437 | 812 | 506 | 940 | 927 |
| 45 | 26 | 173 | 296 | 301 | 592 | 429 | 582 | 557 | 661 | 685 | 459 | 813 | 507 | 941 | 931 |
| 46 | 35 | 174 | 208 | 302 | 228 | 430 | 354 | 558 | 617 | 686 | 663 | 814 | 508 | 942 | 933 |
| 47 | 257 | 175 | 154 | 303 | 337 | 431 | 286 | 559 | 898 | 687 | 842 | 815 | 509 | 943 | 934 |
| 48 | 37 | 176 | 113 | 304 | 181 | 432 | 182 | 560 | 399 | 688 | 619 | 816 | 510 | 944 | 935 |
| 49 | 258 | 177 | 322 | 305 | 550 | 433 | 233 | 561 | 840 | 689 | 824 | 817 | 511 | 945 | 937 |
| 50 | 38 | 178 | 108 | 306 | 295 | 434 | 124 | 562 | 775 | 690 | 438 | 818 | 607 | 946 | 938 |
| 51 | 28 | 179 | 530 | 307 | 95 | 435 | 556 | 563 | 347 | 691 | 901 | 819 | 623 | 947 | 939 |
| 52 | 160 | 180 | 55 | 308 | 332 | 436 | 659 | 564 | 436 | 692 | 849 | 820 | 631 | 948 | 940 |
| 53 | 41 | 181 | 166 | 309 | 579 | 437 | 615 | 565 | 245 | 693 | 844 | 821 | 635 | 949 | 941 |
| 54 | 260 | 182 | 269 | 310 | 553 | 438 | 341 | 566 | 458 | 694 | 441 | 822 | 637 | 950 | 942 |
| 55 | 42 | 183 | 114 | 311 | 540 | 439 | 315 | 567 | 662 | 695 | 247 | 823 | 638 | 951 | 943 |
| 56 | 44 | 184 | 169 | 312 | 285 | 440 | 240 | 568 | 618 | 696 | 902 | 824 | 639 | 952 | 945 |
| 57 | 67 | 185 | 156 | 313 | 390 | 441 | 777 | 569 | 191 | 697 | 461 | 825 | 671 | 953 | 946 |
| 58 | 49 | 186 | 79 | 314 | 205 | 442 | 562 | 570 | 675 | 698 | 850 | 826 | 687 | 954 | 947 |
| 59 | 264 | 187 | 275 | 315 | 648 | 443 | 344 | 571 | 900 | 699 | 621 | 827 | 695 | 955 | 948 |
| 60 | 69 | 188 | 324 | 316 | 312 | 444 | 451 | 572 | 848 | 700 | 442 | 828 | 699 | 956 | 949 |
| 61 | 50 | 189 | 195 | 317 | 338 | 445 | 396 | 573 | 440 | 701 | 905 | 829 | 701 | 957 | 950 |
| 62 | 70 | 190 | 59 | 318 | 182 | 446 | 402 | 574 | 246 | 702 | 462 | 830 | 702 | 958 | 951 |
| 63 | 73 | 191 | 532 | 319 | 124 | 447 | 206 | 575 | 465 | 703 | 865 | 831 | 703 | 959 | 952 |
| 64 | 52 | 192 | 270 | 320 | 393 | 448 | 673 | 576 | 665 | 704 | 852 | 832 | 719 | 960 | 953 |
| 65 | 74 | 193 | 545 | 321 | 769 | 449 | 557 | 577 | 625 | 705 | 622 | 833 | 727 | 961 | 954 |
| 66 | 76 | 194 | 640 | 322 | 232 | 450 | 784 | 578 | 460 | 706 | 467 | 834 | 729 | 962 | 955 |
| 67 | 272 | 195 | 170 | 323 | 527 | 451 | 431 | 579 | 359 | 707 | 667 | 835 | 730 | 963 | 956 |
| 68 | 81 | 196 | 304 | 324 | 299 | 452 | 356 | 580 | 620 | 708 | 444 | 836 | 731 | 964 | 957 |
| 69 | 192 | 197 | 116 | 325 | 448 | 453 | 186 | 581 | 349 | 709 | 906 | 837 | 732 | 965 | 958 |
| 70 | 56 | 198 | 277 | 326 | 211 | 454 | 235 | 582 | 904 | 710 | 627 | 838 | 733 | 966 | 959 |
| 71 | 82 | 199 | 87 | 327 | 185 | 455 | 663 | 583 | 249 | 711 | 866 | 839 | 734 | 967 | 963 |
| 72 | 131 | 200 | 224 | 328 | 608 | 456 | 623 | 584 | 864 | 712 | 856 | 840 | 735 | 968 | 965 |
| 73 | 133 | 201 | 197 | 329 | 554 | 457 | 586 | 585 | 466 | 713 | 351 | 841 | 739 | 969 | 966 |
| 74 | 84 | 202 | 61 | 330 | 286 | 458 | 779 | 586 | 666 | 714 | 913 | 842 | 741 | 970 | 967 |

| 75 | 134 | 203 | 385 | 331 | 581 | 459 | 704 | 587 | 626 | 715 | 908 | 843 | 742 | 971 | 969 |
|---|---|---|---|---|---|---|---|---|---|---|---|---|---|---|---|
| 76 | 137 | 204 | 546 | 332 | 111 | 460 | 125 | 588 | 677 | 716 | 251 | 844 | 743 | 972 | 970 |
| 77 | 513 | 205 | 177 | 333 | 206 | 461 | 241 | 589 | 567 | 717 | 868 | 845 | 745 | 973 | 971 |
| 78 | 138 | 206 | 328 | 334 | 353 | 462 | 564 | 590 | 350 | 718 | 469 | 846 | 746 | 974 | 972 |
| 79 | 514 | 207 | 278 | 335 | 340 | 463 | 397 | 591 | 779 | 719 | 669 | 847 | 747 | 975 | 973 |
| 80 | 97 | 208 | 172 | 336 | 394 | 464 | 345 | 592 | 912 | 720 | 914 | 848 | 748 | 976 | 974 |
| 81 | 288 | 209 | 291 | 337 | 770 | 465 | 455 | 593 | 250 | 721 | 629 | 849 | 749 | 977 | 975 |
| 82 | 98 | 210 | 536 | 338 | 656 | 466 | 357 | 594 | 481 | 722 | 679 | 850 | 750 | 978 | 977 |
| 83 | 88 | 211 | 91 | 339 | 561 | 467 | 404 | 595 | 468 | 723 | 872 | 851 | 751 | 979 | 978 |
| 84 | 140 | 212 | 198 | 340 | 186 | 468 | 302 | 596 | 668 | 724 | 470 | 852 | 753 | 980 | 979 |
| 85 | 516 | 213 | 62 | 341 | 159 | 469 | 568 | 597 | 628 | 725 | 670 | 853 | 754 | 981 | 980 |
| 86 | 145 | 214 | 386 | 342 | 327 | 470 | 243 | 598 | 678 | 726 | 929 | 854 | 755 | 982 | 981 |
| 87 | 100 | 215 | 143 | 343 | 301 | 471 | 594 | 599 | 407 | 727 | 916 | 855 | 756 | 983 | 982 |
| 88 | 146 | 216 | 519 | 344 | 213 | 472 | 188 | 600 | 928 | 728 | 630 | 856 | 757 | 984 | 983 |
| 89 | 15 | 217 | 281 | 345 | 240 | 473 | 565 | 601 | 707 | 729 | 253 | 857 | 758 | 985 | 984 |
| 90 | 23 | 218 | 120 | 346 | 582 | 474 | 675 | 602 | 252 | 730 | 483 | 858 | 759 | 986 | 985 |
| 91 | 520 | 219 | 201 | 347 | 556 | 475 | 360 | 603 | 482 | 731 | 473 | 859 | 760 | 987 | 986 |
| 92 | 148 | 220 | 178 | 348 | 535 | 476 | 705 | 604 | 472 | 732 | 880 | 860 | 761 | 988 | 987 |
| 93 | 27 | 221 | 103 | 349 | 401 | 477 | 588 | 605 | 681 | 733 | 633 | 861 | 762 | 989 | 988 |
| 94 | 259 | 222 | 548 | 350 | 354 | 478 | 214 | 606 | 632 | 734 | 930 | 862 | 763 | 990 | 989 |
| 95 | 104 | 223 | 293 | 351 | 643 | 479 | 785 | 607 | 363 | 735 | 920 | 863 | 764 | 991 | 990 |
| 96 | 39 | 224 | 93 | 352 | 585 | 480 | 646 | 608 | 781 | 736 | 254 | 864 | 765 | 992 | 991 |
| 97 | 29 | 225 | 282 | 353 | 307 | 481 | 347 | 609 | 591 | 737 | 474 | 865 | 766 | 993 | 993 |
| 98 | 161 | 226 | 523 | 354 | 119 | 482 | 418 | 610 | 484 | 738 | 634 | 866 | 767 | 994 | 994 |
| 99 | 261 | 227 | 151 | 355 | 396 | 483 | 405 | 611 | 960 | 739 | 932 | 867 | 799 | 995 | 995 |
| 100 | 43 | 228 | 388 | 356 | 562 | 484 | 463 | 612 | 682 | 740 | 485 | 868 | 811 | 996 | 996 |
| 101 | 30 | 229 | 577 | 357 | 772 | 485 | 679 | 613 | 571 | 741 | 961 | 869 | 813 | 997 | 997 |
| 102 | 162 | 230 | 202 | 358 | 344 | 486 | 800 | 614 | 782 | 742 | 683 | 870 | 814 | 998 | 998 |
| 103 | 262 | 231 | 107 | 359 | 227 | 487 | 361 | 615 | 709 | 743 | 476 | 871 | 815 | 999 | 999 |
| 104 | 152 | 232 | 336 | 360 | 188 | 488 | 589 | 616 | 787 | 744 | 636 | 872 | 819 | 1000 | 1000 |
| 105 | 45 | 233 | 180 | 361 | 302 | 489 | 408 | 617 | 488 | 745 | 936 | 873 | 821 | 1001 | 1001 |
| 106 | 320 | 234 | 294 | 362 | 214 | 490 | 569 | 618 | 689 | 746 | 486 | 874 | 822 | 1002 | 1002 |
| 107 | 265 | 235 | 94 | 363 | 672 | 491 | 787 | 619 | 365 | 747 | 783 | 875 | 823 | 1003 | 1003 |
| 108 | 528 | 236 | 578 | 364 | 402 | 492 | 596 | 620 | 684 | 748 | 962 | 876 | 825 | 1004 | 1004 |

| 109 | 51 | 237 | 525 | 365 | 356 | 493 | 571 | 621 | 710 | 749 | 489 | 877 | 826 | 1005 | 1005 |
| 110 | 46 | 238 | 297 | 366 | 331 | 494 | 218 | 622 | 411 | 750 | 944 | 878 | 827 | 1006 | 1006 |
| 111 | 164 | 239 | 209 | 367 | 217 | 495 | 310 | 623 | 496 | 751 | 685 | 879 | 828 | 1007 | 1007 |
| 112 | 71 | 240 | 552 | 368 | 586 | 496 | 707 | 624 | 690 | 752 | 964 | 880 | 829 | 1008 | 1008 |
| 113 | 266 | 241 | 155 | 369 | 175 | 497 | 597 | 625 | 223 | 753 | 490 | 881 | 830 | 1009 | 1009 |
| 114 | 112 | 242 | 284 | 370 | 539 | 498 | 600 | 626 | 366 | 754 | 711 | 882 | 831 | 1010 | 1010 |
| 115 | 53 | 243 | 323 | 371 | 645 | 499 | 650 | 627 | 573 | 755 | 686 | 883 | 839 | 1011 | 1011 |
| 116 | 75 | 244 | 204 | 372 | 564 | 500 | 420 | 628 | 371 | 756 | 968 | 884 | 843 | 1012 | 1012 |
| 117 | 54 | 245 | 109 | 373 | 309 | 501 | 791 | 629 | 713 | 757 | 497 | 885 | 845 | 1013 | 1013 |
| 118 | 268 | 246 | 531 | 374 | 776 | 502 | 801 | 630 | 789 | 758 | 691 | 886 | 846 | 1014 | 1014 |
| 119 | 77 | 247 | 167 | 375 | 417 | 503 | 610 | 631 | 692 | 759 | 492 | 887 | 847 | 1015 | 1015 |
| 120 | 273 | 248 | 392 | 376 | 123 | 504 | 601 | 632 | 574 | 760 | 367 | 888 | 851 | 1016 | 1016 |
| 121 | 193 | 249 | 768 | 377 | 593 | 505 | 409 | 633 | 714 | 761 | 976 | 889 | 853 | 1017 | 1017 |
| 122 | 57 | 250 | 115 | 378 | 229 | 506 | 230 | 634 | 423 | 762 | 498 | 890 | 854 | 1018 | 1018 |
| 123 | 168 | 251 | 526 | 379 | 404 | 507 | 687 | 635 | 413 | 763 | 693 | 891 | 855 | 1019 | 1019 |
| 124 | 83 | 252 | 298 | 380 | 704 | 508 | 652 | 636 | 790 | 764 | 500 | 892 | 857 | 1020 | 1020 |
| 125 | 78 | 253 | 210 | 381 | 551 | 509 | 247 | 637 | 803 | 765 | 575 | 893 | 858 | 1021 | 1021 |
| 126 | 274 | 254 | 184 | 382 | 218 | 510 | 368 | 638 | 696 | 766 | 992 | 894 | 859 | 1022 | 1022 |
| 127 | 194 | 255 | 157 | 383 | 360 | 511 | 189 | 639 | 599 | 767 | 715 | 895 | 860 | 1023 | 1023 |

For example, the sequence $Q^{N_{max}}$ obtained by using the online construction method may be used as an offline construction sequence, to obtain $Q^{N_{max}}$ in cases of different quantities E of check bits. For example, the offline construction sequence shown in Table 1 or Table 2 may be obtained based on $Q^{N_{max}}$ corresponding to the different E.

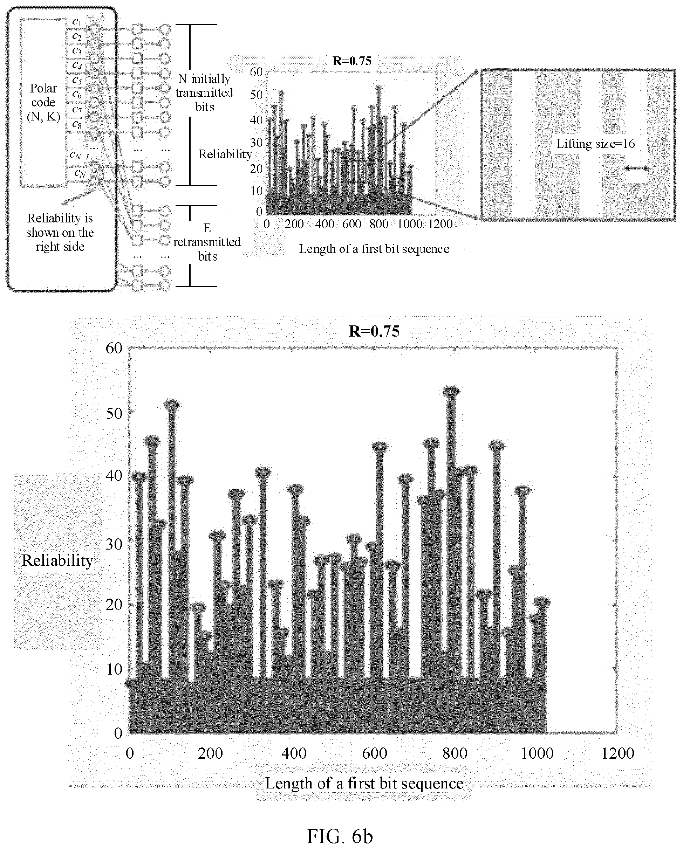

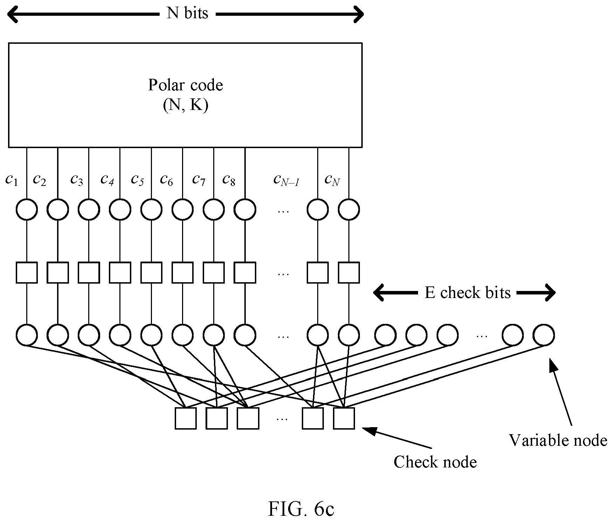

In this embodiment of this application, for example, when the first channel encoding includes polar code encoding, because the check bit is introduced in the method provided in this embodiment of this application, channels corresponding to the N bits are no longer independently and uniformly distributed. For example, the check bit is enhanced compared with one or more of the N bits that participate in the check, resulting in a difference in reliability between the N bits. For example, if one of the N bits participates in more check relationships, reliability of a virtual channel corresponding to the bit is higher. In other words, the reliability of the N bits is related to the column weight of the extension matrix. In addition, because the extension matrix has a QC form, channels of enhanced N bits also presents a block-wise (block-wise) feature. To be specific, intra-block reliability is the same, and inter-block reliability is different. For example, the block size is equal to the lifting size of the lifted base matrix. For example, FIG. 6b is a schematic diagram of a reliability difference between and a block-wise feature of bit channels according to an embodiment of this application. As shown in FIG. 6b, a check relationship between the N bits and the E check bits may be obtained based on a check relationship between a check node and a variable node. The reliability of the N bits included in the second bit sequence obtained through polar code encoding may be shown in a figure on the right side of FIG. 6b. After being scaled up, the figure shown on the right side of FIG. 6b may be shown as a figure on the lower side of FIG. 6b. For example, FIG. 6b shows an example in which the length of the second bit sequence is 1024, the code rate of the first channel encoding is 0.75, and the lifting size is 16. It may be understood that because the lifting size is 16, each column shown in FIG. 6b may represent 16 bits. It may be understood that, for a relationship between the N bits and the E check bits on the left side of FIG. 6b, refer to FIG. 6c. It may be understood that reliability of different bits shown in FIG. 6b is merely an example.

Table 1 and Table 2 show reliability sequences obtained in an offline construction manner. This embodiment of this application further provides an online construction manner. For example, the transmit end may determine reliability of each of the N locations based on a channel state and the extension matrix, where reliability of a location is positively correlated with a quantity of participated check bits; determine the first reliability sequence in ascending order of the reliability of the N locations; and perform first channel encoding on the K information bits based on the first reliability sequence. The channel state may be a state of a channel between the transmit end and the receive end. In other words, the online construction sequence shown in this embodiment of this application may be a function of N, K, E, and Z. In other words, the online construction sequence is not only related to N and K, but also related to E and Z.

For example, a method for constructing the first reliability sequence online may be as follows:

(1) Input the bit length N obtained after the first channel encoding, the quantity K of information bits, the quantity E of check bits (which may alternatively be the target code length M), the lifting size Z of the extension matrix, an SNR search range $SNR_{min}$ to $SNR_{max}$ (for example, $SNR_{min}$=-5 and $SNR_{max}$=20), an $SNR_{step}$ (for example, 0.25), a maximum quantity iterMax (for example, 4) of iterations for PEXIT analysis, and a target BLER, which is, for example, represented by a BLER* (for example, $10^{-2}$).

(2) Determine the extension matrix H based on N, E, and Z, and initialize $SNR_{cur}=SNR_{min}-SNR_{step}$.

(3) Enable $SNR_{cur}=SNR_{cur}+SNR_{step}$, and calculate, based on H by using PEXIT, extrinsic information $I_{EC}$ sent from the check node to the variable node.

(4) Calculate, by using EXIT functions such as $J(\cdot)$ and $J^{-1}(\cdot)$ on a Gaussian channel, a variance $\sigma_i^2$ and an average value $\sigma_i = \dfrac{\sigma_i^2}{2}$ of a transition probability of a channel corresponding to the variable node $c_i$ (i=1, 2, ..., or N). It may be understood that the average value used herein to represent the reliability is merely an example.

(5) Sort the average values $\sigma_i$ in ascending order to obtain, for example, $\overline{\sigma} = [\overline{\sigma}_1, \overline{\sigma}_2, ..., \overline{\sigma}_N]$ and an inner interleaver sequence, for example, I=[$i_1$, ..., $i_N$], and calculate reliability $W\left(Q_i^{N_{max}}\right)$ of a polar code bit channel based on $\overline{\sigma}$ by using GA, where i=1, 2, ..., or N.

(6) Sort numbers of bit channels in ascending order based on $W\left(Q_i^N\right)$ to obtain a construction sequence $Q_i^N$, select K locations with highest reliability as information bits, and calculate BLERs of the K locations in a current $SNR_{cur}$.

(7) If the BLER≤the BLER*, output a current sequence $B=Q_i^N$ as a construction sequence, where i=1, 2, ..., or N; otherwise, return to step (2).

It may be understood that the foregoing online construction method is merely an example, and a specific construction method is not limited in this embodiment of this application.

The following describes a relationship between the extension matrix and the first reliability sequence with reference to specific examples. For example, the length of the second bit sequence is 8, that is, $c_1c_2c_3c_4c_5c_6c_7c_8$, and the lifted base matrix is shown as follows:

$$\begin{bmatrix} 3 & 0 & 0 & 0 & 0 \\ 0 & 1 & 0 & 2 & 0 \\ 2 & 1 & 3 & 0 & 0 \\ 1 & 0 & 2 & 3 & 2 \end{bmatrix}$$

For example, if Z=2, the lifted base matrix is first converted into a binary-field matrix, which may be shown as follows:

$$\begin{array}{cccccccccc}
1 & 0 & 0 & 0 & 0 & 0 & 0 & 0 & 0 & 0 \\
0 & 1 & 0 & 0 & 0 & 0 & 0 & 0 & 0 & 0 \\
0 & 0 & 1 & 0 & 0 & 0 & 1 & 0 & 0 & 0 \\
0 & 0 & 0 & 1 & 0 & 0 & 0 & 1 & 0 & 0 \\
1 & 0 & 1 & 0 & 1 & 0 & 0 & 0 & 0 & 0 \\
0 & 1 & 0 & 1 & 0 & 1 & 0 & 0 & 0 & 0 \\
1 & 0 & 0 & 0 & 1 & 0 & 1 & 0 & 1 & 0 \\
0 & 1 & 0 & 0 & 0 & 1 & 0 & 1 & 0 & 1
\end{array}$$

A corresponding column is shifted rightwards based on the shifting value, and an obtained extension matrix is shown as follows:

$$\begin{array}{cccccccccc}
0 & 1 & 0 & 0 & 0 & 0 & 0 & 0 & 0 & 0 \\
1 & 0 & 0 & 0 & 0 & 0 & 0 & 0 & 0 & 0 \\
0 & 0 & 0 & 1 & 0 & 0 & 1 & 0 & 0 & 0 \\
0 & 0 & 1 & 0 & 0 & 0 & 0 & 1 & 0 & 0 \\
1 & 0 & 0 & 1 & 0 & 1 & 0 & 0 & 0 & 0 \\
0 & 1 & 1 & 0 & 1 & 0 & 0 & 0 & 0 & 0 \\
0 & 1 & 0 & 0 & 1 & 0 & 0 & 1 & 1 & 0 \\
1 & 0 & 0 & 0 & 0 & 1 & 1 & 0 & 0 & 1
\end{array}$$

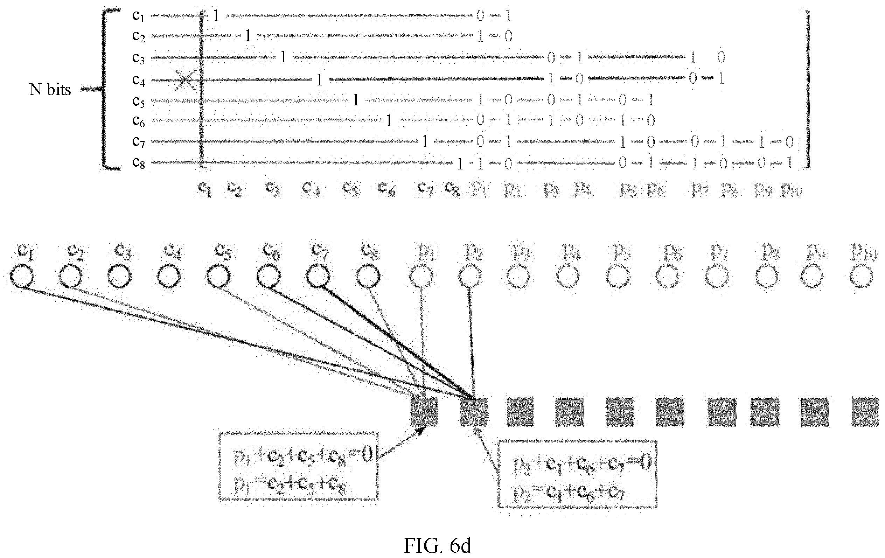

FIG. 6d is a schematic diagram of a relationship between the extension matrix and the first reliability sequence according to an embodiment of this application. As shown in FIG. 6d, based on the check relationship between the check node and the variable node, it may be obtained that on a binary field, $p_1+c_2+c_5+c_8=0$ and $p_2+c_1+c_6+c_7=0$. In other words, $p_1=c_2+c_5+c_8$, and $p_2=c_1+c_6+c_7$. It may be understood that FIG. 6d shows only an example of a relationship between some check bits and the N bits. According to the schematic diagram shown in FIG. 6d, it can be learned that both $c_1$ and $c_2$ participate in one check bit, both $c_3$ and $c_4$ participate in two check bits, both $c_5$ and $c_6$ participate in three check bits, and both $c_7$ and $c_8$ participate in four check bits. It indicates that when the first reliability sequence is constructed, if N=8, a seventh location and an eighth location have highest reliability, and a first location and a second location have lowest reliability. Because the lifting size Z=2, it indicates that the size of the block in the inner interleaver is equal to 2. For example, $c_1$ and $c_2$ correspond to a same block, and locations corresponding to $c_1$ and $c_2$ have same reliability. For another example, $c_7$ and $c_8$ correspond to a same block, and locations corresponding to $c_7$ and $c_8$ have same reliability. For example, reliability in the sequence is sorted in ascending order, to obtain an inner interleaver sequence I=[12345678].

It may be understood that FIG. 6d is a schematic diagram of the relationship between the extension matrix and the first reliability sequence. The extension matrix shown in FIG. 6d is not limited in this embodiment of this application.

In this embodiment of this application, virtual channels corresponding to the N bits have different reliability, and an optimized construction sequence is obtained by sorting the channels in ascending order of the reliability. Therefore, an inner interleaver corresponding to the optimized construction sequence is further required in the encoding and decoding processes. To be specific, in the method shown in FIG. 4a, the transmit end may perform first channel encoding on the first bit sequence based on an inner interleaver sequence, where the inner interleaver sequence is determined based on the extension matrix, and a size of a block of the inner interleaver sequence is equal to the lifting size of the extension matrix. For example, for descriptions of the inner interleaver sequence, refer to the descriptions of the first reliability sequence. Details are not described herein again.

For example, the inner interleaver sequence may have a block-wise interleaving feature. For example, interleaving is performed between blocks in ascending order of reliability, interleaving may be performed or not performed within a block, and a block size may be equal to the lifting size. According to the descriptions of the inner interleaver sequence shown in this embodiment of this application, for example, an inner interleaver sequence I corresponding to a polar code whose lifting size is 16 and N is 256 may have a form shown in Table 3:

**Table 3**

| 1 | 2 | 3 | 4 | 5 | 6 | 7 | 8 | 9 | 10 | 11 | 12 | 13 | 14 | 15 | 16 |
|----|----|----|----|----|----|----|----|----|----|----|----|----|----|----|----|
| 33 | 34 | 35 | 36 | 37 | 38 | 39 | 40 | 41 | 42 | 43 | 44 | 45 | 46 | 47 | 48 |
| 81 | 82 | 83 | 84 | 85 | 86 | 87 | 88 | 89 | 90 | 91 | 92 | 93 | 94 | 95 | 96 |
| 65 | 66 | 67 | 68 | 69 | 70 | 71 | 72 | 73 | 74 | 75 | 76 | 77 | 78 | 79 | 80 |

(continued)

| 17 | 18 | 19 | 20 | 21 | 22 | 23 | 24 | 25 | 26 | 27 | 28 | 29 | 30 | 31 | 32 |
|----|----|----|----|----|----|----|----|----|----|----|----|----|----|----|----|
| 97 | 98 | 99 | 100 | 101 | 102 | 103 | 104 | 105 | 106 | 107 | 108 | 109 | 110 | 111 | 112 |
| 209 | 210 | 211 | 212 | 213 | 214 | 215 | 216 | 217 | 218 | 219 | 220 | 221 | 222 | 223 | 224 |
| 129 | 130 | 131 | 132 | 133 | 134 | 135 | 136 | 137 | 138 | 139 | 140 | 141 | 142 | 143 | 144 |
| 145 | 146 | 147 | 148 | 149 | 150 | 151 | 152 | 153 | 154 | 155 | 156 | 157 | 158 | 159 | 160 |
| 161 | 162 | 163 | 164 | 165 | 166 | 167 | 168 | 169 | 170 | 171 | 172 | 173 | 174 | 175 | 176 |
| 49 | 50 | 51 | 52 | 53 | 54 | 55 | 56 | 57 | 58 | 59 | 60 | 61 | 62 | 63 | 64 |
| 225 | 226 | 227 | 228 | 229 | 230 | 231 | 232 | 233 | 234 | 235 | 236 | 237 | 238 | 239 | 240 |
| 193 | 194 | 195 | 196 | 197 | 198 | 199 | 200 | 201 | 202 | 203 | 204 | 205 | 206 | 207 | 208 |
| 113 | 114 | 115 | 116 | 117 | 118 | 119 | 120 | 121 | 122 | 123 | 124 | 125 | 126 | 127 | 128 |
| 177 | 178 | 179 | 180 | 181 | 182 | 183 | 184 | 185 | 186 | 187 | 188 | 189 | 190 | 191 | 192 |
| 241 | 242 | 243 | 244 | 245 | 246 | 247 | 248 | 249 | 250 | 251 | 252 | 253 | 254 | 255 | 256 |

It may be understood that the inner interleaver sequence shown in Table 3 is merely an example, and should not be construed as a limitation on this embodiment of this application.

The following describes the encoding method shown in embodiments of this application with reference to specific examples. For example, details are as follows:

(1) Input the code length N, the code rate R, the inner interleaver sequence $I_{perm}$, and the quantity E of check bits.

(2) Determine the lifting size of the lifted base matrix based on $Z=\left\lceil \frac{N}{N_0} \right\rceil$, and extend the lifted base matrix to obtain the first matrix.

(3) Puncture/shorten a corresponding row in the first matrix based on the rate matching manner of the polar code; or puncture ($Z \times N_0$ -N) rows with largest row weights in the extension matrix, to obtain a quantity $H_N$ of rows of the extension matrix whose code length is N.

(4) Extract E columns from a $(j=\frac{N\times(R_h-R)}{R})^{th}$ column rightwards based on $H_N$, to obtain an N-row×E-column extension matrix $H_R$ with a code rate R.

It may be understood that a calculation manner of j shown herein is merely an example. For specific descriptions of j, refer to the foregoing descriptions of j, R, $R_h$, N, and $\Delta$. Details are not described herein again.

(5) Perform a row transposition operation on first N rows of $H_R$ based on the interleaver sequence $I_{perm}$ of the polar code, to obtain $H_{perm}$.

(6) Generate E check bits based on $H_{perm}$, where each column of $H_{perm}$ corresponds to one check bit. For example, an $e^{th}$ ($e$=1, 2, ..., or E) check bit $c_e$ =$[c_1, c_2, ..., c_N] \times H_{perm}(1:N, e)$.

For example, the first column of the extension matrix that adapts to the code rate of the first channel encoding may be intercepted through rightward shifting, and different code lengths may be adapted through rate matching.

For example, the following provides an example in which the extension matrix is used to adapt to different code rates.

It is assumed that the code length $N=2^{10}$ (that is, 1024). When the lifting size=16, the code rate R=0.5, and the maximum supported code rate $R_h$=0.75, according to step 4 in the encoding method, $j=\frac{1024\times(0.75-0.5)}{0.5}=512$ columns need to be shifted rightwards from the first column of the first matrix. For example, if the quantity of check bits is E=400, 400 rows are intercepted from a $513^{th}$ row of the first matrix rightwards, to obtain an extension matrix whose code rate is 0.5 and whose quantity of check bits is 400. It may be understood that, for descriptions of the first matrix, refer to the foregoing descriptions. Details are not described herein again.

For another example, the following provides an example in which the extension matrix is used to adapt to different initial transmission code lengths.

It is assumed that the code rate R=0.75. When the lifting size=16, the code length N=992, and the maximum supported code rate is $R_h$=0.75=R, that is, no code rate adaptation operation is required. To adapt to a code length, 32 (1024-992) columns may be punctured based on a puncturing mode according to a 5G NR polar rate matching method, to obtain an extension matrix whose code length is N=992.

It may be understood that the foregoing examples are merely examples, and should not be construed as a limitation on this embodiment of this application.

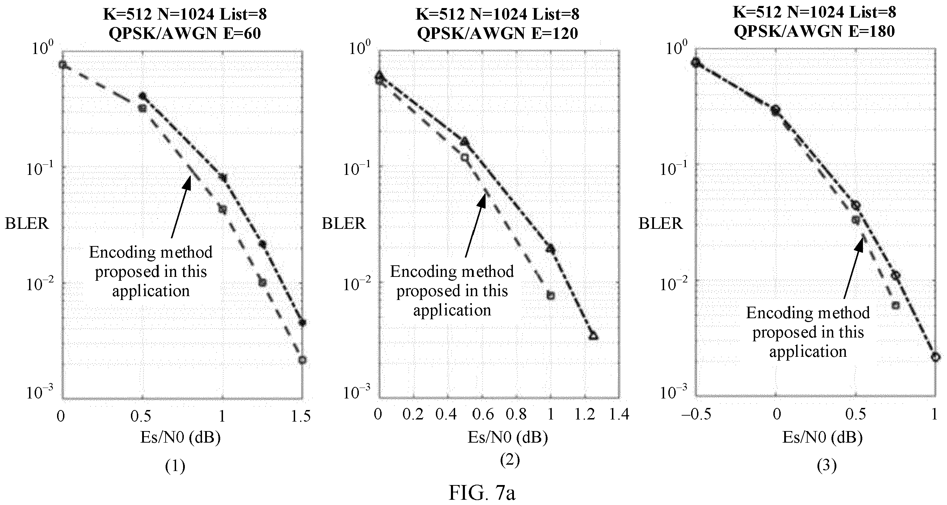

For example, FIG. 7a is a schematic diagram of decoding performance comparison between the encoding method provided in this application and the polar code encoding method according to an embodiment of this application. It may be understood that FIG. 7a shows performance comparison between the encoding method provided in this application and the polar code encoding method by using long code extension. In FIG. 7a, a horizontal coordinate represents an SNR, where for example, the SNR is represented by Es/N0 in a unit of dB; and a vertical coordinate represents a BLER. As shown in FIG. 7a, (1) in FIG. 7a shows K=512, N=1024, list=8, and E=60, a used modulation method includes quadrature phase shift keying (quadrature phase shift keying, QPSK), and a channel model uses additive white Gaussian noise (additive white Gaussian noise, AWGN). (2) in FIG. 7a shows K=512, N=1024, list=8, and E=120, a used modulation method includes quadrature phase shift keying (quadrature phase shift keying, QPSK), and a channel model uses additive white Gaussian noise (additive white Gaussian noise, AWGN). (3) in FIG. 7a shows K=512, N=1024, list=8, and E=180, a used modulation method includes quadrature phase shift keying (quadrature phase shift keying, QPSK), and a channel model uses additive white Gaussian noise (additive white Gaussian noise, AWGN).

Code length extension of the polar code is constructed based on a PW sequence, and a BIV+shorten manner is used for extension in rate matching. An offline optimized sequence shown in Table 1 is used in the encoding method provided in this application, and the extension matrix H is shown in FIG. 5a.

It can be learned from FIG. 7a that when a same BLER is achieved, an SNR (for example, Es/N0) of the encoding method provided in this application is less than that of the polar code encoding method. Similarly, when a same SNR is achieved, a BLER of the encoding method provided in this application is lower than that of the polar code encoding method.

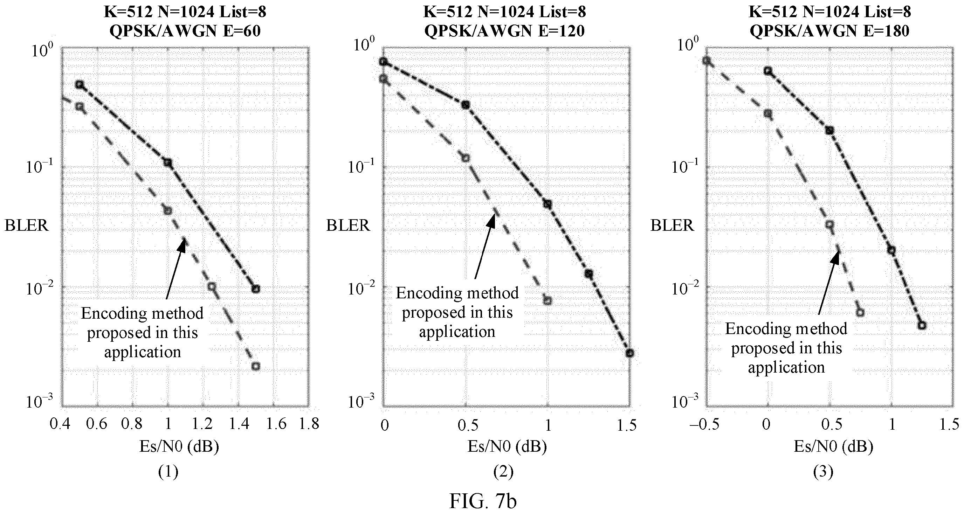

FIG. 7b is a schematic diagram of decoding performance comparison between repetition encoding in the encoding method provided in this application and repetition encoding in the polar code encoding method according to an embodiment of this application. It may be understood that FIG. 7b shows performance comparison between the encoding method provided in this application and the polar code encoding method by using repeated extension. In FIG. 7b, a horizontal coordinate represents an SNR, where for example, the SNR is represented by Es/N0 in a unit of dB; and a vertical coordinate represents a BLER. (1) in FIG. 7b shows K=512, N=1024, list=8, and E=60, a used modulation method includes quadrature phase shift keying (quadrature phase shift keying, QPSK), and a channel model uses additive white Gaussian noise (additive white Gaussian noise, AWGN). (2) in FIG. 7b shows K=512, N=1024, list=8, and E=120, a used modulation method includes quadrature phase shift keying (quadrature phase shift keying, QPSK), and a channel model uses additive white Gaussian noise (additive white Gaussian noise, AWGN). (3) in FIG. 7b shows K=512, N=1024, list=8, and E=180, a used modulation method includes quadrature phase shift keying (quadrature phase shift keying, QPSK), and a channel model uses additive white Gaussian noise (additive white Gaussian noise, AWGN).

Repeated code extension of the polar code is constructed by using an NR sequence, and repeated extension is performed, for rate matching, in a back-to-front manner by using repeated bits. An offline optimized sequence shown in Table 1 is used in the encoding method provided in this application, and the extension matrix H is shown in FIG. 5a.

It can be learned from FIG. 7b that when a same BLER is achieved, an SNR (for example, Es/N0) of the encoding method provided in this application is less than that of the polar code encoding method. Similarly, when a same SNR is achieved, a BLER of the encoding method provided in this application is lower than that of the polar code encoding method.

It may be understood that when the first channel encoding includes polar code encoding, the second channel encoding method provided in this application may also be referred to as an EF-polar code encoding method. Similarly, the second decoding method provided in this application may also be referred to as an EF-polar code decoding method. Alternatively, when the first channel encoding includes polar code encoding, the second channel encoding method and the second channel decoding method provided in this application may be collectively referred to as EF-polar codes.

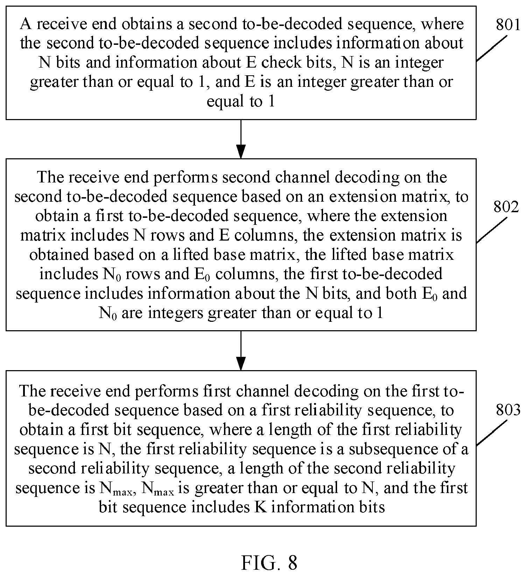

The foregoing is the encoding method provided in embodiments of this application. An embodiment of this application further provides a decoding method. FIG. 8 is a schematic flowchart of the decoding method according to an embodiment of this application. As shown in FIG. 8, the decoding method includes the following steps.

801: A receive end obtains a second to-be-decoded sequence, where the second to-be-decoded sequence includes information about N bits and information about E check bits, N is an integer greater than or equal to 1, and E is an integer greater than or equal to 1.

It may be understood that, that the receive end obtains the second to-be-decoded sequence herein means that the receive end may process a received sequence, and then obtain the second to-be-decoded sequence. For example, the receive end may perform processing such as demodulation on the received sequence, to obtain the second to-be-decoded sequence. The information about the E check bits may be understood as a soft information sequence obtained after the E check bits pass through a channel, or the information about the N bits may be understood as a soft information sequence obtained after the N bits pass through a channel. It may be understood that information about the N bits included in a first to-be-decoded sequence may be the same as or different from the information about the N bits included in the second to-be-decoded sequence.

802: The receive end performs second channel decoding on the second to-be-decoded sequence based on an extension matrix, to obtain a first to-be-decoded sequence, where the extension matrix includes N rows and E columns, the extension matrix is obtained based on a lifted base matrix, the lifted base matrix includes $N_0$ rows and $E_0$ columns, the first to-be-decoded sequence includes the information about the N bits, and both $E_0$ and $N_0$ are integers greater than or equal to 1.

803: The receive end performs first channel decoding on the first to-be-decoded sequence based on a first reliability sequence, to obtain a first bit sequence, where a length of the first reliability sequence is N, the first reliability sequence is a subsequence of a second reliability sequence, a length of the second reliability sequence is $N_{max}$, $N_{max}$ is greater than or equal to N, and the first bit sequence includes K information bits.

It may be understood that for specific descriptions of the first reliability sequence, the second reliability sequence, the first bit sequence, the first to-be-decoded sequence, the second to-be-decoded sequence, the extension matrix, the matrix base matrix, and the like shown in FIG. 8, refer to the encoding method shown above in this application. Details are not described herein again. For example, for descriptions of the extension matrix and the lifted base matrix, refer to the foregoing descriptions shown in FIG. 5a to FIG. 5d. For the first reliability sequence and the second reliability sequence, refer to the foregoing descriptions shown in Table 1, Table 2, and FIG. 6a to FIG. 6d. Details are not described herein again.

It may be understood that how the receive end and the transmit end learn the lifted base matrix and the second reliability sequence is not limited in embodiments of this application.

For example, the following describes the decoding method provided in this embodiment of this application by using a large iterative decoding procedure as an example. However, the decoding method shown below should not be understood as a limitation on embodiments of this application.

For example, the receive end may input: a received sequence $y_1$, $y_2$,..., and $y_T$, where T is a length of the received sequence; encoding parameters: a target code length M, a quantity E of check bits, an extension matrix H, an inner interleaver sequence I, a first reliability sequence (a message location indication sequence B may be obtained based on the first reliability sequence, a location of 0 in the sequence B indicates a frozen bit, and a location of 1 in the sequence B indicates an information bit), a puncturing mode Q, and a CRC polynomial crc_poly; and decoding parameters: a maximum quantity $ITER_{max}$ of iterations for BP decoding and a list which is a dimension of CRC-aided SCL (CRC-Aided SCL, CA-SCL) decoding. For example, the list shown herein may be equal to any value in {1, 2, 4, 8, 16, 32}.

Based on the input, the receive end may output a decoding result of the decoding method provided in this application, for example, an information sequence $u_1$, ..., $u_K$, soft values $L_s=l_{s1}$, ..., and $l_{sN}$ corresponding to the K information bits, and soft values $L_c=L_{c1}$, ..., and $L_{cE}$ corresponding to the check bits. It may be understood that an example in which the information sequence output by the receive end includes information bits is used herein. For example, the information sequence output by the receive end further includes frozen bits. For example, the receive end may further output N bits, and the N bits include K information bits and N-K frozen bits. In this embodiment of this application, whether the output result of the receive end includes only the information bits or includes both the information bits and the frozen bits is not limited. It may be understood that the soft value $L_s$ and the soft value $L_e$ shown above may alternatively be referred to as a soft value $L_{EF}$. In other words, the soft value $L_{EF}$ includes the soft value $L_s$ and the soft value $L_c$.

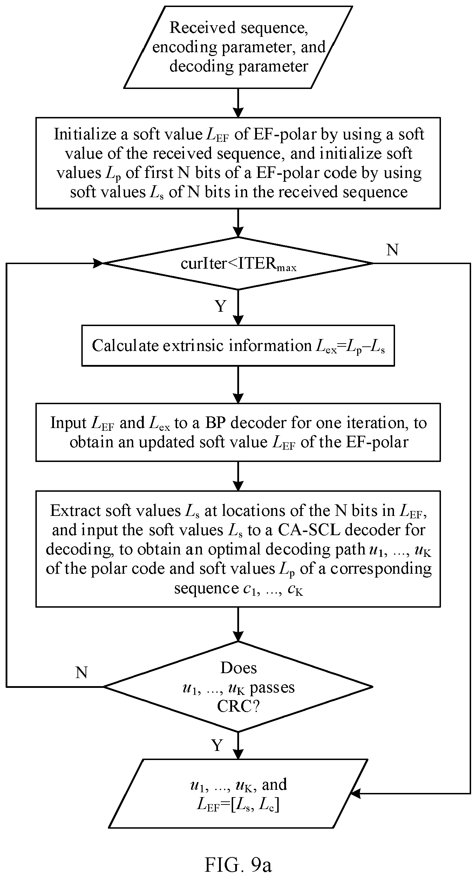

For example, FIG. 9a is a schematic flowchart of large iterative decoding according to an embodiment of this application. As shown in FIG. 9a, the decoding method includes: determining a received sequence, an encoding parameter, and a decoding parameter; then initializing soft values $L_{EF}$, for example, $l_{EF1}$, ..., $l_{EFM}$, of an EF-polar code by using soft values of the received sequence, where soft values $L_p$ of first N bits of the EF-polar code are initialized by using soft values $L_s$ (for example, $ls_1$, ..., $ls_N$) of N bits in the received sequence; when curIter (indicating a current quantity of iterations) is less than $ITER_{max}$, calculating extrinsic information $L_{ex}=L_p-L_s$; and then inputting $L_{EF}$ and $L_{ex}$ to a BP decoder for one iteration to obtain an updated soft value $L_{EF}$ of the EF-polar code. In addition, soft values $L_s$ at locations of the N bits in the $L_{EF}$ are extracted and input to a CA-SCL decoder for decoding, to obtain an optimal decoding path $u_1$, ..., $u_K$ of the polar code and soft values $L_p$, for example, $lp_1$, ..., $lp_N$ of a corresponding sequence $c_1$, ..., $c_N$. When $u_1$, ..., $u_K$ does not pass a CRC check, a next iteration is performed. By analogy, until curIter is not less than $ITER_{max}$, the optimal decoding path $u_1$, ..., $u_K$, $L_s$, and $L_c$ are output.

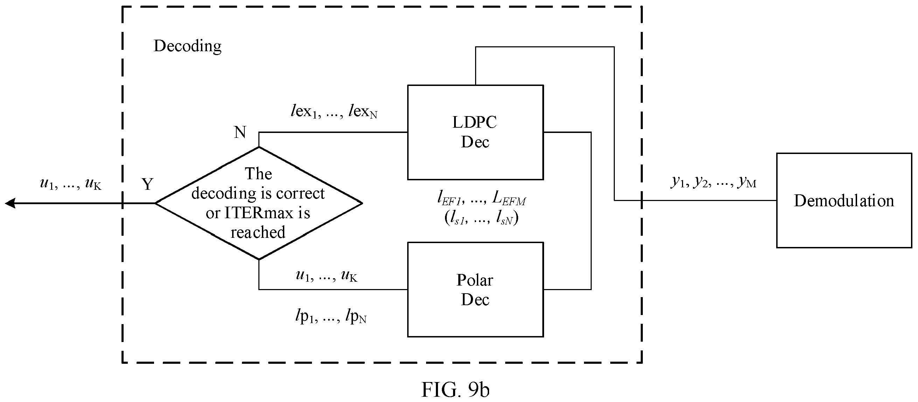

For example, FIG. 9b is a schematic diagram of a decoding method according to an embodiment of this application. The receive end obtains the received sequence $y_1$, $y_2$, ..., and $y_M$, (namely, the second to-be-decoded sequence shown above). It may be understood that M shown herein represents a length of a received symbol. Then, a received sequence (namely, the first to-be-decoded sequence shown above) with N bits is obtained through LDPC decoding (LDPC Dec), and a decoding path $u_1$, ..., $u_K$ of the N bits and corresponding $lp_1$, ..., $lp_N$ are obtained through polar code decoding (polar Dec). If the decoding is incorrect or the $ITER_{max}$ is not reached, LDPC decoding and polar code decoding (polar Dec) are performed again based on the extrinsic information $Iex1, ..., Iex_N$ until the decoding is correct or the $ITER_{max}$ is reached, and an optimal decoding path $u_1, ..., u_K$ is output. Optionally, $L_s$ and $L_c$ may be further output.

It may be understood that the methods shown in FIG. 9a and FIG. 9b are merely examples, and should not be construed as a limitation on embodiments of this application. The LDPC decoding and the polar code decoding are merely examples of embodiments of this application, and specific methods for the second channel decoding and the first channel decoding are not limited.

According to the method provided in this embodiment of this application, decoding of the N bits may be assisted by using soft values generated by using the E check bits, and an early stop decoding policy is supported. To be specific, the LDPC Dec is iterated once each time, and then a decoding result is sent to the polar Dec for decoding. A maximum quantity of allowed attempt iterations is $ITER_{max}$, and a stop condition is that $ITER_{max}$ is reached or polar Dec decoding succeeds.

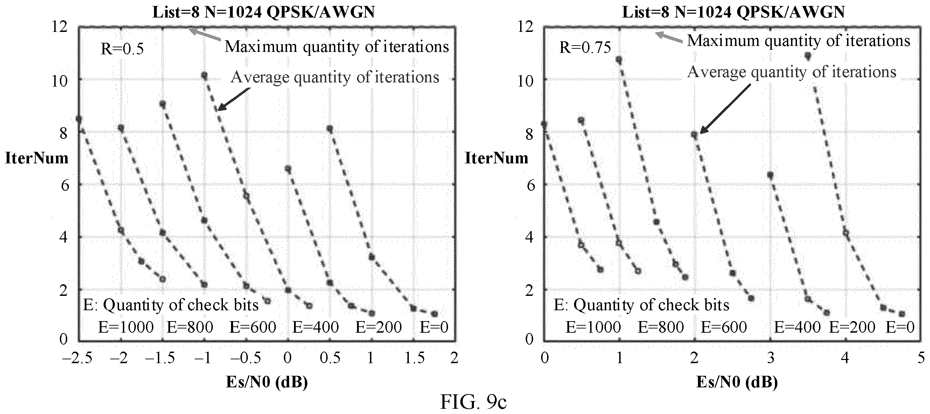

FIG. 9c is a schematic diagram of comparison between maximum decoding complexity and average decoding complexity of an EF-polar code according to an embodiment of this application. It may be understood that, in FIG. 9c, a horizontal axis represents an SNR, and coordinates represent a quantity of iterations (iterNum). The left side of FIG. 9c shows a maximum quantity and an average quantity of iterations of the EF-polar code during large iterative decoding, where R=0.5, N=1024, K=512, and E={0, 2004, 400, 600, 800, 1000} are used as an example. The right side of FIG. 9c shows a maximum quantity and an average quantity of iterations of the EF-polar code during large iterative decoding, where R=0.75, N=1024, K=768, and E={0, 2004, 400, 600, 800, 1000} are used as an example. It can be learned from FIG. 9c that, the target code length M is given, the average quantity of iterations decreases rapidly as the SNR increases, and as the target code length M increases, a minimum quantity of iterations required for performance convergence presents an increasing trend. It may be understood that, in FIG. 9c, a used modulation scheme is QPSK or AWGN.

The EF-polar code provided in this application not only maintains features of a strong structure and high decoding efficiency of a polar code, but also has advantages of flexible code length extension and easy generation of a soft value of an LDPC code, and effectively combines advantages of the LDPC code and the NR polar code.

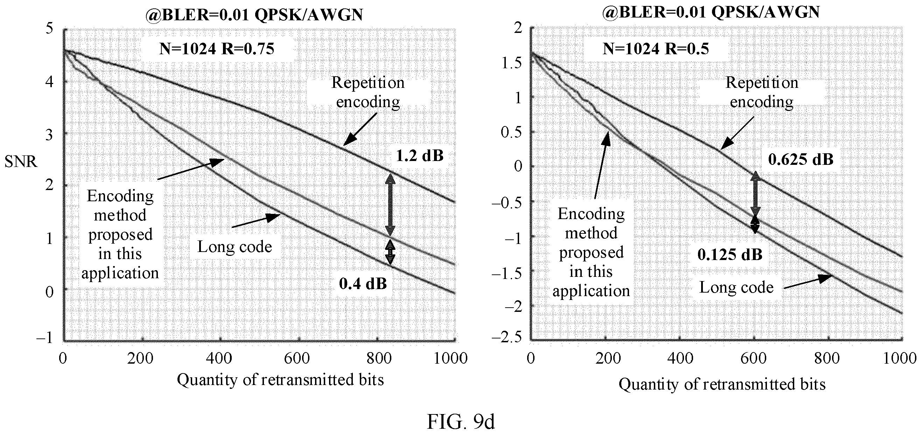

FIG. 9d to FIG. 9g are schematic diagrams of performance comparison between an encoding method, a repetition encoding method, and a long code encoding method according to an embodiment of this application. It may be understood that, in FIG. 9d to FIG. 9g, check bits range from 0 bits to 1000 bits, a code length N={1024, 992}, and a code rate R={0.5, 0.75}. For example, CA24-SCL8 decoding is used for decoding of repetition encoding and long code encoding. A decoding procedure in FIG. 9a is used for decoding provided in this embodiment of this application, and a maximum quantity of iterations is 12. For example, online construction of repetition encoding and long code encoding uses nature (nature, NAT)+puncture+Gaussian approximation (Gaussian Approximation, GA), and online construction of the encoding method provided in this embodiment of this application may be the online construction procedure provided in the foregoing embodiments. For example, a 5G NR offline sequence is used for offline construction of the repetition encoding, bit reversal (bit reversal, BIV)+shorten+polarization weight (polarization weight, PW) is used for offline construction of the long code encoding, and an optimized offline sequence in Table 1 or Table 2 is used for offline construction of the encoding method provided in this embodiment of this application. A modulation mode is QPSK.

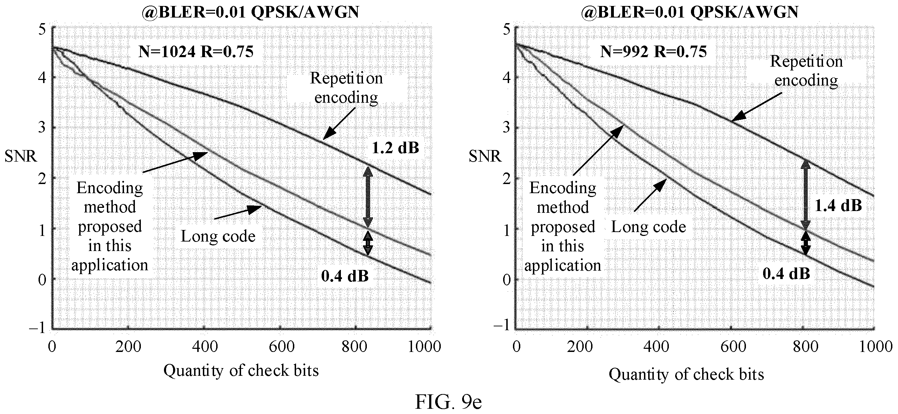

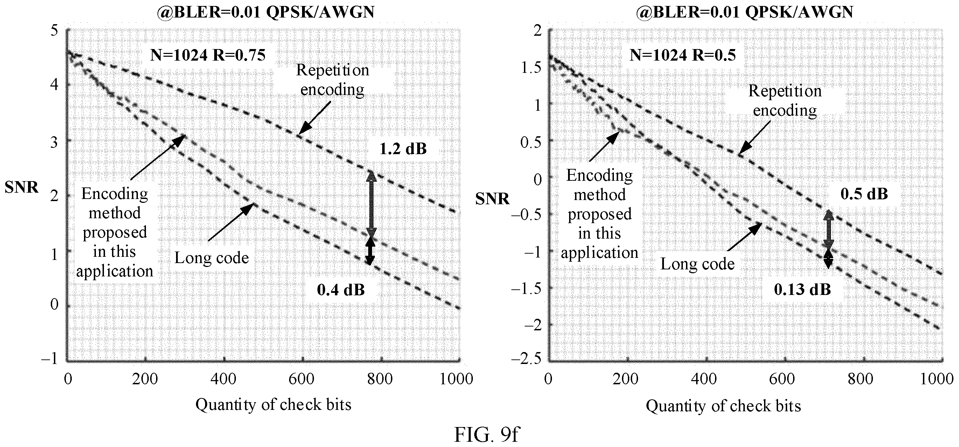

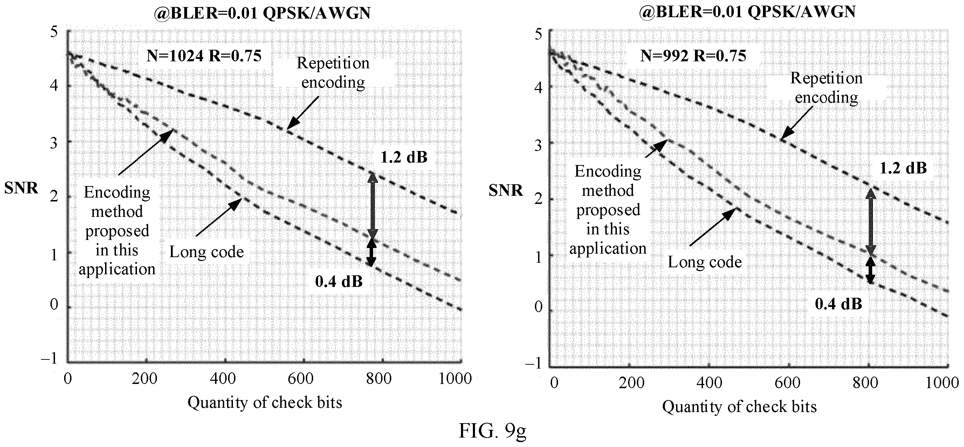

It may be understood that FIG. 9d shows performance comparison based on online construction when code lengths are the same and code rates are different. FIG. 9e shows performance comparison based on online construction when code lengths are different and code rates are the same. FIG. 9f shows performance comparison based on offline construction when code lengths are the same and code rates are different. FIG. 9g shows performance comparison based on offline construction when code lengths are different and code rates are the same.

It can be learned from FIG. 9d to FIG. 9g that the encoding method provided in this embodiment of this application is better than the repetition encoding method. In addition, a difference between performance of the encoding method provided in this embodiment of this application and performance of the long code encoding is small, and in some scenarios, the performance of the encoding method is even better than the performance of the long code encoding. The encoding method provided in this embodiment of this application not only has a large encoding gain, but also can have better performance than long code encoding in particular in SC or CA-SCL8 decoding performance.

FIG. 10 is a schematic diagram of an encoding method and a decoding method according to an embodiment of this application. As shown in FIG. 10, a transmit end may perform first channel encoding on K information bits such as $u_1, ..., u_K$, to obtain a second bit sequence, for example, $c_1, c_2, ..., ex$; then obtain a sequence $d_1, d_2, ..., d_N$ (for example, obtained by using an inner interleaver sequence) through inner interleaving; perform second channel encoding on the sequence $d_1, d_2, ..., d_N$, to obtain a third bit sequence, for example, $x_1, x_2, ..., x_N, x_{N+1}, ..., x_{N+E}$; and then modulate the third bit sequence, to obtain a sending sequence, for example, $s_1, s_2, ..., s_T$. It may be understood that the first channel encoding and the second channel encoding shown in FIG. 10 may be implemented by using different encoders, or the first channel encoding and the second channel encoding may be implemented by using one encoder. For example, the first channel encoding, the inner interleaving, and the second channel encoding shown in FIG. 10 may also be referred to as encoding, as shown in a dashed line part in FIG. 10.

As shown in FIG. 10, a receive end obtains a received sequence $r_1$, $r_2$, ..., $r_T$ through a channel, where T is a length of the received sequence. It may be understood that FIG. 10 shows an example in which a length of a sent sequence is the same as the length of the received sequence. In a specific implementation, the length of the sent sequence may be different from the length of the received sequence. The receive end demodulates the received sequence, to obtain a second to-be-decoded sequence $y_1$, $y_2$, ..., $y_M$; and then performs second channel decoding and first channel decoding on the second to-be-decoded sequence $y_1$, $y_2$, ..., $y_M$, to obtain the K information bits. Alternatively, the receive end obtains the K information bits after demodulating and decoding the received sequence. It may be understood that the first channel decoding and the second channel decoding may be implemented by using one decoder, or the first channel decoding and the second channel decoding may be implemented by using different decoders. This is not limited in this embodiment of this application. Alternatively, both demodulation and decoding may be implemented by using a same device. This is not limited in this embodiment of this application.

It can be learned from the EF-polar code encoding method that, in a case of the same target code length M, complexity of EF-polar code encoding is lower than complexity of NR polar encoding based on long code extension, and is slightly higher than complexity of an NR polar encoding scheme based on repeated extension, and a value of a higher part is related only to the quantity of check bits $E = M - 2^{\lceil \log_2 M \rceil}$. Table 4 shows encoding complexity of different encoding policies. From a perspective of flexible extension, flexibility of the EF-polar code is far higher than that of the NR polar long code extension encoding scheme. In particular, when the code length M exceeds a polar mother code length N by a small amount, using the EF-polar code is most cost-effective.

**Table 4**

| Encoding scheme | Polar long code encoding | EF-Polar encoding | Polar repetition encoding |
|---|---|---|---|
| Complexity O(·) | $2^{\lceil \log_2 M \rceil}$ $\times \log(2^{\lceil \log_2 M \rceil})$ | $2^{\lceil \log_2 M \rceil} \cdot \log(2^{\lceil \log_2 M \rceil})$ $+ (M - 2^{\lceil \log_2 M \rceil})$ | $2^{\lceil \log_2 M \rceil}$ $\times \log(2^{\lceil \log_2 M \rceil})$ |

From a perspective of decoding, because a path length that needs to be maintained by the EF-polar code in an SCL decoding process is shorter, storage space and search complexity required by the EF-polar code in CA-SCL decoding are lower than those required by the NR polar long code. In addition, compared with pure LDPC decoding, an EF-polar rule-based system encoding structure enables the EF-polar code to have higher decoding efficiency, and has lower complexity than a pure LDPC code when code lengths are the same. In addition, EF-polar decoding may output a plurality of soft values including an extension bit, to resolve a problem that a soft value is not easily generated in an NR polar.

In this embodiment of this application, the N bits of the EF-polar code are generated by using the polar code, so that better error correction performance can be obtained than that of the NR polar code. Generating the check bits of the EF-polar code by using the extension matrix can extend the code length more flexibly and generate soft values more easily. In addition, when the large iterative decoding is used to generate an estimated value of an information bit, a corresponding soft value can also be generated. Therefore, the large iterative decoding is more suitable for scenarios such as multi-user detection on a data channel. In addition, the EF-polar decoding policy provided in this application has a feature of early stop, and can effectively reduce a decoding delay and decoding complexity.

The encoding method and the decoding method shown above in this application may be further applied to a data packet layer. To be specific, the N bits shown above may be data blocks at the data packet layer. Similarly, a check data packet may also be generated by using an extension matrix.

A communication apparatus provided in an embodiment of this application is described below.

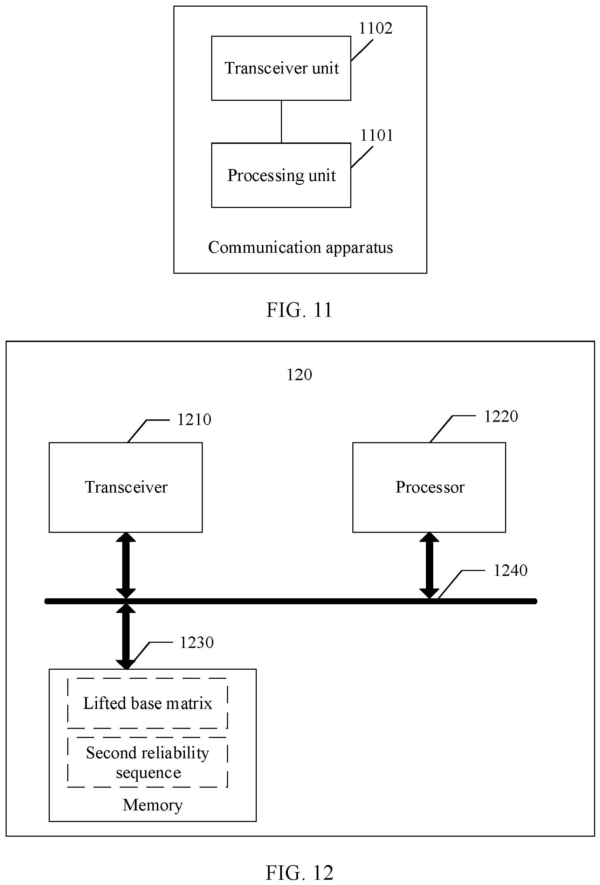

In this application, the communication apparatus is divided into function modules based on the foregoing method embodiments. For example, each function module may be obtained through division based on each corresponding function, or two or more functions may be integrated into one processing module. The integrated module may be implemented in a form of hardware, or may be implemented in a form of a software function module. It should be noted that, in this application, module division is an example, and is merely a logical function division. In actual implementation, another division manner may be used. The following describes in detail the communication apparatuses in embodiments of this application with reference to FIG. 11 to FIG. 13.

FIG. 11 is a schematic diagram of a structure of a communication apparatus according to an embodiment of this application. As shown in FIG. 11, the communication apparatus includes a processing unit 1101 and a transceiver unit 1102.

In some embodiments of this application, the communication apparatus may be the transmit end shown above, the chip in the transmit end, or the like. In other words, the communication apparatus may be configured to perform the steps, functions, or the like performed by the transmit end in the foregoing method embodiments.

The processing unit 1101 is configured to: obtain a first bit sequence and a target code length M; perform first channel encoding on the first bit sequence, to obtain a second bit sequence; and perform second channel encoding based on the second bit sequence, to obtain a third bit sequence.

The processing unit 1101 is configured to output the third bit sequence.

It may be understood that, that the processing unit 1101 obtains the first bit sequence may further include: The processing unit 1101 performs data processing on to-be-processed data input by the transceiver unit 1102, to obtain the first bit sequence; or the processing unit 1101 obtains the first bit sequence through the transceiver unit 1102. This is not limited in this embodiment of this application.

In a possible implementation, the processing unit 1101 is specifically configured to perform second channel encoding based on the second bit sequence and an extension matrix.

In a possible implementation, the processing unit 1101 is specifically configured to perform first channel encoding on the first bit sequence based on an inner interleaver sequence.

In this embodiment of this application, for descriptions of the first bit sequence, the second bit sequence, the third bit sequence, the first channel encoding, the second channel encoding, the extension matrix, a lifted base matrix, a first reliability sequence, a second reliability sequence, and the like, refer to the foregoing method embodiments. Details are not described herein again. For example, for descriptions of the extension matrix and the lifted base matrix, refer to FIG. 5a to FIG. 5d. For the first reliability sequence and the second reliability sequence, refer to FIG. 6a to FIG. 6d.

It may be understood that specific descriptions of the transceiver unit and the processing unit described in this embodiment of this application are merely examples. For specific functions, steps, or the like of the transceiver unit and the processing unit, refer to the foregoing method embodiments. Details are not described herein again. For example, the processing unit 1101 may be further configured to perform steps, functions, or the like of generating a lifted base matrix shown in FIG. 5c and FIG. 5d.

FIG. 11 is reused. In some other embodiments of this application, the communication apparatus may be the receive end shown above, the chip in the receive end, or the like. In other words, the communication apparatus may be configured to perform the steps, functions, or the like performed by the receive end in the foregoing method embodiments.

The processing unit 1101 is configured to: obtain a second to-be-decoded sequence; perform second channel decoding on the second to-be-decoded sequence based on an extension matrix, to obtain a first to-be-decoded sequence; and perform first channel decoding on the first to-be-decoded sequence based on a first reliability sequence, to obtain a first bit sequence.

It may be understood that, that the processing unit 1101 is configured to obtain the second to-be-decoded sequence shown above may be further understood as: The transceiver unit 1102 is configured to input to-be-processed data (for example, a received sequence), and a logic circuit is configured to process the to-be-processed data, to obtain the second to-be-decoded sequence; or the processing unit 1101 obtains the second to-be-decoded sequence from another apparatus, a component, or the like through the transceiver unit 1102.

In a possible implementation, the processing unit 1101 is specifically configured to perform first channel decoding on the first to-be-decoded sequence based on the first reliability sequence and an inner interleaver sequence.

In this embodiment of this application, for descriptions of the first bit sequence, the first to-be-decoded sequence, the second to-be-decoded sequence, first channel encoding, second channel encoding, an extension matrix, a lifted base matrix, the first reliability sequence, a second reliability sequence, and the like, refer to the foregoing method embodiments. Details are not described herein again. For example, for descriptions of the extension matrix and the lifted base matrix, refer to FIG. 5a to FIG. 5d. For the first reliability sequence and the second reliability sequence, refer to FIG. 6a to FIG. 6d.

It may be understood that specific descriptions of the transceiver unit and the processing unit described in this embodiment of this application are merely examples. For specific functions, steps, or the like of the transceiver unit and the processing unit, refer to the foregoing method embodiments. Details are not described herein again. For example, the processing unit 1101 may be further configured to perform steps, functions, or the like of the decoding methods shown in FIG. 9a and FIG. 9b.

The foregoing describes the transmit end and the receive end in embodiments of this application. The following describes possible product forms of the transmit end and the receive end. It should be understood that any form of product having the function of the transmit end described in FIG. 11 or any form of product having the function of the receive end described in FIG. 11 falls within the protection scope of embodiments of this application. It should be further understood that the following descriptions are merely examples, and product forms of the transmit end and the receive end in embodiments of this application are not limited thereto.

In a possible implementation, in the communication apparatus shown in FIG. 11, the processing unit 1101 may be one or more processors, the transceiver unit 1102 may be a transceiver, or the transceiver unit 1102 may include a sending unit and a receiving unit. The sending unit may be a transmitter, the receiving unit may be a receiver, and the sending unit and the receiving unit are integrated into one device, for example, a transceiver. In this embodiment of this application, the processor and the transceiver may be coupled, or the like. A manner of a connection between the processor and the transceiver is not limited in this embodiment of this application.

As shown in FIG. 12, a communication apparatus 120 includes one or more processors 1220 and a transceiver 1210.

For example, when the communication apparatus is configured to perform the steps, the methods, or the functions performed by the transmit end, the processor 1220 is configured to: obtain a first bit sequence and a target code length M; perform first channel encoding on the first bit sequence, to obtain a second bit sequence; perform second channel encoding based on the second bit sequence, to obtain a third bit sequence; and output the third bit sequence.

For example, when the communication apparatus is configured to perform the steps, the methods, or the functions performed by the receive end, the processor 1220 is configured to: obtain a second to-be-decoded sequence; perform second channel decoding on the second to-be-decoded sequence based on an extension matrix, to obtain a first to-be-decoded sequence; and perform first channel decoding on the first to-be-decoded sequence based on a first reliability sequence, to obtain a first bit sequence.

In this embodiment of this application, for descriptions of the first bit sequence, the first to-be-decoded sequence, the second to-be-decoded sequence, first channel encoding, second channel encoding, an extension matrix, a lifted base matrix, the first reliability sequence, a second reliability sequence, and the like, refer to the foregoing method embodiments. Details are not described herein again.

It may be understood that for specific descriptions of the processor and the transceiver, refer to the descriptions of the processing unit and the transceiver unit shown in FIG. 11. Details are not described herein again.

In various implementations of the communication apparatus shown in FIG. 12, the transceiver may include a receiver and a transmitter. The receiver is configured to perform a receiving function (or operation) and the transmitter is configured to perform a transmitting function (or operation). The transceiver is configured to communicate with another device/apparatus through a transmission medium.

Optionally, the communication apparatus 120 may further include one or more memories 1230, configured to store program instructions and/or data. The memory 1230 is coupled to the processor 1220. The coupling in this embodiment of this application may be an indirect coupling or a communication connection between apparatuses, units, or modules in an electrical form, a mechanical form, or another form, and is used for information exchange between the apparatuses, the units, or the modules. The processor 1220 may cooperate with the memory 1230. The processor 1220 may execute the program instruction stored in the memory 1230. Optionally, at least one of the one or more memories may be included in the processor. In this embodiment of this application, the memory 1230 may store any one or more of a lifted base matrix, a second reliability sequence, or the like. For example, only the lifted base matrix, the second reliability sequence, and the like are shown as examples in the memory shown in FIG. 12. It may be understood that, in FIG. 12, that the memory stores the lifted base matrix and the second reliability sequence is indicated by a dashed line, because the memory may store the lifted base matrix and the second reliability sequence, or may store only the lifted base matrix, or may not store the lifted base matrix and the second reliability sequence.

A specific connection medium between the transceiver 1210, the processor 1220, and the memory 1230 is not limited in this embodiment of this application. In this embodiment of this application, the memory 1230, the processor 1220, and the transceiver 1210 are connected through a bus 1240 in FIG. 12. The bus is represented by using a thick line in FIG. 12. A connection manner between other components is schematically described, and is not limited thereto. The bus may be classified into an address bus, a data bus, a control bus, and the like. For ease of representation, only one bold line is used to represent the bus in FIG. 12, but this does not indicate that there is only one bus or only one type of bus.

In this embodiment of this application, the processor may be a general-purpose processor, a digital signal processor, an application-specific integrated circuit, a field programmable gate array or another programmable logic device, a discrete gate or transistor logic device, a discrete hardware component, or the like. The processor can implement or execute the methods, the steps, and the logical block diagrams disclosed in embodiments of this application. The general-purpose processor may be a microprocessor or any conventional processor or the like. The steps of the methods disclosed in combination with embodiments of this application may be directly implemented by a hardware processor, or may be implemented by using a combination of hardware and software modules in the processor, or the like.

In embodiments of this application, the memory may include but is not limited to a nonvolatile memory like a hard disk drive (hard disk drive, HDD) or a solid-state drive (solid-state drive, SSD), a random access memory (Random Access Memory, RAM), an erasable programmable read-only memory (Erasable Programmable ROM, EPROM), a read-only memory (Read-Only Memory, ROM), or a portable read-only memory (Compact Disc Read-Only Memory, CD-ROM). The memory is any storage medium that can be used to carry or store program code in a form of an instruction or a data structure and that can be read and/or written by a computer (for example, the communication apparatus shown in this application). However, this application is not limited thereto. The memory in embodiments of this application may alternatively be a circuit or any other apparatus that can implement a storage function, and is configured to store the program instructions and/or the data.

The processor 1220 is mainly configured to: process a communication protocol and communication data, control an entire communication apparatus, perform a software program, and process data of the software program. The memory 1230 is mainly configured to store the software program and the data. The transceiver 1210 may include a control circuit and an antenna. The control circuit is mainly configured to: perform a conversion between a baseband signal and a radio frequency signal, and process the radio frequency signal. The antenna is mainly configured to receive and send a radio frequency signal in a form of an electromagnetic wave. An input/output apparatus, for example, a touchscreen, a display, or a keyboard, is mainly configured to receive data entered by a user and output data to the user.

After the communication apparatus is powered on, the processor 1220 may read the software program in the memory 1230, interpret and execute instructions of the software program, and process data of the software program. When data needs to be sent wirelessly, the processor 1220 performs baseband processing on the to-be-sent data, and outputs a baseband signal to a radio frequency circuit. After performing radio frequency processing on the baseband signal, the radio frequency circuit sends a radio frequency signal in an electromagnetic wave form through the antenna. When data is sent to the communication apparatus, the radio frequency circuit receives the radio frequency signal through the antenna, converts the radio frequency signal into a baseband signal, and outputs the baseband signal to the processor 1220. The processor 1220 converts the baseband signal into data and processes the data.

In another implementation, the radio frequency circuit and the antenna may be disposed independently of the processor that performs baseband processing. For example, in a distributed scenario, the radio frequency circuit and the antenna may be disposed remotely and independent of the communication apparatus.

It may be understood that the communication apparatus shown in this embodiment of this application may alternatively include more components than those shown in FIG. 12, or the like. This is not limited in this embodiment of this application. The foregoing methods performed by the processor and the transceiver are merely examples. For specific steps performed by the processor and the transceiver, refer to the methods described above.

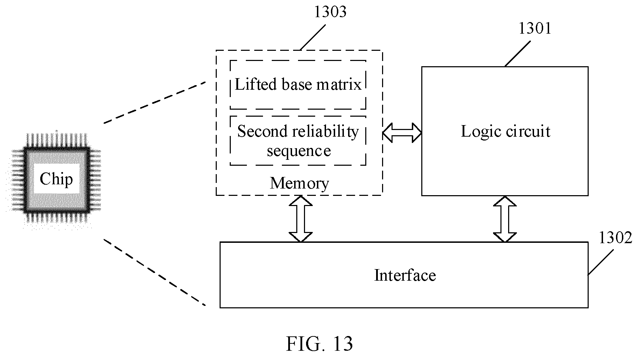

In another possible implementation, in the communication apparatus shown in FIG. 11, the processing unit 1101 may be one or more logic circuits, and the transceiver unit 1102 may be an input/output interface, or may be referred to as a communication interface, an interface circuit, an interface, or the like. Alternatively, the transceiver unit 1102 may include a sending unit and a receiving unit. The sending unit may be an output interface, and the receiving unit may be an input interface. The sending unit and the receiving unit are integrated into one unit, for example, an input/output interface. As shown in FIG. 13, a communication apparatus shown in FIG. 13 includes a logic circuit 1301 and an interface 1302. To be specific, the processing unit 1101 may be implemented by using the logic circuit 1301, and the transceiver unit 1102 may be implemented by using the interface 1302. The logic circuit 1301 may be a chip, a processing circuit, an integrated circuit, a system on chip (system on chip, SoC), or the like. The interface 1302 may be a communication interface, an input/output interface, a pin, or the like. For example, FIG. 13 is an example in which the communication apparatus is a chip. The chip includes the logic circuit 1301 and the interface 1302.

In this embodiment of this application, the logic circuit and the interface may be further coupled to each other. A specific manner of a connection between the logical circuit and the interface is not limited in this embodiment of this application.

For example, when the communication apparatus is configured to perform the methods, the functions, or the steps performed by the transmit end, the logic circuit 1301 is configured to obtain a first bit sequence; the logic circuit 1301 is further configured to: perform first channel encoding on the first bit sequence, to obtain a second bit sequence, and perform second channel encoding based on the second bit sequence, to obtain a third bit sequence; and the interface 1302 is further configured to output the third bit sequence.

It may be understood that, that the logic circuit 1301 is configured to obtain the first bit sequence shown above may be further understood as follows: The logic circuit 1301 is configured to: input to-be-processed data through the interface 1302, and process the to-be-processed data to obtain the first bit sequence. The first bit sequence may be input from another apparatus or component to the logic circuit through the interface, or may be obtained by processing, by the logic circuit, other data input through the interface. This is not limited in this embodiment of this application. It may be understood that, that the interface is configured to output the third bit sequence shown above may be further understood as follows: The logic circuit controls the interface to output the third bit sequence; or the logic circuit is configured to: after performing other processing on the third bit sequence, output, through the interface, a sequence obtained by processing the third bit sequence.

For example, when the communication apparatus is configured to perform the methods, the functions, or the steps performed by the receive end, the logic circuit 1301 is configured to: obtain a second to-be-decoded sequence; perform second channel decoding on the second to-be-decoded sequence based on an extension matrix, to obtain a first to-be-decoded bit sequence; and perform first channel decoding on the first to-be-decoded sequence based on a first reliability sequence, to obtain a first bit sequence.

It may be understood that, that the logic circuit 1301 is configured to obtain a second to-be-decoded sequence shown above may be further understood as follows: The interface 1302 is configured to input to-be-processed data (for example, a received sequence obtained through a channel), and the logic circuit 1301 processes the to-be-processed data input by the interface 1302, to obtain the second to-be-decoded sequence; or the logic circuit 1301 inputs the second to-be-decoded sequence through the interface 1302.

Optionally, the communication apparatus further includes a memory 1303. The memory 1303 may be configured to store one or more of a lifted base matrix or a second reliability sequence.

It may be understood that the communication apparatus shown in this embodiment of this application may implement the method provided in embodiments of this application in a form of hardware, or may implement the method provided in embodiments of this application in a form of software. This is not limited in embodiments of this application.

For descriptions of the first bit sequence, the second bit sequence, the third bit sequence, the first to-be-decoded sequence, the second to-be-decoded sequence, the first channel encoding, the second channel encoding, the extension matrix, the lifted base matrix, the first reliability sequence, the second reliability sequence, and the like, refer to the foregoing method embodiments. Details are not described herein again.

For specific implementations of embodiments shown in FIG. 13, refer to the foregoing embodiments, and details are not described herein again.

An embodiment of this application further provides a wireless communication system. The wireless communication system includes a transmit end and a receive end. The transmit end and the receive end may be configured to perform the method in any one of the foregoing embodiments.

In addition, this application further provides a computer program. The computer program is used to implement operations and/or processing performed by the transmit end in the methods provided in this application.

This application further provides a computer program. The computer program is used to implement operations and/or processing performed by the receive end in the methods provided in this application.

This application further provides a computer-readable storage medium. The computer-readable storage medium stores computer code. When the computer code is run on a computer, the computer is enabled to perform operations and/or processing performed by the transmit end in the methods provided in this application.

This application further provides a computer-readable storage medium. The computer-readable storage medium stores computer code. When the computer code is run on a computer, the computer is enabled to perform operations and/or processing performed by the receive end in the methods provided in this application.

This application further provides a computer program product. The computer program product includes computer code or a computer program. When the computer code or the computer program is run on a computer, operations and/or processing performed by the transmit end in the methods provided in this application are/is performed.

This application further provides a computer program product. The computer program product includes computer code or a computer program. When the computer code or the computer program is run on a computer, operations and/or processing performed by the receive end in the methods provided in this application are/is performed.

In the several embodiments provided in this application, it should be understood that the disclosed system, apparatus, and method may be implemented in other manners. For example, the described apparatus embodiment is merely an example. For example, division into the units is merely logical function division and may be other division in an actual implementation. For example, a plurality of units or components may be combined or integrated into another system, or some features may be ignored or not performed. In addition, the displayed or discussed mutual couplings or direct couplings or communication connections may be implemented through some interfaces, indirect couplings or communication connections between the apparatuses or units, or electrical connections, mechanical connections, or connections in other forms.

The units described as separate parts may or may not be physically separate, and parts displayed as units may or may not be physical units, and may be located in one location, or may be distributed on a plurality of network units. Some or all of the units may be selected based on an actual requirement to implement the technical effects of the solutions provided in embodiments of this application.

In addition, function units in embodiments of this application may be integrated into one processing unit, each of the units may exist alone physically, or two or more units may be integrated into one unit. The integrated unit may be implemented in a form of hardware, or may be implemented in a form of a software function unit.

When the integrated unit is implemented in the form of the software function unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a readable storage medium, and includes several instructions for instructing a computer device (which may be a personal computer, a server, a network device, or the like) to perform all or some of the steps of the methods described in embodiments of this application. The readable storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An encoding method, wherein the method comprises:

   obtaining a first bit sequence and a target code length M, wherein the first bit sequence comprises K information bits, K is an integer greater than or equal to 1, and M is an integer greater than or equal to 1;
   performing first channel encoding on the first bit sequence, to obtain a second bit sequence, wherein the second bit sequence comprises N bits, and N is an integer greater than or equal to 1;
   performing second channel encoding based on the second bit sequence, to obtain a third bit sequence, wherein the third bit sequence comprises the N bits and E check bits, E is an integer greater than or equal to 1, M>N, and E=M-N; and
   outputting the third bit sequence.

2. The method according to claim 1, wherein the performing second channel encoding based on the second bit sequence comprises:
   performing second channel encoding based on the second bit sequence and an extension matrix, wherein the extension matrix comprises N rows and E columns, the extension matrix is obtained based on a lifted base matrix, the lifted base matrix comprises $N_0$ rows and $E_0$ columns, and both $E_0$ and $N_0$ are integers greater than or equal to 1.

3. The method according to claim 2, wherein a lifting size Z of the lifted base matrix is a prime number; or Z=2", Z is a lifting size of the lifted base matrix, and n is an integer greater than or equal to 0.

4. The method according to claim 2 or 3, wherein $Z=N/N_0$, and Z is the lifting size of the lifted base matrix.

5. The method according to claim 3 or 4, wherein Z=16.

6. The method according to any one of claims 2 to 5, wherein the E columns of the extension matrix are first E columns of a first matrix, and the first matrix is a matrix obtained by lifting the lifted base matrix based on the lifting size; or the E columns of the extension matrix are adjacent E columns in a first matrix, the adjacent E columns in the first matrix are determined based on a code rate of the first channel encoding, and the first matrix is a matrix obtained by lifting the lifted base matrix based on the lifting size.

7. The method according to any one of claims 2 to 6, wherein a column weight of a specific column in the extension matrix is related to N, K, and E.

8. The method according to claim 7, wherein the column weight of the specific column in the extension matrix meets any one or more of the following relationships:
   the column weight is negatively correlated with E, the column weight is positively correlated with K, the column weight is negatively correlated with N, and the column weight is positively correlated with K/N.

9. The method according to any one of claims 1 to 8, wherein locations of the K information bits are determined based on a first reliability sequence, a length of the first reliability sequence is N, the first reliability sequence is a subsequence of a second reliability sequence, a length of the second reliability sequence is $N_{max}$, and $N_{max}$ is greater than or equal to N.

10. The method according to claim 9, wherein the second reliability sequence meets the following relationship:

| $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |

| $W(Q_l^{N_{max}})$ | $Q_l^{N_{max}}$ | $W(Q_l^{N_{max}})$ | $Q_l^{N_{max}}$ | $W(Q_l^{N_{max}})$ | $Q_l^{N_{max}}$ | $W(Q_l^{N_{max}})$ | $Q_l^{N_{max}}$ | $W(Q_l^{N_{max}})$ | $Q_l^{N_{max}}$ | $W(Q_l^{N_{max}})$ | $Q_l^{N_{max}}$ | $W(Q_l^{N_{max}})$ | $Q_l^{N_{max}}$ | $W(Q_l^{N_{max}})$ | $Q_l^{N_{max}}$ |
|---|---|---|---|---|---|---|---|---|---|---|---|---|---|---|---|
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |

| $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ |
|---|---|---|---|---|---|---|---|---|---|---|---|---|---|---|---|
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |

| $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ |
|---|---|---|---|---|---|---|---|---|---|---|---|---|---|---|---|
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

wherein $Q_i^{N\max}$ is a reliability sequence, an element in the reliability sequence is a sequence number of a subchannel, $W(Q_i^{N\max})$ represents reliability corresponding to the reliability sequence, and i is an integer greater than or equal to 1 and less than or equal to $N_{max}$.

11. The method according to any one of claims 2 to 10, wherein the performing first channel encoding on the first bit sequence comprises:
performing first channel encoding on the first bit sequence based on an inner interleaver sequence, wherein the inner interleaver sequence is determined based on the extension matrix, and a size of a block of the inner interleaver sequence is equal to the lifting size of the extension matrix.

12. A decoding method, wherein the method comprises:

obtaining a second to-be-decoded sequence, wherein the second to-be-decoded sequence comprises information about N bits and information about E check bits, N is an integer greater than or equal to 1, and E is an integer greater than or equal to 1;
performing second channel decoding on the second to-be-decoded sequence based on an extension matrix, to obtain a first to-be-decoded sequence, wherein the extension matrix comprises N rows and E columns, the extension matrix is obtained based on a lifted base matrix, the lifted base matrix comprises $N_0$ rows and $E_0$ columns, the first to-be-decoded sequence comprises information about the N bits, and both $E_0$ and $N_0$ are integers greater than or equal to 1; and
performing first channel decoding on the first to-be-decoded sequence based on a first reliability sequence, to obtain a first bit sequence, wherein a length of the first reliability sequence is N, the first reliability sequence is a subsequence of a second reliability sequence, a length of the second reliability sequence is $N_{max}$, $N_{max}$ is greater than or equal to N, and the first bit sequence comprises K information bits.

13. The method according to claim 12, wherein a lifting size Z of the lifted base matrix is a prime number; or Z=2", Z is a lifting size of the lifted base matrix, and n is an integer greater than or equal to 0.

14. The method according to claim 12 or 13, wherein $Z=N/N_0$, and Z is the lifting size of the lifted base matrix.

15. The method according to claim 13 or 14, wherein Z=16.

16. The method according to any one of claims 12 to 15, wherein the E columns of the extension matrix are first E columns of a first matrix, and the first matrix is a matrix obtained by lifting the lifted base matrix based on the lifting size; or
the E columns of the extension matrix are adjacent E columns in a first matrix, the adjacent E columns in the first matrix are determined based on a code rate of the first channel encoding, and the first matrix is a matrix obtained by lifting the lifted base matrix based on the lifting size.

17. The method according to any one of claims 12 to 16, wherein a column weight of a specific column in the extension matrix is related to N, K, and E.

18. The method according to claim 17, wherein the column weight of the specific column in the extension matrix meets any one or more of the following relationships:
the column weight is negatively correlated with E, the column weight is positively correlated with K, the column weight is negatively correlated with N, and the column weight is positively correlated with K/N.

19. The method according to any one of claims 12 to 18, wherein the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |

| $W(Q_i^{Nmx})$ | $Q_i^{Nmx}$ | $W(Q_i^{Nmx})$ | $Q_i^{Nmx}$ | $W(Q_i^{Nmx})$ | $Q_i^{Nmx}$ | $W(Q_i^{Nmx})$ | $Q_i^{Nmx}$ | $W(Q_i^{Nmx})$ | $Q_i^{Nmx}$ | $W(Q_i^{Nmx})$ | $Q_i^{Nmx}$ | $W(Q_i^{Nmx})$ | $Q_i^{Nmx}$ | $W(Q_i^{Nmx})$ | $Q_i^{Nmx}$ |
|---|---|---|---|---|---|---|---|---|---|---|---|---|---|---|---|
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |

| $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ | $W(Q_i^{N\max})$ | $Q_i^{N\max}$ |
|---|---|---|---|---|---|---|---|---|---|---|---|---|---|---|---|
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |

| $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ |
|---|---|---|---|---|---|---|---|---|---|---|---|---|---|---|---|
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

wherein $Q_i^{N_{max}}$ is a reliability sequence, an element in the reliability sequence is a sequence number of a subchannel, $W(Q_i^{N_{max}})$ represents reliability corresponding to the reliability sequence, and i is an integer greater than or equal to 1 and less than or equal to $N_{max}$.

20. The method according to any one of claims 12 to 19, wherein the performing first channel decoding on the first to-be-decoded sequence based on a first reliability sequence comprises:
performing first channel decoding on the first to-be-decoded sequence based on the first reliability sequence and an inner interleaver sequence, wherein the inner interleaver sequence is determined based on the extension matrix, and a size of a block of the inner interleaver sequence is equal to the lifting size of the extension matrix.

21. A communication apparatus, comprising:

a processing unit, configured to obtain a first bit sequence and a target code length M, wherein the first bit sequence comprises K information bits, K is an integer greater than or equal to 1, and M is an integer greater than or equal to 1, wherein
the processing unit is further configured to perform first channel encoding on the first bit sequence, to obtain a second bit sequence, wherein the second bit sequence comprises N bits, and N is an integer greater than or equal to 1;
the processing unit is further configured to perform second channel encoding based on the second bit sequence, to obtain a third bit sequence, wherein the third bit sequence comprises the N bits and E check bits, E is an integer greater than or equal to 1, M>N, and E=M-N; and
the processing unit is further configured to output the third bit sequence.

22. The apparatus according to claim 21, wherein the processing unit is specifically configured to perform second channel encoding based on the second bit sequence and an extension matrix, wherein the extension matrix comprises N rows and E columns, the extension matrix is obtained based on a lifted base matrix, the lifted base matrix comprises $N_0$ rows and $E_0$ columns, and both $E_0$ and $N_0$ are integers greater than or equal to 1.

23. The apparatus according to claim 22, wherein a lifting size Z of the lifted base matrix is a prime number; or Z=2", Z is a lifting size of the lifted base matrix, and n is an integer greater than or equal to 0.

24. The apparatus according to claim 22 or 23, wherein $Z=N/N_0$, and Z is the lifting size of the lifted base matrix.

**25.** The apparatus according to claim 23 or 24, wherein Z=16.

**26.** The apparatus according to any one of claims 22 to 25, wherein the E columns of the extension matrix are first E columns of a first matrix, and the first matrix is a matrix obtained by lifting the lifted base matrix based on the lifting size; or
the E columns of the extension matrix are adjacent E columns in a first matrix, the adjacent E columns in the first matrix are determined based on a code rate of the first channel encoding, and the first matrix is a matrix obtained by lifting the lifted base matrix based on the lifting size.

**27.** The apparatus according to any one of claims 22 to 26, wherein a column weight of a specific column in the extension matrix is related to N, K, and E.

**28.** The apparatus according to claim 27, wherein the column weight of the specific column in the extension matrix meets any one or more of the following relationships:
the column weight is negatively correlated with E, the column weight is positively correlated with K, the column weight is negatively correlated with N, and the column weight is positively correlated with K/N.

**29.** The apparatus according to any one of claims 21 to 28, wherein locations of the K information bits are determined based on a first reliability sequence, a length of the first reliability sequence is N, the first reliability sequence is a subsequence of a second reliability sequence, a length of the second reliability sequence is $N_{max}$, and $N_{max}$ is greater than or equal to N.

**30.** The apparatus according to claim 29, wherein the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |

| | | | | | | | | | | | | | | | |
|---|---|---|---|---|---|---|---|---|---|---|---|---|---|---|---|
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |

| | | | | | | | | | | | | | | | |
|---|---|---|---|---|---|---|---|---|---|---|---|---|---|---|---|
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |

| | | | | | | | | | | | | | | | |
|---|---|---|---|---|---|---|---|---|---|---|---|---|---|---|---|
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |

| | | | | | | | | | | | | | | | |
|---|---|---|---|---|---|---|---|---|---|---|---|---|---|---|---|
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

wherein $Q_i^{N_{max}}$ is a reliability sequence, an element in the reliability sequence is a sequence number of a subchannel, $W(Q_i^{N_{max}})$ represents reliability corresponding to the reliability sequence, and i is an integer greater than or equal to 1 and less than or equal to $N_{max}$.

31. The apparatus according to any one of claims 22 to 30, wherein the processing unit is specifically configured to perform first channel encoding on the first bit sequence based on an inner interleaver sequence, wherein the inner interleaver sequence is determined based on the extension matrix, and a size of a block of the inner interleaver sequence is equal to the lifting size of the extension matrix.

32. A communication apparatus, comprising:

a processing unit, configured to obtain a second to-be-decoded sequence, wherein the second to-be-decoded sequence comprises information about N bits and information about E check bits, N is an integer greater than or equal to 1, and E is an integer greater than or equal to 1, wherein
the processing unit is further configured to perform second channel decoding on the second to-be-decoded sequence based on an extension matrix, to obtain a first to-be-decoded sequence, wherein the extension matrix comprises N rows and E columns, the extension matrix is obtained based on a lifted base matrix, the lifted base matrix comprises $N_0$ rows and $E_0$ columns, the first to-be-decoded sequence comprises information about the N bits, and both $E_0$ and $N_0$ are integers greater than or equal to 1; and

the processing unit is further configured to perform first channel decoding on the first to-be-decoded sequence based on a first reliability sequence, to obtain a first bit sequence, wherein a length of the first reliability sequence is N, the first reliability sequence is a subsequence of a second reliability sequence, a length of the second reliability sequence is $N_{max}$, $N_{max}$ is greater than or equal to N, and the first bit sequence comprises K information bits.

33. The apparatus according to claim 32, wherein a lifting size Z of the lifted base matrix is a prime number; or Z=2", Z is a lifting size of the lifted base matrix, and n is an integer greater than or equal to 0.

34. The apparatus according to claim 32 or 33, wherein $Z=N/N_0$, and Z is the lifting size of the lifted base matrix.

35. The apparatus according to claim 33 or 34, wherein Z=16.

36. The apparatus according to any one of claims 32 to 35, wherein the E columns of the extension matrix are first E columns of a first matrix, and the first matrix is a matrix obtained by lifting the lifted base matrix based on the lifting size; or

the E columns of the extension matrix are adjacent E columns in a first matrix, the adjacent E columns in the first matrix are determined based on a code rate of the first channel encoding, and the first matrix is a matrix obtained by lifting the lifted base matrix based on the lifting size.

37. The apparatus according to any one of claims 32 to 36, wherein a column weight of a specific column in the extension matrix is related to N, K, and E.

38. The apparatus according to claim 37, wherein the column weight of the specific column in the extension matrix meets any one or more of the following relationships:

the column weight is negatively correlated with E, the column weight is positively correlated with K, the column weight is negatively correlated with N, and the column weight is positively correlated with K/N.

39. The apparatus according to any one of claims 32 to 38, wherein the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |

| | | | | | | | | | | | | | | | |
|---|---|---|---|---|---|---|---|---|---|---|---|---|---|---|---|
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |

| | | | | | | | | | | | | | | | |
|---|---|---|---|---|---|---|---|---|---|---|---|---|---|---|---|
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |

| 71 | 57 | 199 | 278 | 327 | 212 | 455 | 236 | 583 | 905 | 711 | 628 | 839 | 734 | 967 | 960 |
|----|----|-----|-----|-----|-----|-----|-----|-----|-----|-----|-----|-----|-----|-----|------|
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |

| 105 | 153 | 233 | 337 | 361 | 189 | 489 | 590 | 617 | 788 | 745 | 637 | 873 | 820 | 1001 | 1001 |
|---|---|---|---|---|---|---|---|---|---|---|---|---|---|---|---|
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

wherein $Q_i^{N_{\max}}$ is a reliability sequence, an element in the reliability sequence is a sequence number of a subchannel, $W(Q_i^{N_{\max}})$ represents reliability corresponding to the reliability sequence, and i is an integer greater than or equal to 1 and less than or equal to $N_{\max}$.

40. The apparatus according to any one of claims 32 to 39, wherein the processing unit is specifically configured to perform first channel decoding on the first to-be-decoded sequence based on the first reliability sequence and an inner interleaver sequence, wherein the inner interleaver sequence is determined based on the extension matrix, and a size of a block of the inner interleaver sequence is equal to the lifting size of the extension matrix.

41. A communication apparatus, comprising a processor and a memory, wherein

the memory is configured to store instructions; and

the processor is configured to execute the instructions, to perform the method according to any one of claims 1 to 20.

42. A communication apparatus, comprising a logic circuit and an input/output interface, wherein the logic circuit is coupled to the input/output interface; and

the input/output interface is configured to input to-be-processed data; the logic circuit processes the to-be-processed data according to the method according to any one of claims 1 to 20, to obtain processed data; and the input/output interface is configured to output the processed data.

43. A computer-readable storage medium, wherein the computer-readable storage medium is configured to store a computer program, and when the computer program is executed, the method according to any one of claims 1 to 20 is performed.

44. A computer program product comprising instructions, wherein when the instructions are run on a computer, the method according to any one of claims 1 to 20 is performed.

45. A communication system, wherein the system comprises a transmit end and a receive end, the transmit end is configured to perform the method according to any one of claims 1 to 10, and the receive end is configured to perform the method according to any one of claims 11 to 20.

FIG. 1

FIG. 2

FIG. 3

A transmit end obtains a first bit sequence and a target code length M, where the first bit sequence includes K information bits, K is an integer greater than or equal to 1, and M is an integer greater than or equal to 1

401

The transmit end performs first channel encoding on the first bit sequence, to obtain a second bit sequence, where the second bit sequence includes N bits, and N is an integer greater than or equal to 1

402

The transmit end performs second channel encoding based on the second bit sequence, to obtain a third bit sequence, where the third bit sequence includes the N bits and E check bits, E is an integer greater than or equal to 1, M>N, and E=M–N

403

The transmit end outputs the third bit sequence

404

FIG. 4a

FIG. 4b

FIG. 5a

FIG. 5b

L, $D_{max}$, $D_{min}$, $E_0$,
maxIter, Z, $N_0$, K

A quantity
$e$ of columns of a
current matrix is less
than $E_0$

N

Y

Randomly generate, based on each current
candidate matrix, L additional $N_0$-row and 1-
column QC matrices $H_{N_0 1}^1$ to $H_{N_0 1}^L$ with a degree
range of $D_{min}$ to $D_{max}$ and a lifting size of Z

Calculate SC decoding performance of a (N,
K)-polar code in $L^2$ QC matrices, sort the QC
matrices in descending order of performance,
and reserve first L QC matrices with best
performance

Output $H_{N_0 E_0}^1$
with optimal
performance as a
lifted base matrix

FIG. 5c

EP 4 395 182 A1

[ ]

$HN_0^1 1$  $HN_0^2 1$  $HN_0^3 1$  $HN_0^4 1$  ...  $HN_0^L 1$

...  ...  ...  ...  ...

$HN_0^1 2$  $HN_0^2 2$  ...  $HN_0^L 2$

...  ...  ...

...

$HN_0E_0^1$  $HN_0E_0^2$  ...  $HN_0E_0^L$

501: Initialize a lifted base matrix (QC matrix) to an empty set

502: Randomly generate L $N_0$-row and 1-column QC matrices that have no 4-cycle

503: Randomly generate one additional column based on each $N_0$-row and 1-column QC matrix $HN_0^i 1$ and $i$=1,2, ..., or L, to obtain $L^2$ $N_0$-row and 2-column QC matrices $HN_0^i 2$

504: Calculate performance of a (N, K)-polar code in these QC matrices, where L QC matrices with best performance are obtained through sorting based on performance, and are used as first two columns of the lifted base matrix

505: Randomly generate, based on the L QC matrices with the best performance, a third column of the lifted base matrix, to obtain $L^2$ $N_0$-row and 3-column QC matrices $HN_0^i 3$

506: By analogy, obtain L $N_0$-row and $E_0$-column QC matrices $HN_0E_0^1$ to $HN_0E_0^L$ in a progressive manner

507: Select $HN_0E_0^1$ as a finally output lifted base matrix

FIG. 5d

FIG. 6a

FIG. 6b

FIG. 6c

FIG. 6d

FIG. 7a

FIG. 7b

A receive end obtains a second to-be-decoded sequence, where the second to-be-decoded sequence includes information about N bits and information about E check bits, N is an integer greater than or equal to 1, and E is an integer greater than or equal to 1 — 801

The receive end performs second channel decoding on the second to-be-decoded sequence based on an extension matrix, to obtain a first to-be-decoded sequence, where the extension matrix includes N rows and E columns, the extension matrix is obtained based on a lifted base matrix, the lifted base matrix includes $N_0$ rows and $E_0$ columns, the first to-be-decoded sequence includes information about the N bits, and both $E_0$ and $N_0$ are integers greater than or equal to 1 — 802

The receive end performs first channel decoding on the first to-be-decoded sequence based on a first reliability sequence, to obtain a first bit sequence, where a length of the first reliability sequence is N, the first reliability sequence is a subsequence of a second reliability sequence, a length of the second reliability sequence is $N_{max}$, $N_{max}$ is greater than or equal to N, and the first bit sequence includes K information bits — 803

FIG. 8

Received sequence, encoding parameter, and decoding parameter

Initialize a soft value $L_{EF}$ of EF-polar by using a soft value of the received sequence, and initialize soft values $L_p$ of first N bits of a EF-polar code by using soft values $L_s$ of N bits in the received sequence

curIter<ITER$_{max}$    N

Y

Calculate extrinsic information $L_{ex}=L_p-L_s$

Input $L_{EF}$ and $L_{ex}$ to a BP decoder for one iteration, to obtain an updated soft value $L_{EF}$ of the EF-polar

Extract soft values $L_s$ at locations of the N bits in $L_{EF}$, and input the soft values $L_s$ to a CA-SCL decoder for decoding, to obtain an optimal decoding path $u_1, ..., u_K$ of the polar code and soft values $L_p$ of a corresponding sequence $c_1, ..., c_K$

N    Does $u_1, ..., u_K$ passes CRC?

Y

$u_1, ..., u_K$, and $L_{EF}=[L_s, L_c]$

FIG. 9a

FIG. 9b

FIG. 9c

FIG. 9d

FIG. 9e

EP 4 395 182 A1

FIG. 9f

92

FIG. 9g

EP 4 395 182 A1

$u_1, ..., u_K$ | First channel encoding | $c_1, c_2, ..., c_N$ | Inner interleaving | $d_1, d_2, ..., d_N$ | Second channel encoding | $x_1, x_2, ..., x_N, x_{N+1}, ..., x_{N+E}$

Encoding

Modulation

$u_1, ..., u_K$ | Decoding | $y_1, y_2, ..., y_M$ | Demodulation | $r_1, r_2, ..., r_T$ | Channel | $s_1, s_2, ..., s_T$

FIG. 10

Transceiver unit 1102

Processing unit 1101

Communication apparatus

FIG. 11

120

Transceiver 1210

Processor 1220

1240

1230

Lifted base matrix

Second reliability sequence

Memory

FIG. 12

1303

Lifted base matrix

Second reliability
sequence

Memory

1301

Logic circuit

Chip

Interface

1302

FIG. 13

## INTERNATIONAL SEARCH REPORT

| | International application No. |
|---|---|
| | **PCT/CN2022/116922** |

**A.    CLASSIFICATION OF SUBJECT MATTER**

H03M 13/13(2006.01)i

According to International Patent Classification (IPC) or to both national classification and IPC

**B.    FIELDS SEARCHED**

Minimum documentation searched (classification system followed by classification symbols)

H03M13/-; H04L1/-

Documentation searched other than minimum documentation to the extent that such documents are included in the fields searched

Electronic data base consulted during the international search (name of data base and, where practicable, search terms used)

CNABS; CNTXT; VEN; USTXT; WOTXT; EPTXT; CNKI; IEEE: 编码, 译码, 极化码, 低密度奇偶校验码, 码长, 校验比特, 扩展矩阵, 基矩阵, 扩展因子, 可靠度序列, 内交织, code, encode, decode, polar code, low density parity check code, LDPC code, code length, check bit, expanding matrix, basis matrix, extension factor, sequence of reliability, inner interleaving

**C.    DOCUMENTS CONSIDERED TO BE RELEVANT**

| Category* | Citation of document, with indication, where appropriate, of the relevant passages | Relevant to claim No. |
|---|---|---|
| A | CN 110166167 A (HUAWEI TECHNOLOGIES CO., LTD.) 23 August 2019 (2019-08-23) description, paragraphs 0118-0412 | 1-45 |
| A | CN 111416625 A (HUAWEI TECHNOLOGIES CO., LTD.) 14 July 2020 (2020-07-14) description, paragraphs 0077-0258 | 1-45 |
| A | CN 111970009 A (SOUTHEAST UNIVERSITY et al.) 20 November 2020 (2020-11-20) entire document | 1-45 |
| A | CN 108574561 A (HUAWEI TECHNOLOGIES CO., LTD.) 25 September 2018 (2018-09-25) entire document | 1-45 |
| A | CN 104518847 A (SHANGHAI ADVANCED RESEARCH INSTITUTE, CHINESE ACADEMY OF SCIENCES) 15 April 2015 (2015-04-15) entire document | 1-45 |
| A | US 2010241923 A1 (BROADCOM CORPORATION) 23 September 2010 (2010-09-23) entire document | 1-45 |

☐ Further documents are listed in the continuation of Box C.    ☑ See patent family annex.

| | |
|---|---|
| *     Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **01 November 2022** | **15 November 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/116922**

| Patent document cited in search report | | | Publication date (day/month/year) | Patent family member(s) | | | Publication date (day/month/year) |
|---|---|---|---|---|---|---|---|
| CN | 110166167 | A | 23 August 2019 | WO | 2019158031 | A1 | 22 August 2019 |
| | | | | CN | 110166167 | B | 10 May 2022 |
| CN | 111416625 | A | 14 July 2020 | JP | 2020520570 | A | 09 July 2020 |
| | | | | WO | 2018228514 | A1 | 20 December 2018 |
| | | | | EP | 3588786 | A1 | 01 January 2020 |
| | | | | ZA | 201906314 | B | 29 July 2020 |
| | | | | WO | 2018227681 | A1 | 20 December 2018 |
| | | | | US | 2020007159 | A1 | 02 January 2020 |
| | | | | JP | 2021064962 | A | 22 April 2021 |
| | | | | AU | 2017418080 | A1 | 03 October 2019 |
| | | | | CN | 110754042 | A | 04 February 2020 |
| | | | | CA | 3055231 | A1 | 20 December 2018 |
| | | | | KR | 20190113983 | A | 08 October 2019 |
| | | | | RU | 2740154 | C1 | 12 January 2021 |
| | | | | BR | 112019020158 | A2 | 22 April 2020 |
| | | | | US | 2022255563 | A1 | 11 August 2022 |
| | | | | US | 2020343912 | A1 | 29 October 2020 |
| | | | | CN | 109067407 | A | 21 December 2018 |
| | | | | CN | 109150191 | A | 04 January 2019 |
| | | | | IN | 201937035632 | A | 08 November 2019 |
| | | | | CN | 109067407 | B | 15 November 2019 |
| | | | | VN | 68633 | A | 25 February 2020 |
| | | | | US | 10742235 | B2 | 11 August 2020 |
| | | | | KR | 102194029 | B1 | 22 December 2020 |
| | | | | AU | 2017418080 | B2 | 24 December 2020 |
| | | | | JP | 6820438 | B2 | 27 January 2021 |
| | | | | AU | 2017418080 | B9 | 28 January 2021 |
| | | | | CN | 111416625 | B | 23 March 2021 |
| | | | | BR | 112019020158 | B1 | 08 February 2022 |
| | | | | US | 11296726 | B2 | 05 April 2022 |
| CN | 111970009 | A | 20 November 2020 | None | | | |
| CN | 108574561 | A | 25 September 2018 | EP | 3584972 | A1 | 25 December 2019 |
| | | | | WO | 2018166423 | A1 | 20 September 2018 |
| | | | | US | 2020007163 | A1 | 02 January 2020 |
| | | | | VN | 68087 | A | 30 January 2020 |
| | | | | IN | 201927038100 | A | 14 August 2020 |
| | | | | CN | 108574561 | B | 17 November 2020 |
| | | | | US | 11088709 | B2 | 10 August 2021 |
| CN | 104518847 | A | 15 April 2015 | CN | 104518847 | B | 02 February 2018 |
| US | 2010241923 | A1 | 23 September 2010 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111173210